(19) Europäisches Patentamt
European Patent Office
Office européen des brevets

(11) EP 2 638 544 B1

(12) **EUROPÄISCHE PATENTSCHRIFT**

(45) Veröffentlichungstag und Bekanntmachung des Hinweises auf die Patenterteilung:
**26.12.2018 Patentblatt 2018/52**

(21) Anmeldenummer: **11778624.4**

(22) Anmeldetag: **04.11.2011**

(51) Int Cl.:
***C09B 11/12*** (2006.01) ***C09B 17/00*** (2006.01)
***C09B 21/00*** (2006.01) ***C09B 23/04*** (2006.01)
***C09B 23/06*** (2006.01) ***C09B 23/10*** (2006.01)
***C09B 23/16*** (2006.01) ***C09B 57/00*** (2006.01)
***C09B 55/00*** (2006.01) ***C09B 69/06*** (2006.01)
***C09B 23/08*** (2006.01) ***C09B 49/12*** (2006.01)
***G03F 7/00*** (2006.01) ***G03F 7/035*** (2006.01)
***G03H 1/00*** (2006.01) ***G03H 1/02*** (2006.01)
***G11B 7/24044*** (2013.01) ***G11B 7/245*** (2006.01)
***G03C 1/00*** (2006.01) ***G03F 7/004*** (2006.01)

(86) Internationale Anmeldenummer:
**PCT/EP2011/069389**

(87) Internationale Veröffentlichungsnummer:
**WO 2012/062655 (18.05.2012 Gazette 2012/20)**

(54) **PHOTOPOLYMER-FORMULIERUNG ZUR HERSTELLUNG HOLOGRAPHISCHER MEDIEN MIT HOCH VERNETZTEN MATRIXPOLYMEREN**

PHOTOPOLYMER FORMULATION FOR PRODUCING HOLOGRAPHIC MEDIA HAVING HIGHLY CROSS-LINKED MATRIX POLYMERS

FORMULATION DE PHOTOPOLYMÈRE POUR LA PRODUCTION DE SUPPORTS HOLOGRAPHIQUES, COMPRENANT DES POLYMÈRES MATRICIELS FORTEMENT RÉTICULÉS

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **08.11.2010 EP 10190324**

(43) Veröffentlichungstag der Anmeldung:
**18.09.2013 Patentblatt 2013/38**

(73) Patentinhaber: **Covestro Deutschland AG**
**51373 Leverkusen (DE)**

(72) Erfinder:
- **BERNETH, Horst**
  **51373 Leverkusen (DE)**
- **RÖLLE, Thomas**
  **51381 Leverkusen (DE)**
- **BRUDER, Friedrich-Karl**
  **47802 Krefeld (DE)**
- **FÄCKE, Thomas**
  **51375 Leverkusen (DE)**
- **WEISER, Marc-Stephan**
  **51377 Leverkusen (DE)**
- **HÖNEL, Dennis**
  **53909 Zülpich-Wichterich (DE)**

(74) Vertreter: **Levpat**
**c/o Covestro AG**
**Gebäude 4825**
**51365 Leverkusen (DE)**

(56) Entgegenhaltungen:
**EP-A1- 0 408 322** **EP-A1- 1 666 988**
**EP-A1- 2 028 654** **WO-A1-2008/125229**
**CH-A5- 691 684** **US-A- 5 698 490**

EP 2 638 544 B1

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

## Beschreibung

Die Erfindung betrifft eine Photopolymer-Formulierung, wie in den vorliegenden Ansprüchen offenbart, umfassend eine Polyol-Komponente, eine Polyisocyanat-Komponente, ein Schreibmonomer und einen Photoinitiator, enthaltend einen Coinitiator und einen Farbstoff der Formel $F^+An^-$, in der $F^+$ für einen kationischen Farbstoff und $An^-$ für ein Anion steht. Weitere Gegenstände der Erfindung sind ein holographisches Medium, insbesondere in der Form eines Films, enthaltend eine erfindungsgemäße Photopolymer-Formulierung, die Verwendung eines derartigen Mediums zur Aufzeichnung von Holgrammen sowie ein spezieller in den erfindungsgemäßen Photopolymer-Formulierungen verwendbarer Farbstoff.

Photopolymer-Formulierungen der eingangs genannten Art sind im Stand der Technik bekannt. So ist beispielsweise in der WO 2008/125229 A1 eine Photopolymer-Formulierung beschrieben, die eine Polyol-Komponente, eine Polyisocyanat-Komponente, ein Schreibmonomer auf Acrylatbasis sowie Photoinitiatoren enthaltend einen Coinitiator und einen Farbstoff umfasst. Im ausgehärtetem Zustand sind in der aus Polyol- und Polyisocyanat-Komponente gebildeten Polyurethanmatrix das Schreibmonomer und die Photoinitiatoren räumlich isotrop verteilt eingebettet.

Für die Verwendungen von Photopolymer-Formulierungen spielt die durch die holographische Belichtung im Photopolymer erzeugte Brechungsindexmodulation $\Delta n$ die entscheidende Rolle. Bei der holographischen Belichtung wird das Interferenzfeld aus Signal- und Referenzlichtstrahl (im einfachsten Fall das zweier ebener Wellen) durch die lokale Photopolymerisation von z.B. hochbrechenden Acrylate an Orten hoher Intensität im Interferenzfeld in ein Brechungsindexgitter abgebildet. Das Brechungsindexgitter im Photopolymeren (das Hologramm) enthält alle Information des Signallichtstrahls. Durch Beleuchtung des Hologramms nur mit dem Referenzlichtstrahl kann dann das Signal wieder rekonstruiert werden. Die Stärke des so rekonstruierten Signals im Verhältnis zur Stärke des eingestrahlten Referenzlichts wird Beugungseffizienz, im folgenden DE wie Diffraction Efficiency, genannt.

Im einfachsten Fall eines Hologramms, das aus der Überlagerung zweier ebener Wellen entsteht ergibt sich die DE aus dem Quotienten der Intensität des bei der Rekonstruktion abgebeugten Lichtes und der Summe der Intensitäten aus eingestrahltem Referenzlicht und abgebeugtem Licht. Je höher die DE desto effizienter ist ein Hologramm in Bezug auf die Lichtmenge des Referenzlichtes die notwendig ist, um das Signal mit einer festen Helligkeit sichtbar zu machen.

Bei Beleuchtung des Hologramms mit z.B. weißem Licht hängt die Breite des spektralen Bereiches, der zur Rekonstruktion des Hologramms beitragen kann, ebenfalls nur von der Schichtdicke d ab. Dabei gilt: je kleiner d desto größer die jeweiligen Akzeptanzbreiten. Will man daher helle und leicht sichtbare Hologramme herstellen, ist ein hohes $\Delta n$ und eine geringe Dicke d anzustreben und zwar so, dass DE möglichst groß wird. Das heißt, je höher $\Delta n$ wird, desto mehr Freiraum zur Gestaltung der Schichtdicke d für helle Hologramme erreicht man ohne Verlust an DE. Daher kommt der Optimierung von $\Delta n$ bei der Optimierung von Photopolymer-Formulierungen eine herausragenden Bedeutung zu (P. Hariharan, Optical Holography, 2nd Edition, Cambridge University Press, 1996).

Um ein möglichst hohes $\Delta n$ und DE bei Hologrammen realisieren zu können, sollten grundsätzlich die Matrixpolymere und die Schreibmonomere einer Photopolymer-Formulierung so gewählt werden, dass sie sich in ihren Brechungsindizes möglichst stark unterscheiden. Ein Möglichkeit zur Realisierung ist, Matrixpolymere mit einem möglichst niedrigen und Schreibmonomere mit einem möglichst hohen Brechungsindex zu verwenden. Geeignete Matrixpolymere mit niedrigem Brechungsindex sind beispielsweise durch Umsetzung einer Polyol- mit einer Polyisocyanat-Komponente erhältliche Polyurethane.

Neben hohen DE- und $\Delta n$- Werten ist es für holographische Medien aus Photopolymer-Formulierungen aber auch von großer Bedeutung, dass die Matrixpolymere im fertigen Medium hoch vernetzt sind. Falls der Vernetzungsgrad zu niedrig ist, weist das Medium keine ausreichende Stabilität auf. Dies kann dazu führen, dass die Qualität von in die Medien eingeschriebenen Hologrammen erheblich vermindert ist. Im schlimmsten Fall können die Hologramme sogar nachträglich zerstört werden.

Weiterhin ist es insbesondere für die großtechnische Herstellung von holographischen Medien aus Photopolymer-Formulierungen von großer Bedeutung, dass die Vernetzung der Matrixpolymere schnell erfolgt. So sind hier eine kurze Aushärtezeiten bis zum Erreichen der Blockfestigkeit von großer Bedeutung, da durch diese Größe die Verarbeitungsgeschwindigkeit bzw. die Länge einer nötigen Härtungsstrecke bestimmt wird.

Es ist jedoch festgestellt worden, dass Medien aus den bekannten Photopolymer-Formulierungen häufig keine ausreichende Vernetzung aufweisen. Außerdem sind in vielen Fällen selbst bis zur Erreichung einer gerade noch ausreichenden Vernetzungsdichte lange Aushärtungszeiten nötig. Damit kann es bei Medien aus den bekannten Photopolymer-Formulierungen einerseits zu Qualitätsproblemen kommen und andererseits ist durch die längere Aushärtungszeit ein erheblicher Aufwand bei der großtechnischen Produktion verbunden.

CH691684A5 offenbart säurestabile Borate für die Photopolymerisation.

EP1666988A1 offenbart holographische Aufnahmemedien, holographische Aufnahmeverfahren und holographische Informationsmedien.

EP2028654A1 offenbart holographische Aufnahmemedien und einen holographischen Aufnahmeapparat.

WO2008125229A1 offenbart vorteilhafte Aufnahmemedien für holographische Anwendungen.

Die Aufgabe der vorliegenden Erfindung war es daher, eine Photopolymer-Formulierung der eingangs genannten Art bereit zu stellen, aus der schnell und mit geringem Aufwand stabile holographische Medien für helle Hologramme hergestellt werden können.

Diese Aufgabe ist bei der erfindungsgemäßen Photopolymer-Formulierung, wie in den vorliegenden Ansprüchen offenbart, dadurch gelöst, dass der Farbstoff eine Wasseraufnahme von $\leq 5$ % aufweist.

Die Wasseraufnahme ergibt sich aus der Formel (F-1)

$$W = (m_f/m_t - 1)*100\% \quad (F\text{-}1),$$

worin $m_f$ die Masse des Farbstoffs nach Wassersättigung und $m_t$ die Masse des getrockneten Farbstoffs sind. $m_t$ wird durch Trocknen einer bestimmten Farbstoffmenge bis zur Massenkonstanz, beispielsweise bei erhöhter Temperatur im Vakuum ermittelt. $m_f$ wird durch Stehen einer bestimmtem Farbstoffmenge an der Luft bei einer definierten Luftfeuchtigkeit bis zur Gewichtskonstanz bestimmt.

Überraschenderweise wurde gefunden, dass schnell härtende holographische Medien aus Photopolymer-Formulierungen erhältlich sind, die einen Farbstoff der Formel $F^+An^-$ mit einer Wasseraufnahme von $\leq 5$ % enthalten. Die Medien zeigen eine schnelle und hohe Vernetzung des Matrixpolymeren und in sie können helle Hologramme einbelichtet werden.

Gemäß einer ersten bevorzugten Ausführungsform der Erfindung ist vorgesehen, dass der Farbstoff eine Wasseraufnahme von $\leq 3$ %, und bevorzugt von $\leq 2$ % aufweist. Ganz besonders bevorzugt nimmt der Farbstoff nur Spuren oder gar kein Wasser auf.

Mit kationischen Farbstoffen der Formel $F^+$ sind erfindungsgemäß Farbstoffe gemeint, wie sie beispielsweise in H. Berneth in Ullmann's Encyclopedia of Industrial Chemistry, Cationic Dyes, Wiley-VCH Verlag, 2008 beschrieben sind.

Unter kationischen Farbstoffen der Formel $F^+$ werden bevorzugt solche der folgenden Klassen Acridin-Farbstoffe, Xanthen-Farbstoffe, Thioxanthen-Farbstoffe, Phenazin-Farbstoffe, Phenoxazin-Farbstoffe, Phenothiazin-Farbstoffe, Tri(het)arylmethan-Farbstoffe - insbesondere Diamino- und Triamino(het)arylmethan-Farbstoffe, Mono-, Di- und Trimethincyanin-Farbstoffe, Hemicyanin-Farbstoffe, extern kationische Merocyanin-Farbstoffe, extern kationische Neutrocyanin-Farbstoffe, Nullmethin-Farbstoffe - insbesondere Naphtholactam-Farbstoffe, Streptocyanin-Farbstoffe verstanden. Solche Farbstoffe sind beispielsweise in H. Berneth in Ullmann's Encyclopedia of Industrial Chemistry, Azine Dyes, Wiley-VCH Verlag, 2008, H. Berneth in Ullmann's Encyclopedia of Industrial Chemistry, Methine Dyes and Pigments, Wiley-VCH Verlag, 2008, T. Gessner, U. Mayer in Ullmann's Encyclopedia of Industrial Chemistry, Triarylmethane and Diarylmethane Dyes, Wiley-VCH Verlag, 2000 beschrieben.

Bevorzugt ist auch, wenn das Anion $An^-$ des Farbstoffs einen AClogP im Bereich von 1-30, besonders bevorzugt im Bereich von 1-12, ganz besonders bevorzugt im Bereich von 1-6,5, herausragend bevorzugt im Bereich 1-4 aufweist.

Der AClogP wird nach J. Comput. Aid. Mol. Des. 2005, 19, 453; Virtual Computational Chemistry Laboratory, http://www.vcclab.org berechnet.

Bei einer weiteren bevorzugten Ausführungsform der Erfindung ist vorgesehen, dass das Anion $An^-$ eine Molmasse >150 g/mol und besonderes bevorzugt > 250 g/mol aufweist.

Das Anion der Formel $An^-$ kann vorzugsweise wenigstens ein Phosphor-, Bor- oder Schwefel-Atom, bevorzugt wenigstens ein Bor oder ein Schwefel-Atom und besonders bevorzugt wenigstens ein Schwefel-Atom insbesondere ein Schwefel-Atom in einer $SO_3$-Gruppierung umfassen.

Ebenfalls bevorzugt kann das Anion $An^-$ mindestens einen linearen oder verzweigten aliphatischen Rest, bevorzugt einen linearen oder verzweigten aliphatischen Cs bis $C_{18}$-Rest aufweisen. Enthält das Anion mehr als einen linearen oder verzweigten aliphatischen Rest, so enthalten diese zusammen 8 bis 36, vorzugsweise 8 bis 24 C-Atome. Dieser aliphatische Rest kann Substituenten tragen wie Fluor, Methoxy oder Ethoxy.

Herausragend bevorzugte Anionen der Formel $An^-$ besitzen folglich eine Molmasse > 250 g/mol und enthalten eine $SO_3^-$-Gruppierung sowie mindestens eine Alkylgruppe mit mindestens 8 C-Atomen und haben eine AClogP im Bereich 1-6,5.

Mit den erfindungsgemäßen Anionen der Formel $An^-$ sind insbesondere auch gemeint:

$C_8$- bis $C_{25}$-Alkansulfonat, vorzugsweise $C_{13}$- bis $C_{25}$-Alkansulfonat, $C_3$- bis $C_{18}$-Perfluoralkansulfonat, vorzugsweise $C_4$- bis $C_{18}$-Perfluoralkansulfonat, $C_9$- bis $C_{25}$-Alkanoat, $C_9$- bis $C_{25}$-Alkenoat, $C_8$- bis $C_{25}$-Alkylsulfat, vorzugsweise $C_{13}$- bis $C_{25}$-Alkylsulfat, $C_8$- bis $C_{25}$-Alkenylsulfat, vorzugsweise $C_{13}$- bis $C_{25}$-Alkenylsulfat, $C_3$- bis $C_{18}$-Perfluoralkylsulfat, vorzugsweise $C_4$- bis $C_{18}$-Perfluoralkylsulfat, Polyethersulfate basierend auf mindestens 4 Äquivalenten Ethylenoxid und/oder Äquivalenten 4 Propylenoxid, Bis-$C_4$- bis $C_{25}$-Alkyl-, $C_5$- bis $C_7$-Cycloalkyl-, $C_3$- bis Cs-Alkenyl- oder $C_7$- bis $C_{11}$-Aralkyl-sulfosuccinat, durch mindestens 8 Fluoratome substituiertes Bis-$C_2$- bis $C_{10}$-Alkyl-sulfosuccinat, $C_8$- bis $C_{25}$-Alkyl-sulfoacetate, durch mindestens einen Rest der Gruppe Halogen, $C_4$- bis $C_{25}$-Alkyl, Perfluor-$C_1$- bis $C_8$-Alkyl

und/oder $C_1$- bis $C_{12}$-Alkoxycarbonyl substituiertes Benzolsulfonat, ggf. durch Nitro, Cyano, Hydroxy, $C_1$- bis $C_{25}$-Alkyl, $C_1$- bis $C_{12}$-Alkoxy, Amino, $C_1$- bis $C_{12}$-Alkoxycarbonyl oder Chlor substituiertes Naphthalin- oder Biphenylsulfonat, ggf. durch Nitro, Cyano, Hydroxy, $C_1$- bis $C_{25}$-Alkyl, $C_1$- bis $C_{12}$-Alkoxy, $C_1$- bis $C_{12}$-Alkoxycarbonyl oder Chlor substituiertes Benzol-, Naphthalin- oder Biphenyldisulfonat, durch Dinitro, $C_6$- bis $C_{25}$-Alkyl, $C_4$- bis $C_{12}$-Alkoxycarbonyl, Benzoyl, Chlorbenzoyl oder Toluoyl substituiertes Benzoat, das Anion der Naphthalindicarbonsäure, Diphenyletherdisulfonat, sulfonierte oder sulfatierte, ggf. mindestens einfach ungesättigte $C_8$- bis $C_{25}$-Fettsäureester von aliphatischen $C_1$- bis $C_8$-Alkoholen oder Glycerin, Bis-(sulfo-$C_2$- bis $C_6$-alkyl)-$C_3$- bis $C_{12}$-alkandicarbonsäureester, Bis-(sulfo-$C_2$- bis $C_6$-alkyl)-itaconsäureester, (Sulfo-$C_2$- bis $C_6$-alkyl)-$C_6$- bis $C_{18}$-alkancarbonsäureester, (Sulfo-$C_2$- bis $C_6$-alkyl)-acryl- oder methacrylsäureester, ggf. durch bis zu 12 Halogenreste substituiertes Triscatecholphosphat, ein Anion der Gruppe Tetraphenylborat, Cyanotriphenylborat, Tetraphenoxyborat, $C_4$- bis $C_{12}$-Alkyl-triphenylborat, deren Phenyl- oder Phenoxy-Reste durch Halogen, $C_1$- bis $C_4$-Alkyl und/oder $C_1$- bis $C_4$-Alkoxy substituiert sein können, $C_4$- bis $C_{12}$-Alkyl-trinaphthylborat, Tetra-Ci- bis $C_{20}$-alkoxyborat, 7,8- oder 7,9-Dicarba-nidoundecaborat(1-) oder (2-), die gegebenenfalls an den B- und/oder C-Atomen durch eine oder zwei $C_1$- bis $C_{12}$-Alkyl- oder Phenyl-Gruppen substituiert sind, Dodecahydrodicarbadodecaborat(2-) oder B-$C_1$- bis $C_{12}$-Alkyl-C-phenyl-dodecahydrodicarbadodecaborat(1-) steht, wobei bei mehrwertigen Anionen wie Naphthalindisulfonat An- für ein Äquivalent dieses Anions steht, und wobei die Alkan- und Alkylgruppen verzweigt sein können und/oder durch Halogen, Cyano, Methoxy, Ethoxy, Methoxycarbonyl oder Ethoxycarbonyl sustituiert sein können..

Besonders bevorzugt sind:

Sec-$C_{11}$- bis $C_{18}$-Alkansulfonat, $C_{13}$- bis $C_{25}$-Alkylsulfat, verzweigtes $C_8$- bis $C_{25}$-Alkylsulfat, ggf. verzweigtes Bis-$C_6$- bis $C_{25}$-Alkylsulfosuccinat, sec- oder tert.-$C_4$- bis $C_{25}$-Alkylbenzolsulfonat, sulfonierte oder sulfatierte, ggf. mindestens einfach ungesättigte $C_8$- bis $C_{25}$-Fettsäureester von aliphatischen $C_1$- bis $C_8$-Alkoholen oder Glycerin, Bis-(sulfo-$C_2$- bis $C_6$-alkyl)-$C_3$- bis $C_{12}$-alkandicarbonsäureester, (Sulfo-$C_2$- bis $C_6$-alkyl)-$C_6$- bis $C_{18}$-alkancarbonsäureester, durch bis zu 12 Halogenreste substituiertes Triscatecholphosphat, Cyanotriphenylborat, Tetraphenoxyborat.

Beispiele sind:

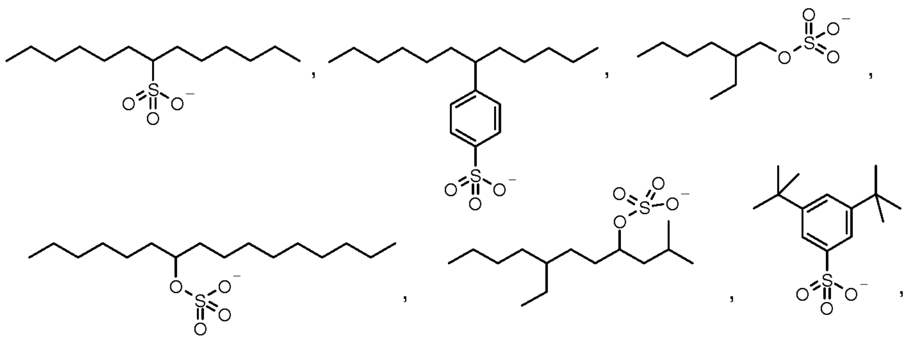

, , , , , ,

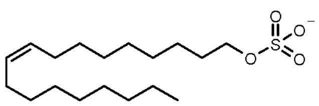
,
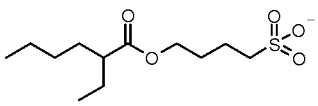
,
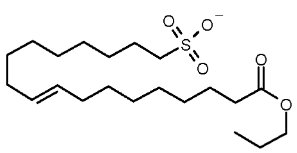
,

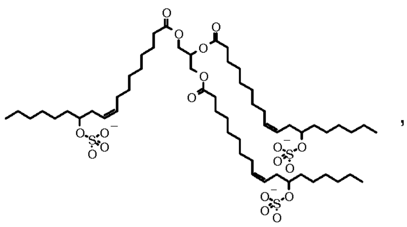
,
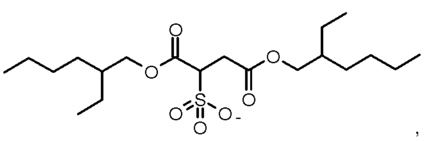
,

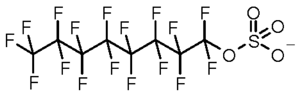 , 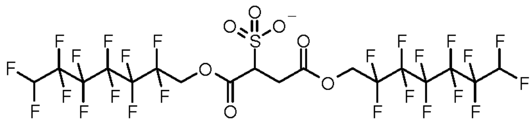 ,

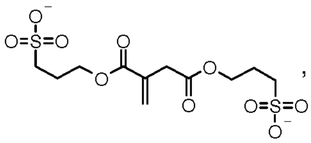 , 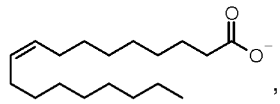 , 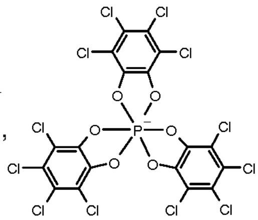 ,

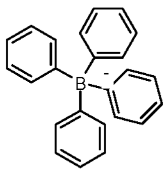 , 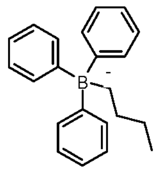 , 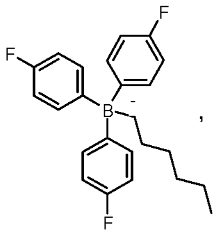 , 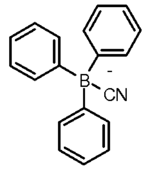

AClogP-Werte für verschiedene Anionen sind in der folgenden Tabelle 1 zusammengestellt:

Tabelle 1: AClogP-Werte ausgewählter Anionen

| Anion | AClogP |
|---|---|
| 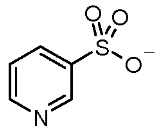 | -1,50 |
| 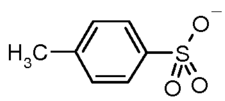 | -0,11 |
| 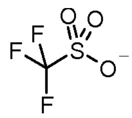 | 0,23 |
| 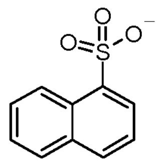 | 0,76 |
| 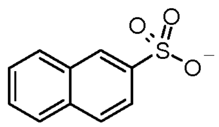 | 0,76 |
| 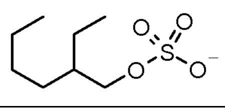 | 1,07 |

(fortgesetzt)

| Anion | AClogP |
|---|---|
| 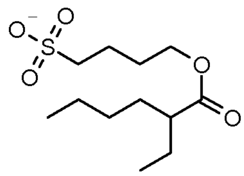 | 1,84 |
| 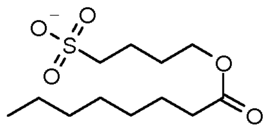 | 1,96 |
| 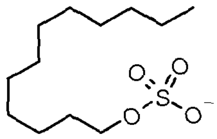 | 3,05 |
| 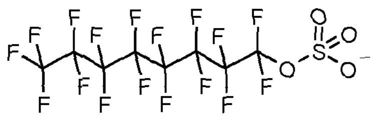 | 3,32 |
| 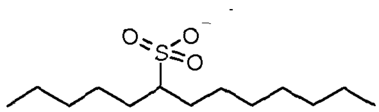 | 3,45 |
| 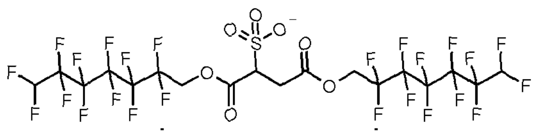 | 3,62 |
| 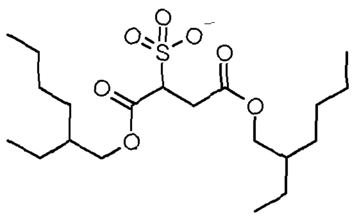 | 3,67 |
| 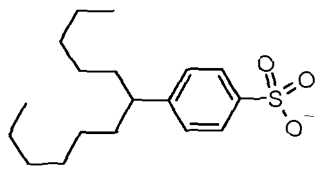 | 4,85 |
| 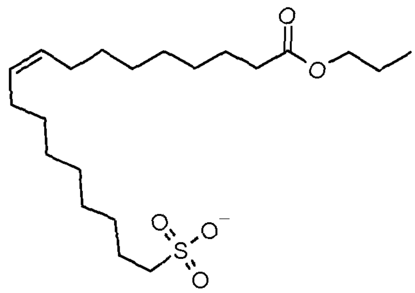 | 5,78 |

(fortgesetzt)

| Anion | AClogP |
|---|---|
| 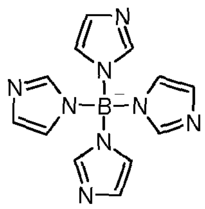 | 5,81 |
| 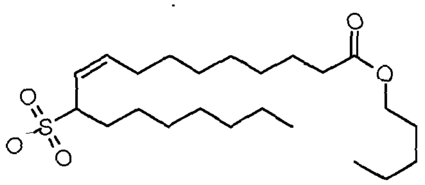 | 6,34 |
| 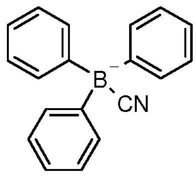 | 6,86 |
| 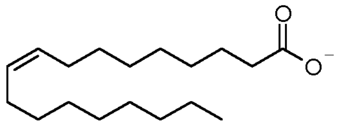 | 7,55 |
| 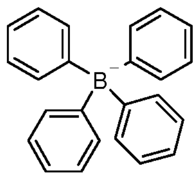 | 8,76 |
| 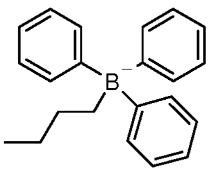 | 8,99 |
| 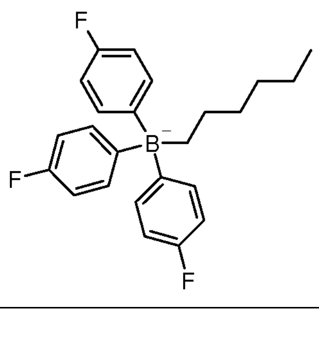 | 9,16 |

(fortgesetzt)

| Anion | AClogP |
|---|---|
| 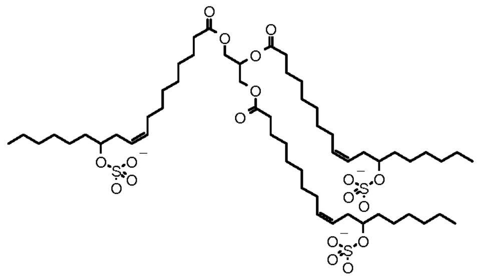 | 12,49 |
| 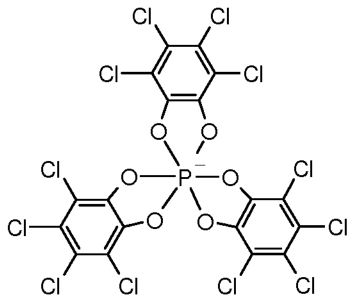 | 17,49 |

Ebenfalls besonders bevorzugt steht

$An^-$ für ein 4-(sec-Alkyl)benzolsulfonat der Formel (LI)

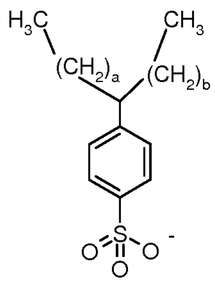

(LI),

worin

a und b unabhängig von einander für eine ganze Zahl von 0 bis 20 stehen, wobei a + b ≥ 3 ist.

Bevorzugt ist hierbei a + b ≥ 5, besonders bevorzugt ≥ 7, ganz besonders bevorzugt ≥ 9.

Mit der Formel (LI) sind auch Mischungen von Anionen gemeint mit verschiedenen Werten von a und b, bei denen a + b gleich ist. Mit der Formel (LI) sind aber auch Mischungen von Anionen gemeint mit verschiedenen Werten von a und b.

Beispiele für Anionen der Formel (LI) sind:

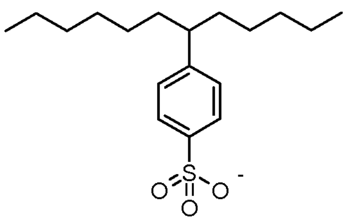

sowie als Mischung aller fünf denkbaren Isomeren.

Ebenfalls besonders bevorzugt steht

An⁻ für ein sec-Alkylsulfonat der Formel (LII)

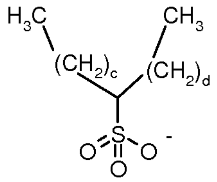

(LII),

worin

c und d unabhängig von einander für eine ganze Zahl von 0 bis 20 stehen, wobei $c + d \geq 5$ ist.

Bevorzugt ist $c + d \geq 7$, besonders bevorzugt $\geq 9$, ganz besonders bevorzugt $\geq 11$.

Mit der Formel (LII) sind auch Mischungen von Anionen gemeint mit verschiedenen Werten von c und d, bei denen c + d gleich ist. Mit der Formel (LII) sind aber auch Mischungen von Anionen gemeint mit verschiedenen Werten von c und d.

Beispiele für Anionen der Formel (LII) sind:

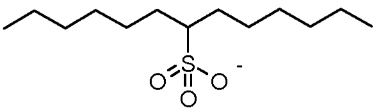

,

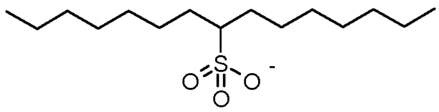

,

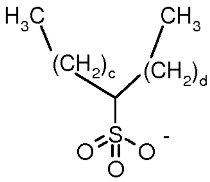

(mit c + d = 8 bis 12),

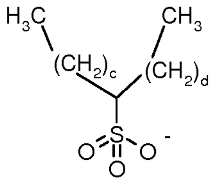

(c + d= 10 bis 14)

sowie als Mischung aller denkbaren Isomeren.

Ebenfalls besonders bevorzugt steht

An⁻ für ein secundäres oder verzweigtes Alkylsulfat der Formel (LIII)

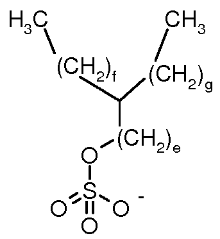

(LIII),

worin

e für eine ganze Zahl von 0 bis 5 steht,

f und g unabhängig von einander für eine ganze Zahl von 0 bis 15 stehen, wobei $e + f + g \geq 5$ ist und die $CH_2$-Gruppen noch durch weitere Methyl- oder Ethylgruppen substituiert sein können.

Bevorzugt ist e + f + g ≥ 7, besonders bevorzugt ≥ 9, ganz besonders bevorzugt ≥ 11.

e steht bevorzugt für 0 oder 1.

Bevorzugt sind zwei $CH_2$-Gruppen durch Methyl und/oder Ethyl substituiert.

Mit der Formel (LIII) sind auch Mischungen von Anionen gemeint mit verschiedenen Werten von e, f und g, bei denen e + f + g gleich ist. Mit der Formel (LIII) sind aber auch Mischungen von Anionen gemeint mit verschiedenen Werten von e, f und g.

Beispiele für Anionen der Formel (LIII) sind:

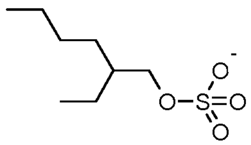 , 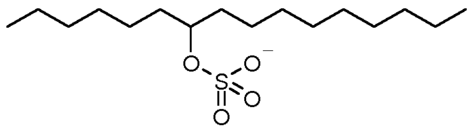 ,

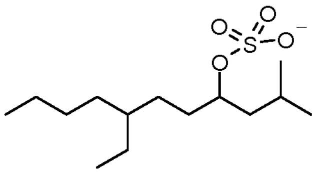 , 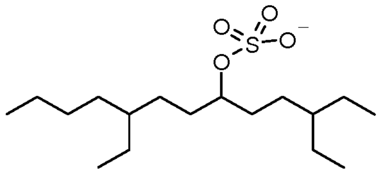 .

Ebenfalls besonders bevorzugt steht

An⁻ für ein verzweigtes Phosphat der Formel (LIV)

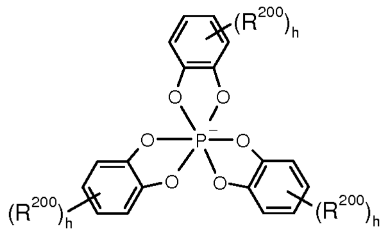 (LIV),

worin

$R^{200}$ für Wasserstoff oder Halogen steht,
h für eine ganze Zahl von 1 bis 4 steht.

Vorzugsweise stehen $R^{200}$ für Chlor oder Brom und h für 4.

Beispiele für Anionen der Formel (LIV) sind:

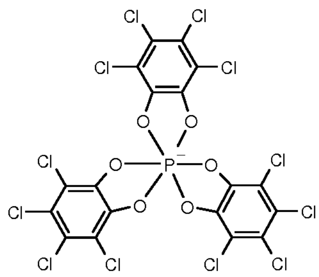,
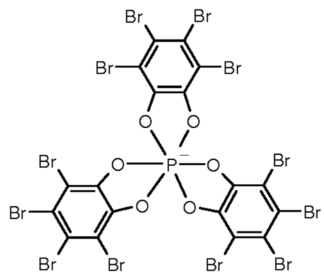.

Ebenfalls besonders bevorzugt steht

An⁻ für ein Alkylsulfat der Formel (LV)

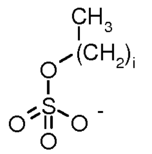
(LV),

worin

i für eine ganze Zahl von 12 bis 25 steht.

Vorzugsweise steht i für eine ganze Zahl von 18 bis 25.

Beispiele für Anionen der Formel (LV) sind:

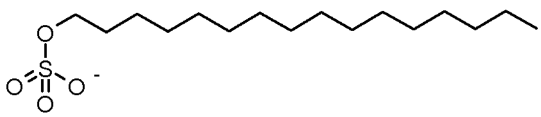.

Ebenfalls besonders bevorzugt steht

An⁻ für ein Sulfosuccinat der Formel (LVI)

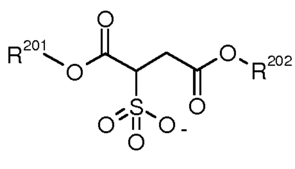
(LVI),

worin

$R^{201}$ und $R^{202}$ unabhängig von einander für einen $C_4$- bis $C_{16}$-Alkylrest steht, der verzweigt sein kann, für einen durch mindestens 4 Fluoratome substituierten $C_2$- bis $C_{12}$-Alkylrest, für einen $C_5$- bis $C_7$-Cycloalkylrest oder für einen $C_7$- bis $C_{10}$-Aralkylrest.

Vorzugsweise sind $R^{201}$ und $R^{202}$ gleich.

Besonders bevorzugt stehen $R^{201}$ und $R^{202}$ für einen $C_6$- bis $C_{12}$-Alkylrest, der verzweigt sein kann, für einen durch mindestens 6 Fluoratome substituierten $C_4$- bis $C_8$-Alkylrest, für Cyclohexyl oder Benzyl. Ganz besonders bevorzugt stehen $R^{201}$ und $R^{202}$ für n-Hexyl, n-Octyl, 2-Ethylhexyl oder 1H,1H,7H-Dodecafluorheptyl.

Beispiele für Anionen der Formel (LVI) sind:

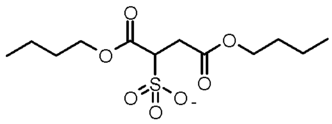 , 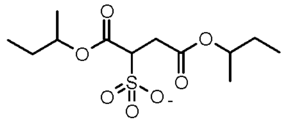 , 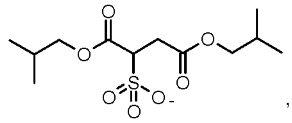 ,

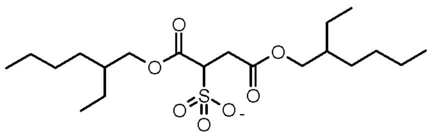 , 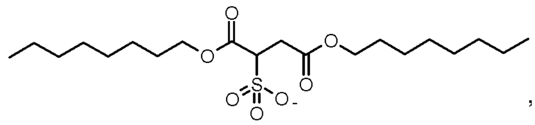 ,

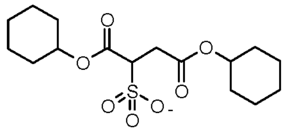 , 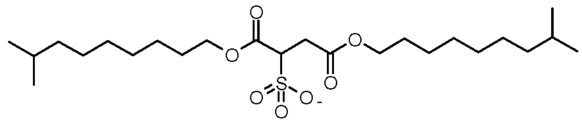 ,

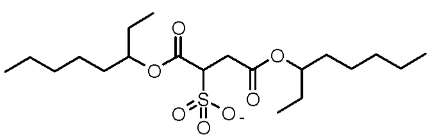 , 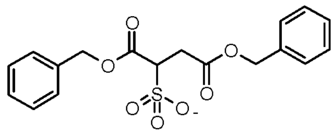 ,

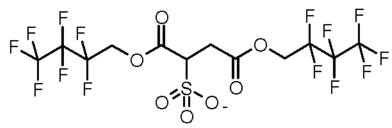

.

Ebenfalls besonders bevorzugt steht

$An^-$ für ein Estersulfonat der Formel (LVII)

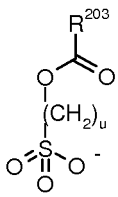

(LVII),

worin

$R^{203}$ für einen $C_2$- bis $C_{22}$-Alkyl- oder Alkenylrest steht, der verzweigt oder substituiert sein kann, und

u für eine ganze Zahl von 2 bis 4 steht.

Vorzugsweise steht $R^{203}$ für einen verzweigten oder unverzweigten $C_6$- bis $C_{17}$-Alkyl- oder Alkenyl-Rest oder für $-CH{=}CH_2$ oder $-C(CH_3){=}CH_2$, besonders bevorzugt für einen verzweigten oder unverzweigten $C_6$- bis $C_{17}$-Alkyl- oder Alkenyl-Rest . Vorzugsweise steht u für 3 oder 4.

Beispiele für Anionen der Formel (LVII) sind:

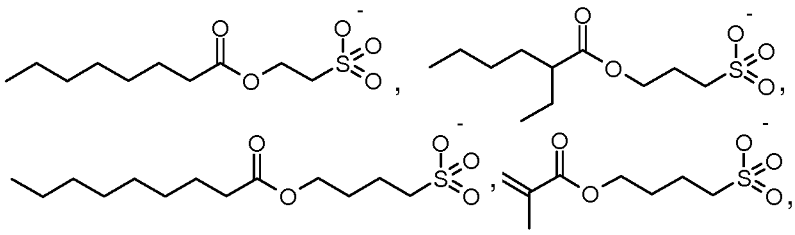

, , , ,

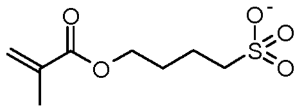

Ebenfalls besonders bevorzugt steht

An⁻ für ein Estersulfonat oder Estersulfate der Formel (LVIII)

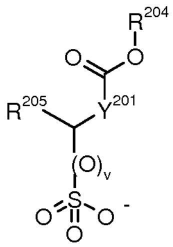

(LVIII),

worin

v für 0 oder 1 steht,
$R^{204}$ für $C_1$- bis $C_{18}$-Alkyl, das verzweigt und/oder substituiert sein kann, steht,
$R^{205}$ für Wasserstoff oder $C_1$- bis $C_8$-Alkyl steht und
$Y^{201}$ für eine direkte Bindung, eine aliphatische $C_1$- bis $C_{22}$-Brücke oder eine olefinische $C_2$- bis $C_{22}$-Brücke steht,
wobei $Y^{201}$ und $R^{204}$ gemeinsam mindestens 7 C-Atome aufweisen.

Beispiele für Anionen der Formel (LVIII) sind:

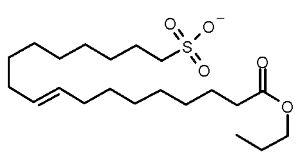

,

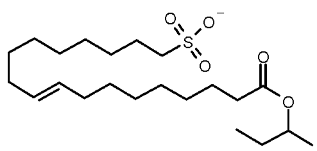

,

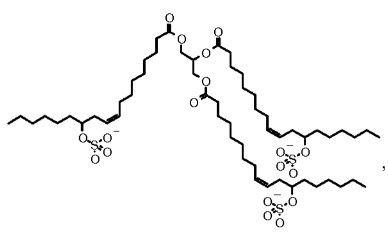

,

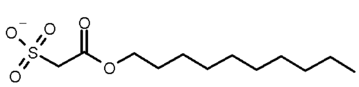

Ebenfalls besonders bevorzugt steht

An⁻ für ein Borat der Formel (LIX)

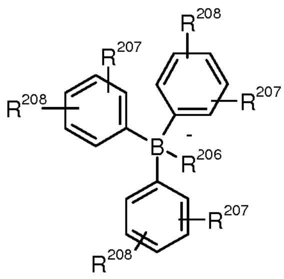

(LIX),

worin

$R^{206}$ für Cyano, $C_1$- bis $C_{12}$-Alkyl, $C_7$- bis $C_{10}$-Aralkyl oder für einen Rest der Formel

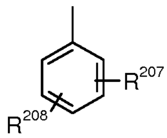

steht,

$R^{207}$ und $R^{208}$ unabhängig voneinander für Wasserstoff, $C_1$- bis $C_4$-Alkyl, $C_1$- bis $C_4$-Alkoxy, Halogen, Cyano oder Nitro steht oder

zwei benachbarte $R^{207}$ und $R^{208}$ eine -CH=CH-CH=CH-Brücke bilden.

Besonders bevorzugt stehen

$R^{206}$ für Cyano, Butyl, Pentyl, Hexyl, Benzyl oder für einen Rest der Formel

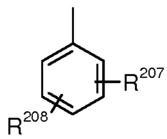

,

$R^{207}$ und $R^{208}$ unabhängig voneinander für Wasserstoff, Methyl, Methoxy, Fluor, Chlor, oder Cyano oder

zwei benachbarte $R^{207}$ und $R^{208}$ bilden eine -CH=CH-CH=CH-Brücke.

Beispiele für Beispiele für Anionen der Formel (LIX) sind:

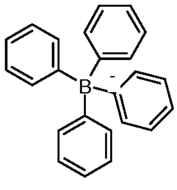 , 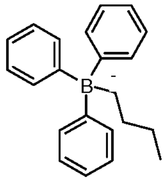 , 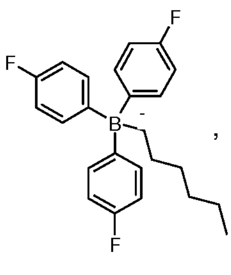 , 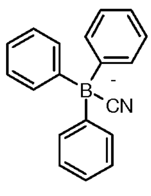 , 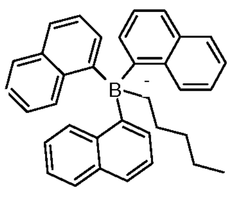

Ebenfalls besonders bevorzugt steht

An⁻ für ein fluoriertes Alkylsulfat der Formel (LX)

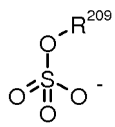

(LX),

worin

$R^{209}$ für einen $C_4$- bis $C_{18}$-Alkylrest steht, der mindestens 4 Fluoratome trägt.

Vorzugsweise steht $R^{209}$ für einen $C_8$- bis $C_{18}$-Alkylrest steht, der mindestens 6 Fluoratome trägt. Ebenfalls vorzugsweise steht steht $R^{209}$ für einen perfluorierten $C_6$- bis $C_{12}$-Alkylrest.

Beispiele für Anionen der Formel (LX) sind:

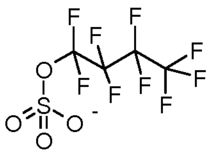

,

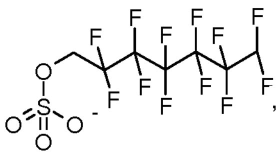

,

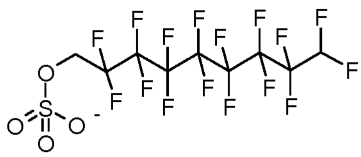

.

Die kationischen Farbstoffe und Anionen sind entweder bekannt oder lassen sich analog zu bekannten Verfahren herstellen.

Unter kationischen Farbstoffen der Formel $F^+$ versteht man bevorzugt solche der folgenden Formeln:

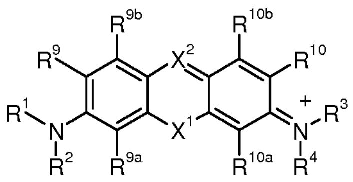

(I),

worin

| | |
|---|---|
| $X^1$ | für O, S, N-$R^6$ oder $CR^{6a}R^{6b}$ steht, |
| $X^2$ | für N oder C-$R^5$ steht, |
| $R^5$ | für Wasserstoff, Cyano, $C_1$- bis $C_4$-Alkyl, $C_4$- bis $C_7$-Cycloalkyl, einen ggf. durch $C_1$- bis $C_4$-Alkoxycarbonyl oder $NR^7R^8$ substituierten $C_6$- bis $C_{10}$-Aryl oder einen heterocyclischen Rest steht, |
| $R^6$ | für Wasserstoff, $C_1$- bis $C_{16}$-Alkyl, $C_4$- bis $C_7$-Cycloalkyl, $C_7$- bis $C_{16}$-Aralkyl, $C_6$- bis Cio-Aryl oder einen heterocyclischen Rest steht, |
| $R^{6a}$ und $R^{6b}$ | gleich sind und für Methyl, Ethyl oder gemeinsam für eine $-CH_2-CH_2-CH_2-$oder $-CH_2-CH_2-CH_2-CH_2-$Brücke stehen, |
| $R^1$ bis $R^4$, $R^7$ und $R^8$ | unabhängig von einander für Wasserstoff, $C_1$- bis $C_{16}$-Alkyl, $C_4$- bis $C_7$-Cycloalkyl, $C_7$- bis $C_{16}$-Aralkyl, $C_6$- bis $C_{10}$-Aryl oder einen heterocyclischen Rest stehen oder |
| $NR^1R^2$, $NR^3R^4$ und $NR^7R^8$ | unabhängig voneinander für einen fünf- oder sechsgliedrigen, über N angebunde- |

nen gesättigten Ring stehen, der zusätzlich ein N oder O enthalten kann und/oder durch nichtionische Reste substituiert sein kann, oder

$R^1$ bis $R^4$, $R^7$ und $R^8$ unabhängig von einander mit einem zum N-Atom benachbarten C-Atom des Benzolrings eine zwei- oder dreigliedrige Brücke bilden, die ein O oder N enthalten kann und/oder durch nichtionische Reste substituiert sein kann,

$R^9$, $R^{9a}$, $R^{9b}$, $R^{10}$, $R^{10a}$ und $R^{10b}$ unabhängig von einander für Wasserstoff, Halogen oder $C_1$-bis $C_4$-Alkyl stehen,

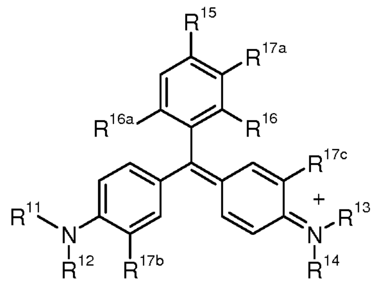

(II),

worin

$R^{15}$ für Wasserstoff, Halogen, $C_1$- bis $C_4$-Alkyl, $C_1$- bis $C_4$-Alkoxy oder $NR^{18}R^{19}$ steht,

$R^{11}$ bis $R^{14}$, $R^{18}$ und $R^{19}$ unabhängig von einander für Wasserstoff, $C_1$- bis $C_{16}$-Alkyl, $C_4$- bis $C_7$-Cycloalkyl, $C_7$- bis $C_{16}$-Aralkyl, $C_{6}$- bis $C_{10}$-Aryl oder einen heterocyclischen Rest stehen oder

$NR^{11}R^{12}$, $NR^{13}R^{14}$ und $NR^{18}R^{19}$ unabhängig voneinander für einen fünf- oder sechsgliedrigen, über N angebundenen gesättigten Ring stehen, der zusätzlich ein N oder O enthalten kann und/oder durch nichtionische Reste substituiert sein kann, oder

$R^{12}$; $R^{17b}$, $R^{13}$; $R^{17c}$ und $R^{18}$; $R^{17a}$ unabhängig von einander eine zwei- oder dreigliedrige Brücke bilden, die ein O oder N enthalten kann und/oder durch nichtionische Reste substituiert sein kann,

$R^{16}$ für Wasserstoff, Chlor, Methyl, Methoxycarbonyl oder Ethoxycarbonyl steht,

$R^{16a}$ für Wasserstoff, Chlor oder Methyl steht,

$R^{17a}$, $R^{17b}$ und $R^{17c}$ unabhängig von einander für Wasserstoff, Chlor, Methyl oder Methoxy stehen,

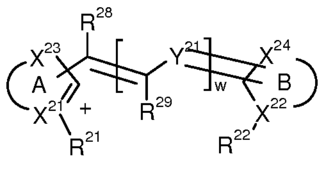

(III),

worin

A und B zusammen mit $X^{21}$ bis $X^{24}$ und den sie verbindenden Atomen unabhängig voneinander für einen fünf- oder sechsgliedrigen aromatischen oder quasiaromatischen oder teilhydrierten heterocyclischen Ring stehen, die 1 bis 4 Heteroatome enthalten und/oder benz- oder naphthanelliert und/oder durch nichtionische Reste substituiert sein können, wobei die Kette in 2-oder 4-Position zu $X^{21}$ bzw. $X^{22}$ am jeweiligen Ring angreift,

$X^{21}$ und $X^{22}$ für Stickstoff stehen oder

$X^{21}$-$R^{21}$ und $X^{22}$-$R^{22}$ unabhängig voneinander für O oder S stehen,

| | |
|---|---|
| $X^{23}$ und $X^{24}$ | unabhängig voneinander für O, S, N-$R^{23}$, $CR^{24}$ oder $CR^{25}R^{26}$ stehen, |
| $Y^{21}$ | für N oder C-$R^{27}$ steht, |
| w | für 0 oder 1 steht, |
| $R^{21}$, $R^{22}$ und $R^{23}$ | unabhängig voneinander für $C_1$- bis $C_{16}$-Alkyl, $C_3$- bis $C_6$-Alkenyl, $C_5$- bis $C_7$-Cycloalkyl oder $C_7$- bis $C_{16}$-Aralkyl stehen, |
| $R^{27}$, $R^{28}$ und $R^{29}$ | unabhängig voneinander für Wasserstoff, $C_1$- bis $C_{16}$-Alkyl oder Cyano stehen, |
| $R^{24}$ | für Wasserstoff oder $C_1$- bis $C_4$-Alkyl steht, |
| $R^{25}$ und $R^{26}$ | unabhängig voneinander $C_1$- bis $C_{16}$-Alkyl oder $C_7$- bis $C_{10}$-Aralkyl stehen oder gemeinsam eine $-CH_2-CH_2-CH_2-$ oder $-CH_2-CH_2-CH_2-CH_2-$Brücke bilden, |

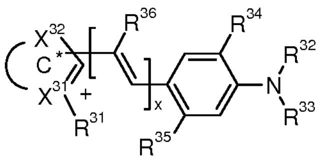

(IV),

worin

| | |
|---|---|
| C | zusammen mit $X^{31}$ und $X^{32}$ und den sie verbindenden Atomen unabhängig voneinander für einen fünf- oder sechsgliedrigen aromatischen oder quasiaromatischen oder teilhydrierten heterocyclischen Ring stehen, die 1 bis 4 Heteroatome enthalten und/oder benz- oder naphthanelliert und/oder durch nichtionische Reste substituiert sein können, wobei die Kette in 2-oder 4-Position zu $X^{31}$ am Ring angreift, |
| $X^{31}$ | für Stickstoff steht oder |
| $X^{31}$-$R^{31}$ | für O oder S steht, |
| $X^{32}$ | für O, S, N-$R^{37}$, $CR^{38}$ oder $CR^{39}R^{40}$ stehen, |
| $R^{31}$ und $R^{37}$ | unabhängig voneinander für $C_1$- bis $C_{16}$-Alkyl, $C_3$- bis $C_6$-Alkenyl, $C_5$- bis $C_7$-Cycloalkyl oder $C_7$- bis $C_{16}$-Aralkyl stehen, |
| $R^{38}$ | für Wasserstoff oder $C_1$- bis $C_4$-Alkyl steht, |
| $R^{39}$ und $R^{40}$ | unabhängig voneinander für $C_1$- bis $C_4$-Alkyl, $C_3$- bis $C_6$-Alkenyl, $C_4$- bis $C_7$-Cycloalkyl oder $C_7$- bis $C_{10}$-Aralkyl stehen oder gemeinsam eine $-CH_2-CH_2-CH_2-$ oder $-CH_2-CH_2-CH_2-CH_2-$Brücke bilden, |
| $R^{32}$ und $R^{33}$ | unabhängig voneinander für Wasserstoff, $C_1$- bis $C_{16}$-Alkyl, $C_4$- bis $C_7$-Cycloalkyl, $C_7$- bis $C_{16}$-Aralkyl, $C_{6-}$ bis Cio-Aryl oder einen heterocyclischen Rest stehen oder |
| $NR^{32}R^{33}$ | für einen fünf- oder sechsgliedrigen, über N angebundenen gesättigten Ring stehen, der zusätzlich ein N oder O enthalten kann und/oder durch nichtionische Reste substituiert sein kann, |
| $R^{34}$ | für Wasserstoff, $C_1$- bis $C_{16}$-Alkyl, $C_1$- bis $C_{16}$-Alkoxy oder Halogen steht oder |
| $R^{34}$ mit $R^{32}$ | eine zwei- oder dreigliedrige Brücke bilden, die ein O oder N enthalten kann und/oder durch nichtionische Reste substituiert sein kann, |
| $R^{35}$ | für Wasserstoff, $C_1$- bis $C_4$-Alkyl, $C_1$- bis $C_4$-Alkoxy, Halogen, Cyano, $C_1$-bis $C_4$-Alkoxycarbonyl, O-CO-$C_1$- bis $C_4$-Alkyl, NH-CO-$C_1$- bis $C_4$-Alkyl, O-$SO_2$-$C_1$- bis $C_4$-Alkyl oder NH-$SO_2$-$C_1$- bis $C_4$-Alkyl steht, |

$R^{36}$ für Wasserstoff, $C_1$- bis $C_4$-Alkyl oder Cyano, steht,

x für 0 oder 1 steht,

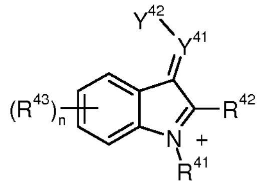

(V),

worin

$Y^{42}$ für einen Rest der Formeln (Va) oder (Vb)

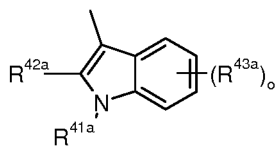

(Va),

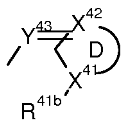

(Vb)

steht,

$R^{41}$, $R^{41a}$ und $R^{41b}$ unabhängig von einander für $C_1$- bis $C_{16}$-Alkyl, $C_3$- bis $C_6$-Alkenyl, $C_5$- bis $C_7$-Cycloalkyl oder $C_7$- bis $C_{16}$-Aralkyl oder $C_6$- bis $C_{10}$-Aryl stehen,

$R^{42}$ und $R^{42a}$ unabhängig von einander für Wasserstoff, $C_1$- bis $C_{16}$-Alkyl, $C_3$- bis $C_6$-Alkenyl, $C_5$- bis $C_7$-Cycloalkyl oder $C_7$- bis $C_{16}$-Aralkyl, $C_{6-}$ bis Cio-Aryl oder Hetaryl stehen,

$R^{43}$ und $R^{43a}$ unabhängig von einander für Wasserstoff, $C_1$- bis $C_4$-Alkyl, $C_1$- bis $C_4$-Alkoxy, Halogen, Cyano, Nitro oder $C_1$- bis $C_4$-Alkoxycarbonyl steht oder zwei benachbarte $R^{43}$ oder $R^{43a}$ für -CH=CH-CH=CH- stehen,

n und o unabhängig von einander für eine ganze Zahl von 0 bis 4 stehen,

$Y^{41}$ für $CR^{44}$, $=CR^{45a}$-$CR^{46}$=$CR^{45b}$- oder N steht,

$Y^{43}$ für CH oder N steht,

$R^{44}$, $R^{45a}$, $R^{45b}$ und $R^{46}$ unabhängig voneinander für Wasserstoff, $C_1$- bis $C_4$-Alkyl, $C_5$- bis $C_6$-Cycloalkyl, $C_6$-Aryl, Hetaryl, Halogen oder Cyano stehen,

D zusammen mit $X^{41}$, $X^{42}$ und dem dazwischen gebundenen C-Atom für einen fünf- oder sechsgliedrigen aromatischen oder quasiaromatischen oder teilhydrierten heterocyclischen Ring steht, der 1 bis 4 Heteroatome enthalten und/oder benz- oder naphthanelliert und/oder durch nichtionische Reste substituiert sein kann, wobei die Kette in 2- oder 4-Position zu $X^{41}$ am Ring angreift,

$X^{41}$ für N steht oder

$x^{41}$-$R^{41b}$ für O oder S steht,

$X^{42}$ für O, S, $CR^{47}R^{48}$ oder -CH=CH- steht,

$R^{47}$ und $R^{48}$ unabhängig voneinander für $C_1$- bis $C_4$-Alkyl, $C_3$- bis $C_6$-Alkenyl, $C_4$- bis $C_7$-Cycloalkyl, $C_7$- bis $C_{10}$-Aralkyl oder $C_6$-Aryl stehen oder gemeinsam eine-$CH_2$-$CH_2$-$CH_2$- oder -$CH_2$-$CH_2$-$CH_2$-$CH_2$-Brücke bilden,

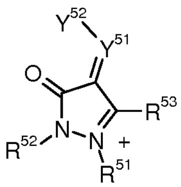

(VI),

worin

$Y^{52}$ für einen Rest der Formeln (VIa), (VIb) oder (VIc)

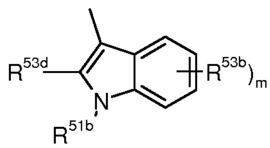

(VIa),

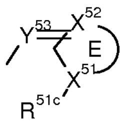

(VIb),

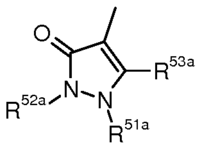

(VIc)

steht,

$R^{51}$, $R^{51a}$, $R^{51b}$ und $R^{51c}$ unabhängig von einander für $C_1$- bis $C_{16}$-Alkyl, $C_3$- bis $C_6$-Alkenyl, $C_5$- bis $C_7$-Cycloalkyl oder $C_7$- bis $C_{16}$-Aralkyl oder $C_6$- bis Cio-Aryl stehen,

$R^{52}$ und $R^{52a}$ unabhängig von einander für $C_1$- bis $C_{16}$-Alkyl, $C_3$- bis $C_6$-Alkenyl, $C_5$- bis $C_7$-Cycloalkyl oder $C_7$- bis $C_{16}$-Aralkyl oder $C_6$- bis $C_{10}$-Aryl stehen,

$R^{53}$ und $R^{53a}$ unabhängig von einander für $C_1$- bis $C_4$-Alkyl, Halogen, Cyano, Nitro oder $C_1$- bis $C_4$-Alkoxycarbonyl stehen,

$R^{53d}$ für Wasserstoff, $C_1$- bis $C_{16}$-Alkyl, $C_3$- bis $C_6$-Alkenyl, $C_5$- bis $C_7$-Cycloalkyl oder $C_7$- bis $C_{16}$-Aralkyl, $C_6$- bis Cio-Aryl oder Hetaryl steht,

$R^{53b}$ für Wasserstoff, $C_1$- bis $C_4$-Alkyl, $C_1$- bis $C_4$-Alkoxy, Halogen, Cyano, Nitro oder $C_1$- bis $C_4$-Alkoxycarbonyl steht oder zwei benachbarte $R^{53b}$ oder $R^{53c}$ für -CH=CH-CH=CH- stehen,

m für eine ganze Zahl von 0 bis 4 steht,

$Y^{51}$ für $CR^{54}$, $=CR^{55a}-CR^{56}=CR^{55b}-$ oder N steht,

$Y^{53}$ für CH oder N steht,

$R^{54}$, $R^{55a}$, $R^{55b}$ und $R^{56}$ unabhängig voneinander für Wasserstoff, $C_1$- bis $C_4$-Alkyl, $C_5$- bis $C_6$-Cycloalkyl, $C_6$-Aryl, Hetaryl, Halogen oder Cyano stehen,

E zusammen mit $X^{51}$, $X^{52}$ und dem dazwischen gebundenen C-Atom für einen fünf- oder sechsgliedrigen aromatischen oder quasiaromatischen oder teilhydrierten heterocyclischen Ring steht, der 1 bis 4 Heteroatome enthalten und/oder benz- oder naphthanelliert und/oder durch nichtionische Reste substituiert sein kann, wobei die Kette in 2- oder 4-Position zu $X^{51}$ am Ring angreift,

$X^{51}$ für N steht oder

$X^{51}-R^{51c}$ für O oder S steht,

$X^{52}$ für O, S, $CR^{57}R^{58}$ oder -CH=CH- steht,

$R^{57}$ und $R^{58}$ unabhängig voneinander für $C_1$- bis $C_4$-Alkyl, $C_3$- bis $C_6$-Alkenyl, $C_4$- bis $C_7$-Cycloalkyl, $C_7$- bis $C_{10}$-Aralkyl oder $C_6$-Aryl stehen oder gemeinsam eine $-CH_2-CH_2-CH_2-$ oder $-CH_2-CH_2-CH_2-CH_2-$Brücke bilden,

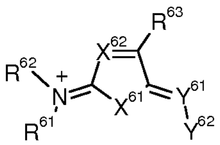

(VII),

worin

$Y^{62}$ für einen Rest der Formeln

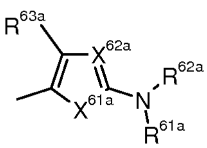

(VIIa),

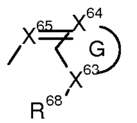

(VIIb) oder

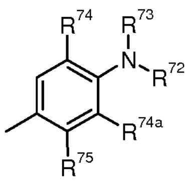

(VIIc) steht,

$X^{61}$ und $X^{61a}$ unabhängig von einander für O oder S stehen,

$X^{62}$ und $X^{62a}$ unabhängig von einander für $CR^{66}$ oder N stehen,

| | |
|---|---|
| $R^{63}$ und $R^{63a}$ | unabhängig von einander für Wasserstoff, $C_1$- bis $C_6$-Alkyl, Halogen, Hydroxy, $C_6$- bis $C_{10}$-Aryl oder $NR^{64}R^{65}$ stehen oder $R^{63}$ und $R^{63a}$ gemeinsam für eine $-C(CH_3)_2$-Brücke stehen, wenn $Y^{61}$ für CH und $Y^{62}$ für einen Rest der Formel (VIIa) stehen, |
| $R^{61}$, $R^{61a}$, $R^{62}$, $R^{62a}$, $R^{64}$ und $R^{65}$ | unabhängig voneinander für Wasserstoff, $C_1$- bis $C_6$-Alkyl, $C_5$- bis $C_7$-Cycloalkyl, $C_6$- bis $C_{10}$-Aryl oder $C_7$- bis $C_{15}$-Aralkyl stehen oder |
| $NR^{61}R^{62}$ und $NR^{64}R^{61}$ | unabhängig voneinander für Pyrrolidino, Morpholino, Piperazino oder Piperidino stehen, |
| $R^{66}$ | für Wasserstoff, Cyano, $C_1$- bis $C_6$-Alkyl, Halogen oder $C_6$- bis Cio-Aryl steht, |
| $Y^{61}$ | für $=Y^{63}-(Y^{64}=Y^{65})_p-$ steht, |
| $Y^{63}$ bis $Y^{65}$ | unabhängig voneinander für N oder C-$R^{67}$ stehen, |
| p | für 0 oder 1 steht, |
| $R^{67}$ | für Wasserstoff, Cyano oder $C_1$- bis $C_3$-Alkyl steht oder |
| $R^{67}$ | für einen Rest der Formel (VIIa) steht, wenn p für 1 steht, |
| G | zusammen mit $X^{63}$, $X^{64}$ und dem dazwischen gebundenen C-Atom für einen fünf- oder sechsgliedrigen aromatischen oder quasiaromatischen oder teilhydrierten heterocyclischen Ring steht, der 1 bis 4 Heteroatome enthalten und/oder benz- oder naphthanelliert und/oder durch nichtionische Reste substituiert sein kann, wobei die Kette in 2- oder 4-Position zu $X^{63}$ am Ring angreift, |
| $X^{63}$ | für Stickstoff steht oder |
| $X^{63}$-$R^{68}$ | für O oder S steht, |
| $X^{64}$ | für O, S, N-$R^{69}$ oder $CR^{70}R^{71}$ steht, |
| $X^{65}$ | für N oder C-$R^{67}$ steht, |
| $R^{68}$ und $R^{69}$ | unabhängig voneinander für $C_1$- bis $C_{16}$-Alkyl, $C_3$- bis $C_6$-Alkenyl, $C_5$- bis $C_7$-Cycloalkyl oder $C_7$- bis $C_{16}$-Aralkyl stehen, |
| $R^{70}$ und $R^{71}$ | unabhängig voneinander für $C_1$- bis $C_4$-Alkyl oder $C_7$- bis $C_{10}$-Aralkyl stehen oder gemeinsam eine $-CH_2-CH_2-CH_2-$ oder $-CH_2-CH_2-CH_2-CH_2-$Brücke bilden, |
| $R^{72}$ und $R^{73}$ | unabhängig voneinander für Wasserstoff, $C_1$- bis $C_{16}$-Alkyl, $C_4$- bis $C_7$-Cycloalkyl, $C_7$- bis $C_{16}$-Aralkyl, $C_6$- bis $C_{10}$-Aryl oder einen heterocyclischen Rest stehen oder |
| $NR^{72}R^{73}$ für | einen fünf- oder sechsgliedrigen, über N angebundenen gesättigten Ring stehen, der zusätzlich ein N oder O enthalten kann und/oder durch nichtionische Reste substituiert sein kann, |
| $R^{74}$ und $R^{74a}$ | unabhängig voneinander für Wasserstoff, $C_1$- bis $C_4$-Alkyl, $C_1$- bis $C_4$-Alkoxy oder Halogen stehen oder |
| $R^{74}$; $R^{73}$ und/oder $R^{74a}$; $R^{72}$ | eine zwei- oder dreigliedrige Brücke bilden, die ein O oder N enthalten kann und/oder durch nichtionische Reste substituiert sein kann, |
| $R^{75}$ | für Wasserstoff, $C_1$- bis $C_4$-Alkyl, $C_1$- bis $C_4$-Alkoxy, Halogen, Cyano, $C_1$-bis $C_4$-Alkoxycarbonyl, O-CO-$C_1$- bis $C_4$-Alkyl, NH-CO-$C_1$- bis $C_4$-Alkyl, O-$SO_2$-$C_1$- bis $C_4$-Al- |

kyl oder NH-$SO_2$-$C_1$- bis $C_4$-Alkyl steht,

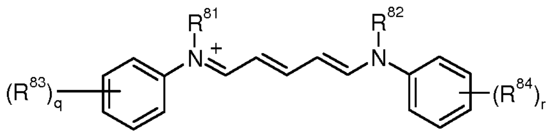

(VIII),

worin

$R^{81}$ und $R^{82}$ unabhängig von einander für Wasserstoff, $C_1$- bis $C_{16}$-Alkyl, $C_3$- bis $C_6$-Alkenyl, $C_5$- bis $C_7$-Cycloalkyl oder $C_7$- bis $C_{16}$-Aralkyl oder $C_6$- bis $C_{10}$-Aryl stehen,

$R^{83}$ und $R^{84}$ unabhängig von einander für Wasserstoff, $C_1$- bis $C_4$-Alkyl, $C_1$- bis $C_4$-Alkoxy, Halogen, Cyano, Nitro oder $C_1$- bis $C_4$-Alkoxycarbonyl steht oder zwei benachbarte $R^{83}$ oder $R^{84}$ für -CH=CH-CH=CH- stehen, oder

$R^{83}$; $R^{81}$ und/oder $R^{84}$; $R^{82}$ eine zwei- oder dreigliedrige Brücke bilden, die durch nichtionische Reste substituiert sein kann,

q und r unabhängig von einander für eine ganze Zahl von 0 bis 4 stehen,

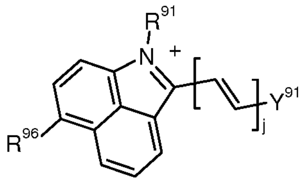

(IX),

worin

$Y^{91}$ für einen Rest der Formeln (IXa) oder (IXb)

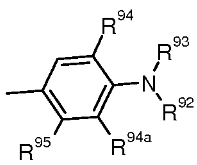

(IXa),

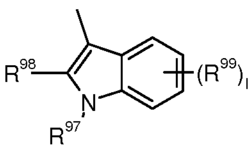

(IXb)

steht,

$R^{91}$ für $C_1$- bis $C_{16}$-Alkyl, $C_3$- bis $C_6$-Alkenyl, $C_5$- bis $C_7$-Cycloalkyl oder $C_7$- bis $C_{16}$-Aralkyl stehen,

$R^{92}$ und $R^{93}$ unabhängig voneinander für Wasserstoff, $C_1$- bis $C_{16}$-Alkyl, $C_4$- bis $C_7$-Cycloalkyl, $C_7$- bis $C_{16}$-Aralkyl, $C_6$- bis $C_{10}$-Aryl oder einen heterocyclischen Rest stehen oder

$NR^{92}R^{93}$ für einen fünf- oder sechsgliedrigen, über N angebundenen gesättigten Ring stehen, der zusätzlich ein N oder O enthalten kann und/oder durch nicht-ionische Reste substi-

tuiert sein kann,

$R^{94}$ und $R^{94a}$ unabhängig voneinander für Wasserstoff, $C_1$- bis $C_4$-Alkyl, $C_1$- bis $C_4$-Alkoxy oder Halogen stehen oder

$R^{94}$; $R^{93}$ und/oder $R^{94a}$; $R^{92}$ eine zwei- oder dreigliedrige Brücke bilden, die ein O oder N enthalten kann und/oder durch nichtionische Reste substituiert sein kann,

$R^{95}$ für Wasserstoff, $C_1$- bis $C_4$-Alkyl, $C_1$- bis $C_4$-Alkoxy, Halogen, Cyano, $C_1$-bis $C_4$-Alkoxycarbonyl, O-CO-$C_1$- bis $C_4$-Alkyl, NH-CO-$C_1$- bis $C_4$-Alkyl, O-$SO_2$-$C_1$- bis $C_4$-Alkyl oder NH-$SO_2$-$C_1$- bis $C_4$-Alkyl steht,

$R^{96}$ für Wasserstoff, Halogen, O-$C_1$- bis $C_4$-Alkyl oder S-$C_1$- bis $C_4$-Alkyl steht,

j für 0 oder 1 steht,

$R^{97}$ für $C_1$- bis $C_{16}$-Alkyl, $C_3$- bis $C_6$-Alkenyl, $C_5$- bis $C_7$-Cycloalkyl oder $C_7$- bis $C_{16}$-Aralkyl oder $C_6$- bis $C_{10}$-Aryl steht,

$R^{98}$ für Wasserstoff, $C_1$- bis $C_{16}$-Alkyl, $C_3$- bis $C_6$-Alkenyl, $C_5$- bis $C_7$-Cycloalkyl oder $C_7$- bis $C_{16}$-Aralkyl, $C_6$- bis $C_{10}$-Aryl oder Hetaryl steht,

$R^{99}$ für Wasserstoff, $C_1$- bis $C_4$-Alkyl, $C_1$- bis $C_4$-Alkoxy, Halogen, Cyano, Nitro oder $C_1$- bis $C_4$-Alkoxycarbonyl steht oder zwei benachbarte $R^{99}$ für -CH=CH-CH=CH- stehen,

1 für eine ganze Zahl von 0 bis 4 steht,

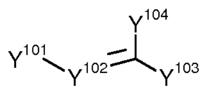
(X),

worin

$Y^{101}$ für einen Rest der Formeln

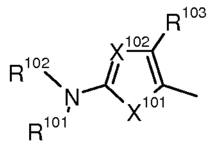
(Xa),

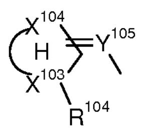
(Xb) oder

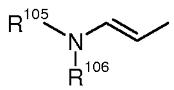
(Xc)

steht,

$X^{101}$ für O oder S steht,

| | |
|---|---|
| $X^{102}$ | für $CR^{107}$ oder N steht, |
| $R^{103}$ | für Wasserstoff, $C_1$- bis $C_6$-Alkyl, Halogen, Hydroxy, $C_6$- bis $C_{10}$-Aryl oder $NR^{101a}R^{102a}$ steht, |
| $R^{101}$, $R^{102}$, $R^{101a}$ und $R^{102a}$ | unabhängig voneinander für Wasserstoff, $C_1$- bis $C_6$-Alkyl, $C_5$- bis $C_7$-Cycloalkyl, $C_6$- bis Cio-Aryl oder $C_7$- bis $C_{15}$-Aralkyl stehen oder |
| $NR^{101}R^{102}$ | und/oder $NR^{101a}R^{102a}$ für Pyrrolidino, Morpholino, Piperazino oder Piperidino stehen, |
| $R^{107}$ | für Wasserstoff, Cyano, $C_1$- bis $C_6$-Alkyl, Halogen oder $C_6$- bis Cio-Aryl steht, |
| H | zusammen mit $X^{103}$, $X^{104}$ und dem dazwischen gebundenen C-Atom für einen fünf- oder sechsgliedrigen aromatischen oder quasiaromatischen oder teilhydrierten heterocyclischen Ring steht, der 1 bis 4 Heteroatome enthalten und/oder benz- oder naphthanelliert und/oder durch nichtionische Reste substituiert sein kann, wobei die Kette in 2- oder 4-Position zu $X^{103}$ am Ring angreift, |
| $X^{103}$ | für N steht oder |
| $X^{103}$-$R^{104}$ | für O oder S steht, |
| $X^{104}$ | für O, S, $CR^{115}R^{116}$ oder -CH=CH- steht, |
| $R^{115}$ und $R^{116}$ | unabhängig voneinander für $C_1$- bis $C_4$-Alkyl, $C_3$- bis $C_6$-Alkenyl, $C_4$- bis $C_7$-Cycloalkyl, $C_7$- bis $C_{10}$-Aralkyl oder $C_6$-Aryl stehen oder gemeinsam eine-$CH_2$-$CH_2$-$CH_2$- oder -$CH_2$-$CH_2$-$CH_2$-$CH_2$-Brücke bilden, |
| $R^{104}$ | für $C_1$- bis $C_{16}$-Alkyl, $C_3$- bis $C_6$-Alkenyl, $C_5$- bis $C_7$-Cycloalkyl oder $C_7$- bis $C_{16}$-Aralkyl oder $C_6$- bis Cio-Aryl steht, |
| $R^{105}$ und $R^{106}$ | unabhängig voneinander für Wasserstoff, $C_1$- bis $C_{16}$-Alkyl, $C_4$- bis $C_7$-Cycloalkyl, $C_7$- bis $C_{16}$-Aralkyl, $C_6$- bis Cio-Aryl oder einen heterocyclischen Rest stehen oder |
| $NR^{105}R^{106}$ | für einen fünf- oder sechsgliedrigen, über N angebundenen gesättigten Ring stehen, der zusätzlich ein N oder O enthalten kann und/oder durch nicht-ionische Reste substituiert sein kann, |
| $Y^{102}$ und $Y^{105}$ | unabhängig von einander für N oder $CR^{108}$ stehen, |
| $R^{108}$ | für Wasserstoff, Cyano oder $C_1$- bis $C_4$-Alkyl steht, |
| $Y^{103}$ | für CN, CO-$R^{109}$, COO-$R^{110}$, $CONHR^{110}$ oder $CONR^{110}R^{111}$ steht, |
| $Y^{104}$ | für einen kationischen Rest der Formel |

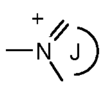
oder

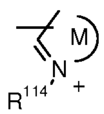

steht oder

$CY^{103}Y^{104}$ zusammen für einen Rest der Formeln

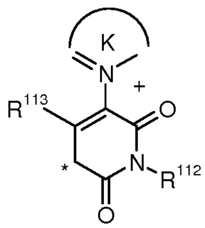
,
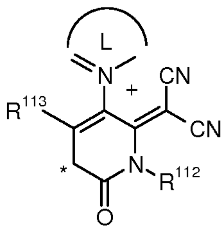

steht, wobei der Stern (*) das Ringatom anzeigt, von dem die Doppelbindung ausgeht,

$R^{109}$ bis $R^{112}$ unabhängig voneinander für Wasserstoff, $C_1$- bis $C_6$-Alkyl, $C_3$- bis $C_6$-Alkenyl, $C_5$- bis $C_7$-Cycloalkyl, $C_6$- bis $C_{10}$-Aryl oder $C_7$- bis $C_{15}$- Aralkyl stehen,

$R^{113}$ für Wasserstoff, Cyano, COO-$R^{110}$ oder $C_1$- bis $C_4$-Alkyl steht,

J, K und L unabhängig von einander zusammen mit dem N-Atom für einen fünf- oder sechsgliedrigen aromatischen oder quasiaromatischen oder teilhydrierten heterocyclischen Ring steht, der 1 bis 4 Heteroatome enthalten und/oder benz- oder naphthanelliert und/oder durch nichtionische Reste substituiert sein kann,

M zusammen mit dem N-Atom für einen fünf- oder sechsgliedrigen aromatischen oder quasiaromatischen oder teilhydrierten heterocyclischen Ring steht, der 1 bis 4 Heteroatome enthalten und/oder benz- oder naphthanelliert und/oder durch nichtionische Reste substituiert sein kann, wobei die Kette in 2- oder 4-Position zum N-Atom am Ring angreift,

$R^{114}$ für $C_1$- bis $C_6$-Alkyl, $C_3$- bis $C_6$-Alkenyl, $C_5$- bis $C_7$-Cycloalkyl, $C_6$- bis $C_{10}$-Aryl oder $C_7$- bis $C_{15}$- Aralkyl steht,

wobei zwei oder mehrere dieser Farbstoffformeln (I) bis (X) über eine Brücke verbunden sein können und diese Brücke statt der Reste $R^{21}$, $R^{22}$, $R^{31}$, $R^{32}$, $R^{41}$, $R^{41a}$, $R^{41b}$, $R^{51b}$, $R^{51c}$, $R^{61}$, $R^{61a}$, $R^{66}$, $R^{72}$, $R^{91}$, $R^{92}$, $R^{101}$, $R^{104}$ und/oder $R^{105}$ steht.
Unter kationischen Farbstoffen der Formel $F^+$ versteht man bevorzugt auch solche der folgenden Formel:

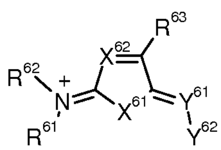
(VII),

worin

$Y^{62}$ für einen Rest der Formeln

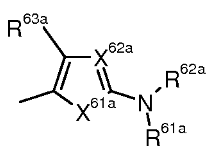
(VIIa),

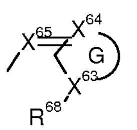
(VIIb),

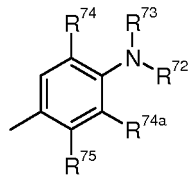

(VIIc),

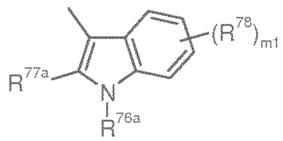

(VIId) oder

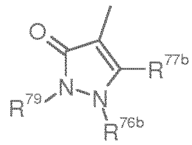

(VIIe) steht,

| | |
|---|---|
| $X^{61}$ und $X^{61a}$ | unabhängig voneinander für O oder S stehen, |
| $X^{62}$ und $X^{62a}$ | unabhängig voneinander für $CR^{66}$ oder N stehen, |
| $R^{63}$ und $R^{63a}$ | unabhängig voneinander für Wasserstoff, $C_1$- bis $C_6$-Alkyl, Halogen, Hydroxy, $C_6$- bis $C_{10}$-Aryl oder $NR^{64}R^{65}$ stehen oder $R^{63}$ und $R^{63a}$ gemeinsam für eine $-C(CH_3)_2$-Brücke stehen, wenn $Y^{61}$ für CH und $Y^{62}$ für einen Rest der Formel (VIIa) stehen, |
| $R^{61}$, $R^{61a}$, $R^{62}$, $R^{62a}$, $R^{64}$ und $R^{65}$ | unabhängig voneinander für Wasserstoff, $C_1$- bis $C_6$-Alkyl, $C_5$- bis $C_7$-Cycloalkyl, $C_6$- bis $C_{10}$-Aryl oder $C_7$- bis $C_{15}$-Aralkyl stehen oder |
| $NR^{61}R^{62}$ und $NR^{64}R^{65}$ | unabhängig voneinander für Pyrrolidino, Morpholino, Piperazino oder Piperidino stehen, |
| $R^{66}$ | für Wasserstoff, Cyano, $C_1$- bis $C_6$-Alkyl, Halogen oder $C_6$- bis Cio-Aryl steht, |
| $Y^{61}$ | für $=Y^{63}-(Y^{64}=Y^{65})_p$- steht, |
| $Y^{63}$ bis $Y^{65}$ | unabhängig voneinander für N oder C-$R^{67}$ stehen, |
| p | für 0 oder 1 steht, |
| $R^{67}$ | für Wasserstoff, Cyano oder $C_1$- bis $C_3$-Alkyl steht oder |
| $R^{67}$ | für einen Rest der Formeln (VIIa), (VIIc) oder für einen gegebenenfalls durch einen oder mehrere $C_1$- bis $C_4$-Alkyl, Halogen, $C_1$- bis $C_4$-Alkoxy, Cyano, Nitro oder $C_1$- bis $C_4$-Alkoxycarbonyl substituierten Phenylrest steht, wenn p für 1 steht, |
| G | zusammen mit $X^{63}$, $X^{64}$ und dem dazwischen gebundenen C-Atom für einen fünf- oder sechsgliedrigen aromatischen oder quasiaromatischen oder teilhydrierten heterocyclischen Ring steht, der 1 bis 4 Heteroatome enthalten und/oder benz- oder naphthanelliert und/oder durch nichtionische Reste substituiert sein kann, wobei die Kette in 2- oder 4-Position zu $X^{63}$ am Ring angreift, |
| $X^{63}$ | für Stickstoff steht oder |

| | |
|---|---|
| $X^{63}$-$R^{68}$ | für O oder S steht, |
| $X^{64}$ | für O, S, N-$R^{69}$ oder $CR^{70}R^{71}$ steht, |
| $X^{65}$ | für N oder C-$R^{67}$ steht, |
| $R^{68}$ und $R^{69}$ | unabhängig voneinander für $C_1$- bis $C_{16}$-Alkyl, $C_3$- bis $C_6$-Alkenyl, $C_5$- bis $C_7$-Cycloalkyl oder $C_7$- bis $C_{16}$-Aralkyl stehen, |
| $R^{70}$ und $R^{71}$ | unabhängig voneinander für $C_1$- bis $C_4$-Alkyl oder $C_7$- bis $C_{10}$-Aralkyl stehen oder gemeinsam eine $-CH_2-CH_2-CH_2-$ oder $-CH_2-CH_2-CH_2-CH_2-$Brücke bilden, |
| $R^{72}$ und $R^{73}$ | unabhängig voneinander für Wasserstoff, $C_1$- bis $C_{16}$-Alkyl, $C_4$- bis $C_7$-Cycloalkyl, $C_7$- bis $C_{16}$-Aralkyl, $C_6$- bis $C_{10}$-Aryl oder einen heterocyclischen Rest stehen oder |
| $NR^{72}R^{73}$ | für einen fünf- oder sechsgliedrigen, über N angebundenen gesättigten Ring stehen, der zusätzlich ein N oder O enthalten kann und/oder durch nichtionische Reste substituiert sein kann, |
| $R^{74}$ und $R^{74a}$ | unabhängig voneinander für Wasserstoff, $C_1$- bis $C_4$-Alkyl, $C_1$- bis $C_4$-Alkoxy oder Halogen stehen oder |
| $R^{74}$; $R^{73}$ und/oder $R^{74a}$; $R^{72}$ | eine zwei- oder dreigliedrige Brücke bilden, die ein O oder N enthalten kann und/oder durch nichtionische Reste substituiert sein kann, |
| $R^{76a}$, $R^{76b}$ und $R^{79}$ | unabhängig voneinander für $C_1$- bis $C_{16}$-Alkyl, $C_3$- bis $C_6$-Alkenyl, $C_5$- bis $C_7$-Cycloalkyl, $C_7$- bis $C_{16}$-Aralkyl oder $C_6$- bis Cio-Aryl stehen, |
| $R^{77a}$ | für Wasserstoff, $C_1$- bis $C_{16}$-Alkyl, $C_3$- bis $C_6$-Alkenyl, $C_5$- bis $C_7$-Cycloalkyl, $C_7$- bis $C_{16}$-Aralkyl, $C_6$- bis Cio-Aryl oder Hetaryl steht, |
| $R^{77b}$ | für $C_1$- bis $C_4$-Alkyl, Halogen, Cyano, Nitro oder $C_1$- bis $C_4$-Alkoxycarbonyl steht, |
| $R^{78}$ | für Wasserstoff, $C_1$- bis $C_4$-Alkyl, $C_1$- bis $C_4$-Alkoxy, Halogen, Cyano, Nitro oder $C_1$- bis $C_4$-Alkoxycarbonyl steht oder zwei benachbarte $R^{78}$ für-CH=CH-CH=CH-stehen, |
| $m^1$ | für eine ganze Zahl von 0 bis 4 steht. |

Unter kationischen Farbstoffen der Formel $F^+$ versteht man bevorzugt auch solche der folgenden Formel:

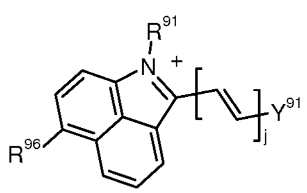

(IX),

worin

$Y^{91}$ für einen Rest der Formeln (IXc)

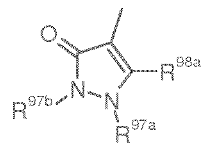

(IXc)

steht,

$R^{91}$ für $C_1$- bis $C_{16}$-Alkyl, $C_3$- bis $C_6$-Alkenyl, $C_5$- bis $C_7$-Cycloalkyl oder $C_7$- bis $C_{16}$-Aralkyl stehen,

j für 0 oder 1 steht,

$R^{97a}$ und $R^{97b}$ unabhängig voneinander für $C_1$- bis $C_{16}$-Alkyl, $C_3$- bis $C_6$-Alkenyl, $C_5$- bis $C_7$-Cycloalkyl, $C_7$- bis $C_{16}$-Aralkyl oder $C_6$- bis $C_{10}$-Aryl stehen,

$R^{98a}$ für $C_1$- bis $C_4$-Alkyl, Halogen, Cyano, Nitro oder $C_1$- bis $C_4$-Alkoxycarbonyl steht.

Geeignete Brücken sind beispielsweise solche der Formeln:
$-CH_2-CH_2-CH_2-$, $-CH_2-CH_2-CH_2-CH_2-$, $-CH_2-CH_2-O-CH_2-CH_2-$,

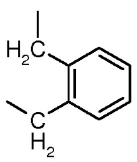 , 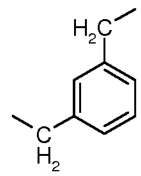 , 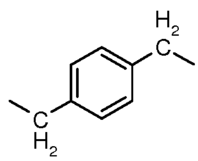 .

Nichtionische Reste sind $C_1$- bis $C_4$-Alkyl, $C_1$- bis $C_4$-Alkoxy, Halogen, Cyano, Nitro, $C_1$-bis $C_4$-Alkoxycarbonyl, $C_1$- bis $C_4$-Alkylthio, $C_1$- bis $C_4$-Alkanoylamino, Benzoylamino, Mono- oder $D_1$-$C_1$- bis $C_4$-Alkylamino.

Alkyl-, Alkoxy-, Cycloalkyl-, Aryl- und heterocyclischen Reste können gegebenenfalls weitere Reste wie Alkyl, Halogen, Nitro, Cyano, $CO-NH_2$, Alkoxy, Trialkylsilyl, Trialkylsiloxy oder Phenyl tragen, die Alkyl- und Alkoxyreste können geradkettig oder verzweigt sein, die Alkylreste können teil- oder perhalogeniert sein, die Alkyl- und Alkoxyreste können ethoxyliert oder propoxyliert oder silyliert sein, benachbarte Alkyl und/oder Alkoxyreste an Aryl- oder heterocyclischen Resten können gemeinsam eine drei- oder viergliedrige Brücke ausbilden und die heterocyclischen Reste können benzanneliert und/oder quaterniert sein.

Unter Halogen sind Fluor, Chlor, Brom oder Iod zu verstehen, vorzugsweise Fluor, Chlor oder Brom.

Beispiele für substituierte Alkylreste sind Trifluormethyl, Chlorethyl, Cyanmethyl, Cyanoethyl, Methoxyethyl. Beispiele für verzweigte Alkylreste sind Isopropyl, tert.-Butyl, 2-Butyl, Neopentyl. Beispiele für Alkoxyreste sind Methoxy, Ethoxy, Methoxyethoxy.

Bevorzugte gegebenenfalls substituierte $C_1$- bis $C_4$-Alkylreste sind Methyl, Ethyl, n-Propyl, Isopropyl, n-Butyl, 2-Butyl, iso-Butyl, tert.-Butyl, perfluoriertes Methyl, perfluororiertes Ethyl, 2,2-Trifluorethyl, 3,3,3-Trifluorethyl, Perfluorbutyl, Cyanethyl, Methoxyethyl, Chlorethyl.

Als bevorzugtes Aralkyl kommt beispielsweise Benzyl, Phenethyl oder Phenylpropyl in Frage.

Beispiele für $C_6$- bis $C_{10}$-Aryl sind Phenyl und Naphthyl. Beispiele für substituierte Arylreste sind Tolyl, Chlorphenyl, Dichlorphenyl, Methoxyphenyl, Nitrophenyl, Cyanophenyl, Dimethylaminophenyl, Diethylaminophenyl.

Beispiele für Hetarylreste, insbesondere für fünf- oder sechsgliedrige heterocyclische Reste, sind Indolyl, Pyridyl, Chinolyl, Benzthiazolyl. Beispiele für substituierte heterocyclische Reste sind 1,2-Dimethylindol-3-yl, 1-Methyl-2-phenylindol-3-yl.

Beispiele für die Ringe A und C der Formeln

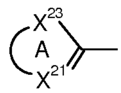 bzw. 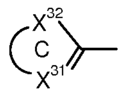

sind: 2- oder 4-Pyridyl, 2- oder 4-Chinolyl, 2- oder 4-Pyrimidyl, Pyrimid-2-on-4-yl, 2-Pyrazinyl, 1,3-Thiazol-2-yl, 1,3-Thiazolin-2-yl, Benzothiazol-2-yl, 1,3-Oxazol-2-yl, 1,3-Oxazolin-2-yl, Benzoxazol-2-yl, Imidazol-2-yl, Imidazolin-2-yl, Benzimidazol-2-yl,

Pyrrolin-2-yl, Pyrrol-2-yl, 3-H-Indol-2-yl, 3-H-Benzindol-2-yl, 1,3,4-Thiadiazol-2-yl, 1,2,4-Thiadiazol-3-yl, Benz-1,4-thiazin-3-yl, Chinoxalin-2-yl oder Chinoxalin-3-on-2-yl, die durch $C_1$- bis $C_6$-Alkyl, $C_1$- bis $C_6$-Alkoxy, Fluor, Chlor, Brom, Iod, Cyano, Nitro, $C_1$- bis $C_6$-Alkoxycarbonyl, $C_1$- bis $C_6$-Alkylthio, $C_1$- bis $C_6$-Acylamino, $C_6$- bis $C_{10}$-Aryl, $C_6$- bis $C_{10}$-Aryloxy, $C_6$- bis $C_{10}$-Arylcarbonylamino, Mono- oder Di-$C_1$- bis $C_6$-Alkylamino, N-$C_1$- bis $C_6$-Alkyl-N-$C_6$- bis $C_{10}$-Arylamino, Pyrrolidino, Morpholino, Piperidino oder Piperazino substituiert sein können.

Unter 3-H-Indol-2-yl sind insbesondere die 3,3-Dialkylderivate zu verstehen, beispielsweise solche der Formeln

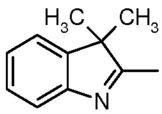 , 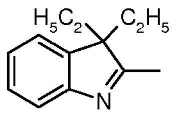 , 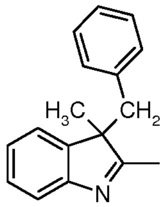 , 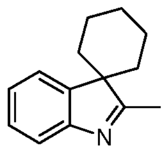 .

Beispiele für die Ringe A und C der Formeln

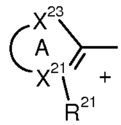 bzw. 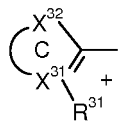

sind: Pyrylium-2- oder -4-yl, Thiopyrylium-2- oder -4-yl, die durch $C_1$- bis $C_6$-Alkyl oder $C_6$-bis $C_{10}$-Aryl substituiert sein können.

Beispiele für die Ringe B, D, E, G und H der Formeln

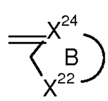 , 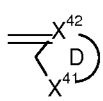 , 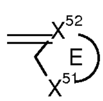 , 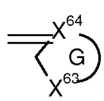 bzw. 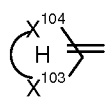

sind: Pyridin-2- oder -4-ylen, Chinolin-2- oder -4-ylen, Pyrimidin-2- oder -4-ylen, Pyrimid-2-on-4-ylen, Pyrazin-2-ylen, 1,3-Thiazol-2-ylen, 1,3-Thiazolin-2-ylen, Benzothiazol-2-ylen, 1,3-Oxazol-2-ylen, 1,3-Oxazolin-2-ylen, Benzoxazol-2-ylen, Imidazol-2-ylen, Imidazolin-2-ylen, Benzimidazol-2-ylen, Pyrrolin-2-ylen, Pyrrol-2-ylen, 3-H-Indol-2-ylen, 3-H-Benzindol-2-ylen, Benz[c,d]indol-2-ylen, 1,3,4-Thiadiazol-2-ylen, 1,2,4-Thiadiazol-3-ylen, Benz-1,4-thiazin-3-ylen, Chinoxalin-2-ylen oder Chinoxalin-3-on-2-ylen, die durch $C_1$- bis $C_6$-Alkyl, $C_1$- bis $C_6$-Alkoxy, Fluor, Chlor, Brom, Iod, Cyano, Nitro, $C_1$- bis $C_6$-Alkoxycarbonyl, $C_1$-bis $C_6$-Alkylthio, $C_1$- bis $C_6$-Acylamino, $C_6$- bis $C_{10}$-Aryl, $C_6$- bis $C_{10}$-Aryloxy, $C_6$-bis $C_{10}$-Arylcarbonylamino, Mono- oder Di-$C_1$- bis $C_6$-Alkylamino, N-$C_1$- bis $C_6$-Alkyl-N-$C_6$- bis $C_{10}$-Arylamino, Pyrrolidino, Morpholino, Piperidino oder Piperazino substituiert sein können.

Unter 3-H-Indol-2-ylen sind insbesondere die 3,3-Dialkylderivate zu verstehen, beispielsweise solche der Formeln

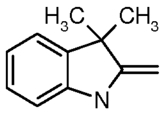 , 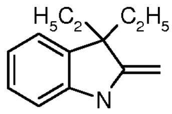 , 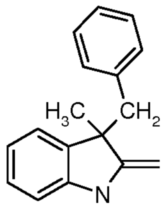 , 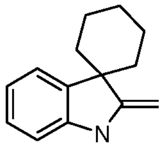 .

Beispiele für die Ringe B, D, E, G und H der Formeln

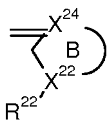 , 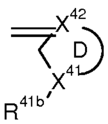 , 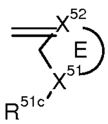 , 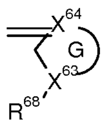 bzw. 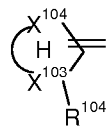

sind: 2H-Pyran-2-ylen, 4H-Pyran-4-ylen, 2H-Thiopyran-2-ylen, 4H-Thiopyran-4-ylen, die durch $C_1$- bis $C_6$-Alkyl oder $C_6$- bis $C_{10}$-Aryl substituiert sein können.

Es können auch zwei oder mehrere, bevorzugt zwei der Farbstoffe der Formeln (I) bis (X) über eine Brücke verbunden sein. Vorzugsweise sind zwei gleiche Farbstoffe mit einander verbunden. Eine solche Brücke kann beispielsweise eine der Formeln

$$-CH_2-[CH_2]_k-CH_2-$$

oder

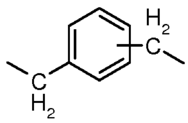

besitzen, worin

k für eine ganze Zahl von 0 bis 4 steht und

die beiden Methylengruppen am Benzolring in o-, m- oder p-Stellung zu einander stehen.

Ganz besonders bevorzugt sind kationische Farbstoffe der Formel (I)

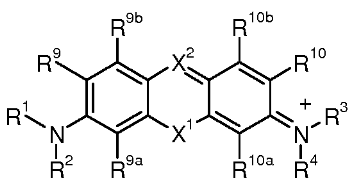 (I),

worin

| | |
|---|---|
| $X^1$ | für O, S oder $CR^{6a}R^{6b}$ steht, |
| $X^2$ | für C-$R^5$ steht, |

| | |
|---|---|
| $R^5$ | für Wasserstoff, Cyano, Methyl, Ethyl, Cyclohexyl, Phenyl, 2-Methoxycarbonylphenyl, 2-Ethoxycarbonylphenyl oder 4-($R^7R^8N$)-phenyl steht, |
| $R^{6a}$ und $R^{6b}$ | für Methyl stehen, |
| $R^1$ bis $R^4$, $R^7$ und $R^8$ | unabhängig von einander für Wasserstoff, Methyl, Ethyl, Propyl, Butyl, Chlorethyl, Cyanmethyl, Cyanethyl, Methoxyethyl, Cyclopentyl, Cyclohexyl, Cyclohexylmethyl, Benzyl, Phenyl, Tolyl, Anisyl oder Chlorophenyl stehen oder, |
| $NR^1R^2$, $NR^3R^4$ und $NR^7R^8$ | unabhängig voneinander für Pyrrolidino, Piperidino, Morpholino oder N-Methylpiperazino stehen, |
| $R^9$, $R^{9a}$, $R^{9b}$, $R^{10}$, $R^{10a}$ und $R^{10b}$ | für Wasserstoff stehen oder jeweils einer der Reste $R^9$, $R^{9a}$, $R^{9b}$ und/oder einer der Reste $R^{10}$, $R^{10a}$ und $R^{10b}$ für Methyl steht oder |
| $R^1$; $R^9$, $R^2$; $R^{9a}$, $R^3$; $R^{10}$ und $R^4$; $R^{10a}$ | unabhängig von einander eine $-CH_2CH_2-$, $-CH_2CH_2CH_2-$ oder $-CH_2CH_2-O-$ Brücke bilden, die bis zu drei Methylgruppen tragen kann. |

Herausragend bevorzugt sind kationische Farbstoffe der Formel (I), worin

| | |
|---|---|
| $X^1$ | für O, S oder $CR^{6a}R^{6b}$ steht, |
| $X^2$ | für C-$R^5$ steht, |
| $R^5$ | für Wasserstoff, Cyano, Phenyl, 2-Methoxycarbonylphenyl, 2-Ethoxycarbonylphenyl oder 4-($R^7R^8N$)-phenyl steht, |
| $R^{6a}$ und $R^{6b}$ | für Methyl stehen, |
| $R^1$ bis $R^4$, $R^7$ und $R^8$ | unabhängig von einander für Methyl, Ethyl, Cyanethyl, Benzyl oder Phenyl stehen und |
| $R^1$, $R^3$ und $R^7$ | zusätzlich für Wasserstoff stehen können oder |
| $NR^1R^2$, $NR^3R^4$ | und $NR^7R^8$ unabhängig voneinander für Pyrrolidino, Piperidino oder Morpholino stehen, |
| $R^9$, $R^{9a}$, $R^{9b}$, $R^{10}$, $R^{10a}$ und $R^{10b}$ | für Wasserstoff stehen oder jeweils einer der Reste $R^9$, $R^{9a}$, $R^{9b}$ und/oder einer der Reste $R^{10}$, $R^{10a}$ und $R^{10b}$ für Methyl steht. |

Ebenfalls ganz besonders bevorzugt sind kationische Farbstoffe der Formel (I)

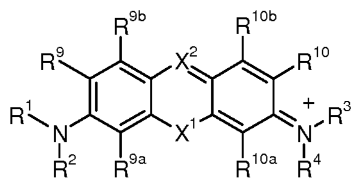

(I),

worin

| | |
|---|---|
| $X^1$ | für O, S oder N-$R^6$ steht, |
| $X^2$ | für N steht, |
| $R^6$ | für Wasserstoff, Methyl, Ethyl, Propyl, Butyl, Cyclohexyl, Benzyl, Phenyl, Tolyl, |

| | |
|---|---|
| | Anisyl oder Chlorophenyl steht, |
| $R^1$ bis $R^4$ | unabhängig von einander für Wasserstoff, Methyl, Ethyl, Propyl, Butyl, Chlorethyl, Cyanmethyl, Cyanethyl, Methoxyethyl, Cyclopentyl, Cyclohexyl, Cyclohexylmethyl, Benzyl, Phenyl, Tolyl, Anisyl oder Chlorophenyl stehen oder |
| $NR^1R^2$ und $NR^3R^4$ | unabhängig voneinander für Pyrrolidino, Piperidino, Morpholino oder N-Methylpiperazino stehen, |
| $R^9$, $R^{9a}$, $R^{9b}$, $R^{10}$, $R^{10a}$ und $R^{10b}$ | für Wasserstoff stehen oder jeweils einer der Reste $R^9$, $R^{9a}$, $R^{9b}$ und/oder einer der Reste $R^{10}$, $R^{10a}$ und $R^{10b}$ für Methyl steht oder |
| $R^1$; $R^9$, $R^2$; $R^{9a}$, $R^3$; $R^{10}$ und $R^4$; $R^{10a}$ | unabhängig von einander eine $-CH_2CH_2-$, $-CH_2CH_2CH_2-$ oder $-CH_2CH_2-O-$Brücke bilden, die bis zu drei Methylgruppen tragen kann. |

Herausragend bevorzugt sind kationische Farbstoffe der Formel (I), worin

| | |
|---|---|
| $X^1$ | für O, S oder $N-R^6$ steht, |
| $X^2$ | für N steht, |
| $R^6$ | für Phenyl steht, |
| $R^1$ bis $R^4$ | unabhängig von einander für Wasserstoff, Methyl, Ethyl, Cyanethyl oder Phenyl stehen, |
| $R^9$, $R^{9a}$, $R^{9b}$, $R^{10}$, $R^{10a}$ und $R^{10b}$ | für Wasserstoff stehen oder jeweils einer der Reste $R^9$, $R^{9a}$, $R^{9b}$ und/oder einer der Reste $R^{10}$, $R^{10a}$ und $R^{10b}$ für Methyl steht. |

Ebenfalls herausragend bevorzugt sind kationische Farbstoffe der Formel (I), worin

| | |
|---|---|
| $X^1$ | für O steht, |
| $X^2$ | für N steht, |
| $NR^1R^2$ | für Dimethylamino oder Diethylamino steht, |
| $NR^3R^4$ | für Dimethylamino, Diethylamino, N-Methyl-N-(2-cyanethyl)amino, Bis(2-cyanethyl)amino oder Anilino steht, |
| $R^9$ | für Wasserstoff oder Methyl steht und |
| $R^{9a}$, $R^{9b}$ $R^{10}$, $R^{10a}$ und $R^{10b}$ | für Wasserstoff stehen. |

Ebenfalls bevorzugt sind Mischungen von Farbstoffen der Formel (I), worin $X^2$ für N steht.

Besonders bevorzugt sind solche Mischungen von Farbstoffen der Formel (I), worin

| | |
|---|---|
| $X^1$ | für S oder $N-R^6$ steht, |
| $X^2$ | für N steht, |
| $R^6$ | Phenyl oder Tolyl steht, |
| $R^1$ bis $R^4$ | unabhängig von einander für Wasserstoff, Methyl, Ethyl, Cyanethyl oder Phenyl stehen oder |

| | |
|---|---|
| $NR^1R^2$ und $NR^3R^4$ | unabhängig voneinander für Pyrrolidino, Piperidino oder Morpholino oder N-Methylpiperazino stehen und jeweils einer der Reste der Gruppen |
| $R^9$, $R^{9a}$, $R^{9b}$ und $R^{10}$, $R^{10a}$, $R^{10b}$ | für Methyl steht und die beiden anderen für Wasserstoff stehen. |

Ebenfalls besonders bevorzugt sind solche Mischungen von Farbstoffen der Formel (I), worin

| | |
|---|---|
| $X^1$ | für S oder N-$R^6$ steht, |
| $X^2$ | für N steht, |
| $R^6$ | Phenyl oder Tolyl steht, |
| $R^1$ und $R^3$ | unabhängig von einander für Wasserstoff, Methyl, Ethyl, Cyanethyl oder Phenyl stehen, |
| $R^2$ und $R^4$ | unabhängig von einander für Wasserstoff, Methyl oder Ethyl stehen, |
| $R^9$ und $R^{10}$ | für Wasserstoff oder Methyl stehen und unter einander gleich sind und |
| $R^{9a}$, $R^{9b}$, $R^{10a}$ und $R^{10b}$ | für Wasserstoff stehen. |

Beispiele für solche Mischungen sind:

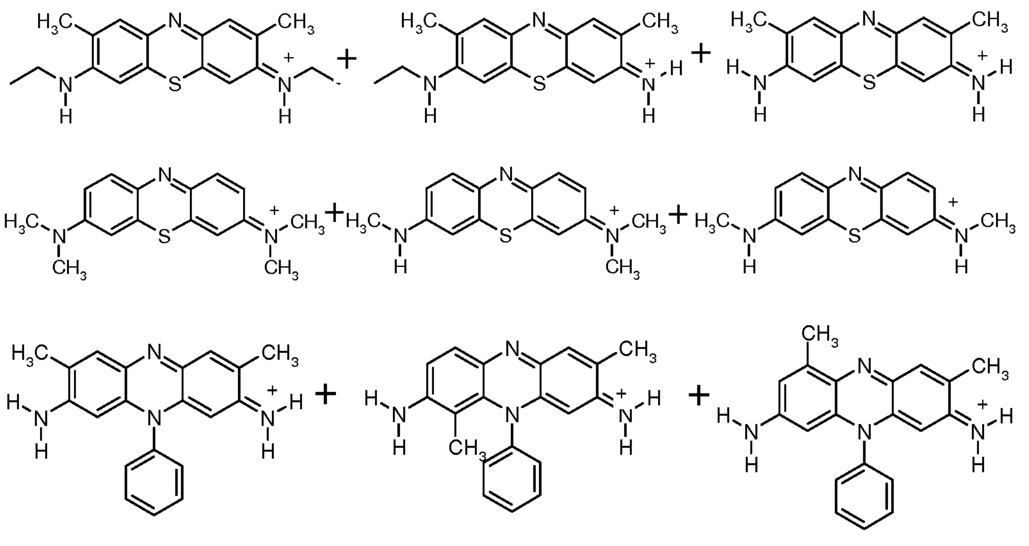

Ebenfalls ganz besonders bevorzugt sind kationische Farbstoffe der Formel (II)

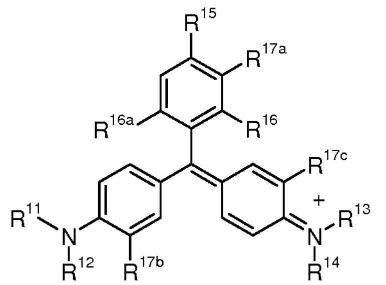

(II),

worin

| | |
|---|---|
| $R^{15}$ | für Wasserstoff, Chlor, Methyl, Methoxy, $NR^{18}R^{19}$ oder $N^+ R^{18}R^{19}N^{20}$ $An^-$ steht, |
| $R^{11}$ bis $R^{14}$, $R^{18}$, $R^{19}$ und $R^{20}$ | unabhängig von einander für Wasserstoff, Methyl, Ethyl, Propyl, Butyl, Chlorethyl, Cyanmethyl, Cyanethyl, Methoxyethyl, Cyclopentyl, Cyclohexyl, Cyclohexylmethyl, Benzyl, Phenyl, Tolyl, Anisyl oder Chlorophenyl stehen oder |
| $NR^{11}R^{12}$, $NR^{13}R^{14}$ und $NR^{18}R^{19}$ | unabhängig von einander für Pyrrolidino, Piperidino, Morpholino oder N-Methyl- |

piperazino stehen, oder

$R^{12}$; $R^{17b}$, $R^{13}$; $R^{17c}$ und $R^{18}$; $R^{17a}$ unabhängig von einander eine eine $-CH_2CH_2-$, $-CH_2CH_2CH_2-$ oder $-CH_2CH_2-O-$Brücke bilden, die bis zu drei Methylgruppen tragen kann,

$An^-$ für ein Anion,

$R^{16}$ für Wasserstoff, Chlor, Methoxycarbonyl oder Ethoxycarbonyl steht,

$R^{16a}$ für Wasserstoff oder Chlor steht und

$R^{17a}$, $R^{17b}$ und $R^{17c}$ unabhängig von einander für Wasserstoff oder Methyl stehen.

Herausragend bevorzugt sind kationische Farbstoffe der Formel (II), worin

$R^{15}$ für Wasserstoff oder $NR^{18}R^{19}$ steht,

$NR^{11}R^{12}$, $NR^{13}R^{14}$ und $NR^{18}R^{19}$ unabhängig von einander für Amino, Methylamino, Ethylamino, Cyanethylamino, Dimethylamino, Diethylamino, Bis(2-cyanethyl)amino oder Anilino stehen,

$R^{16}$ und $R^{16a}$ für Wasserstoff stehen oder

$R^{16}$ zusätzlich für Chlor stehen kann, wenn $R^{15}$ für Wasserstoff steht,

$R^{17a}$, $R^{17b}$ und $R^{17c}$ für Wasserstoff stehen oder

$R^{17a}$, $R^{17b}$ und $R^{17c}$ unabhängig von einander zusätzlich für Methyl stehen können, wenn die jeweils benachbarte Gruppe $NR^{11}R^{12}$, $NR^{13}R^{14}$ bzw. $NR^{18}R^{19}$ für Amino, Methylamino, Ethylamino oder Cyanethylamino steht.

Ebenfalls ganz besonders bevorzugt sind kationische Farbstoffe der Formel (III)

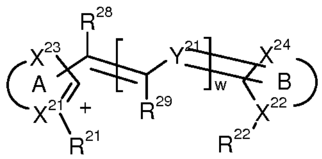

(III),

worin

A zusammen mit $X^{21}$ und $X^{23}$ und den sie verbindenden Atomen für 2- oder 4-Chinolyl, 1,3-Thiazol-2-yl, 1,3-Thiazolin-2-yl, Benzothiazol-2-yl, 1,3-Oxazolin-2-yl, Benzoxazol-2-yl, Imidazol-2-yl, Imidazolin-2-yl, Benzimidazol-2-yl, Pyrrolin-2-yl, 3H-Indol-2-yl oder Chinoxalin-2-yl steht, die durch Methyl, Ethyl, Benzyl, Methoxy, Chlor, Cyano, Nitro oder Methoxycarbonyl substituiert sein können, wobei im Falle von Imidazol-2-yl, Imidazolin-2-yl und Benzimidazol-2-yl beide N-Atome durch $R^{21}$ substituiert sind, oder

A zusammen mit $X^{21}$-$R^{21}$ und $X^{23}$ und den sie verbindenden Atomen für Pyrylium-2- oder -4-yl, Thiopyrylium-2- oder -4-yl, die durch 2 Reste der Gruppe Phenyl, Tolyl oder Anisyl substituiert sind, steht,

B zusammen mit $X^{22}$ und $X^{24}$ und den sie verbindenden Atomen für Pyridin-2-oder -4-ylen, Chinolin-2- oder -4-ylen, 1,3-Thiazol-2-ylen, 1,3-Thiazolin-2-ylen, Benzothiazol-2-ylen, 1,3-Oxazolin-2-ylen, Benzoxazol-2-ylen, Imidazol-2-ylen, Imidazolin-2-ylen, Benzimidazol-2-ylen, Pyrrolin-2-ylen, 3-H-Indol-2-ylen, 1,3,4-Thiadiazol-2-ylen, 1,2,4-Thiadiazol-3-ylen oder Chinoxalin-2-ylen steht, die durch Methyl, Ethyl, Benzyl, Methoxy, Chlor, Cyano, Nitro, Methoxycarbonyl, Dimethylamino, Diethylamino, Dipropylamino, Dibutylamino, Pyrrolidino, Morpholino oder Piperidino substituiert sein können, wobei im Falle von Imidazol-2-ylen, Imidazolin-2-ylen und Benzimidazol-2-ylen beide N-Atome durch $R^{22}$ substituiert sind,

$Y^{21}$ für N oder C-$R^{27}$ steht,

w für 0 oder 1 steht,

$R^{21}$ und $R^{22}$ unabhängig voneinander für Methyl, Ethyl, Propyl, Butyl, Benzyl oder Phenethyl stehen,

$R^{27}$ und $R^{28}$ unabhängig von einander für Wasserstoff oder Cyano stehen und

$R^{29}$ für Wasserstoff steht.

Herausragend bevorzugt sind kationische Farbstoffe der Formel (III), worin

A zusammen mit $X^{21}$ und $X^{23}$ und den sie verbindenden Atomen für 2- oder 4-Chinolyl, 1,3-Thiazol-2-yl, 1,3-Thiazolin-2-yl, Benzothiazol-2-yl, Imidazol-2-yl, Imidazolin-2-yl, Benzimidazol-2-yl, Pyrrolin-2-yl oder 3H-Indol-2-yl steht, die durch Methyl, Methoxy, Chlor, Nitro oder Methoxycarbonyl substituiert sein können, wobei im Falle von Imidazol-2-yl, Imidazolin-2-yl und Benzimidazol-2-yl beide N-Atome durch $R^{21}$ substituiert sind,

B zusammen mit $X^{22}$ und $X^{24}$ und den sie verbindenden Atomen für Chinolin-2- oder -4-ylen, 1,3-Thiazol-2-ylen, 1,3-Thiazolin-2-ylen, Benzothiazol-2-ylen, Imidazol-2-ylen, Imidazolin-2-ylen, Benzimidazol-2-ylen, Pyrrolin-2-ylen oder 3-H-Indol-2-ylen steht, die durch Methyl, Methoxy, Chlor, Nitro oder Methoxycarbonyl substituiert sein können, wobei im Falle von Imidazol-2-ylen, Imidazolin-2-ylen und Benzimidazol-2-ylen beide N-Atome durch $R^{22}$ substituiert sind,

$Y^{21}$ für C-$R^{27}$ steht,

w für 0 oder 1 steht, vorzugsweise für 1 steht,

$R^{21}$ und $R^{22}$ unabhängig voneinander für Methyl, Ethyl oder Benzyl stehen,

$R^{27}$ für Wasserstoff oder Cyano steht und

$R^{28}$ und $R^{29}$ für Wasserstoff stehen.

Ebenfalls herausragend bevorzugt sind kationische Farbstoffe der Formel (III), worin

A zusammen mit $X^{21}$ und $X^{23}$ und den sie verbindenden Atomen für 2- oder 4-Chinolyl, 1,3-Thiazol-2-yl, 1,3-Thiazolin-2-yl, Benzothiazol-2-yl, Imidazol-2-yl, Imidazolin-2-yl, Benzimidazol-2-yl, Pyrrolin-2-yl oder 3H-Indol-2-yl steht, die durch Methyl, Methoxy, Chlor, Nitro oder Methoxycarbonyl substituiert sein können, wobei im Falle von Imidazol-2-yl, Imidazolin-2-yl und Benzimidazol-2-yl beide N-Atome durch $R^{21}$ substituiert sind,

B zusammen mit $X^{22}$ und $X^{24}$ und den sie verbindenden Atomen für 1,3-Thiazol-2-ylen, Benzothiazol-2-ylen, Imidazol-2-ylen, Benzimidazol-2-ylen, die durch Methyl, Ethyl, Methoxy, Chlor, Cyano, Phenyl, Methoxycarbonyl substituiert sein können, 1,3,4-Thiadiazol-2-ylen, das durch Methyl, Methoxy, Methylthio, Brom, Dimethylamino, Diethylamino, Dipropylamino, N-Methyl-N-(2-cyanethyl)amino, N-Methylanilino, Pyrrolidino, Morpholino oder Piperidino substituiert sein kann, oder 1,2,4-Thiadiazol-3-ylen steht, das durch Methyl, Ethyl, Methylthio oder Phenyl substituiert sein kann, wobei im Falle von Imidazol-2-ylen, und Benzimidazol-2-ylen beide N-Atome durch $R^{22}$ substituiert sind,

$Y^{21}$ für N steht,

w für 1 steht,

$R^{21}$ und $R^{22}$ unabhängig voneinander für Methyl, Ethyl oder Benzyl stehen und

$R^{28}$ und $R^{29}$ für Wasserstoff stehen.

Ebenfalls ganz besonders bevorzugt sind kationische Farbstoffe der Formel (IV)

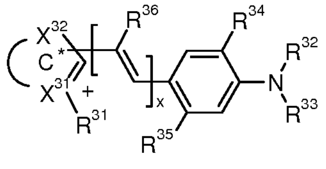

(IV),

worin

C zusammen mit $X^{31}$ und $X^{32}$ und den sie verbindenden Atomen für 2- oder 4-Pyridyl, 2- oder 4-Chinolyl, 1,3-Thiazol-2-yl, 1,3-Thiazolin-2-yl, Benzothiazol-2-yl, 1,3-Oxazolin-2-yl, Benzoxazol-2-yl, Imidazol-2-yl, Imidazolin-2-yl, Benzimidazol-2-yl, Pyrrolin-2-yl, 3H-Indol-2-yl oder Chinoxalin-2-yl steht, die durch Methyl, Ethyl, Benzyl, Methoxy, Chlor, Cyano, Nitro oder Methoxycarbonyl substituiert sein können, wobei im Falle von Imidazol-2-yl, Imidazolin-2-yl und Benzimidazol-2-yl beide N-Atome durch $R^{31}$ substituiert sind, oder

C zusammen mit $X^{31}$-$R^{31}$ und $X^{32}$ und den sie verbindenden Atomen für Pyrylium-2- oder -4-yl, Thiopyrylium-2- oder -4-yl, die durch 2 Reste der Gruppe Phenyl, Tolyl oder Anisyl substituiert sind, steht,

$R^{31}$ für Methyl, Ethyl, Propyl, Butyl, Benzyl oder Phenethyl steht,

$R^{32}$ und $R^{33}$ unabhängig voneinander für Methyl, Ethyl, Propyl, Butyl, Chlorethyl, Cyanmethyl, Cyanethyl, Methoxyethyl, Cyclopentyl, Cyclohexyl, Cyclohexylmethyl, Benzyl, Phenyl, Tolyl, Anisyl, 4-Ethoxyphenyl oder Chlorophenyl stehen und

$R^{32}$ zusätzlich für Wasserstoff stehen kann oder

$NR^{32}R^{33}$ für Pyrrolidino, Piperidino, Morpholino oder N-Methylpiperazino steht,

$R^{34}$ für Wasserstoff, Chlor, Methyl oder Methoxy steht oder

$R^{34}$ mit $R^{32}$ eine $-CH_2CH_2-$, $-CH_2CH_2CH_2-$ oder $-CH_2CH_2-O-$Brücke bilden, in der bis zu drei Wasserstoffatome durch Methylgruppen ersetzt sein können,

$R^{35}$ für Wasserstoff, Chlor, Methyl, Methoxy, Acetamino, Propionylamino, oder Methansulfonylamino steht,

$R^{36}$ für Wasserstoff oder Cyano, steht,

x für 1 steht und

x zusätzlich für 0 stehen kann, wenn C für 1,3-Thiazol-2-yl, 1,3-Thiazolin-2-yl, Benzothiazol-2-yl, 1,3-Oxazolin-2-yl, Benzoxazol-2-yl, Imidazol-2-yl, Imidazolin-2-yl oder Benzimidazol-2-yl steht.

Herausragend bevorzugt sind kationische Farbstoffe der Formel (IV),
worin

C zusammen mit $X^{31}$ und $X^{32}$ und den sie verbindenden Atomen für für 2-oder 4-Chinolyl, 1,3-Thiazol-2-yl, 1,3-Thiazolin-2-yl, Benzothiazol-2-yl, Imidazol-2-yl, Imidazolin-2-yl, Benzimidazol-2-yl, Pyrrolin-2-yl oder 3H-Indol-2-yl steht, die durch Methyl, Methoxy, Chlor, Nitro oder Methoxy-carbonyl substituiert sein können, wobei im Falle von Imidazol-2-yl, Imidazolin-2-yl und Benzimidazol-2-yl beide N-Atome durch $R^{21}$ substituiert sind, oder

C zusammen mit $X^{31}$-$R^{31}$ und $X^{32}$ und den sie verbindenden Atomen für Pyrylium-2-yl, Thiopyrylium-yl, die durch 2 Phenyl-Reste substituiert sind, steht,

$R^{31}$ für Methyl, Ethyl oder Benzyl steht,

$R^{32}$ und $R^{33}$ unabhängig voneinander für Methyl, Ethyl, Chlorethyl, Cyanmethyl, Cyanethyl, Benzyl, Phenyl, Anisyl oder 4-Ethoxyphenyl stehen oder

$NR^{32}R^{33}$ für Pyrrolidino, Piperidino, oder Morpholino steht,

$R^{34}$ für Wasserstoff steht,

$R^{35}$ für Wasserstoff oder Methyl steht,

| | |
|---|---|
| $R^{36}$ | für Wasserstoff oder Cyano, steht und |
| x | für 1 steht. |

Ebenfalls ganz besonders bevorzugt sind kationische Farbstoffe der Formel (V)

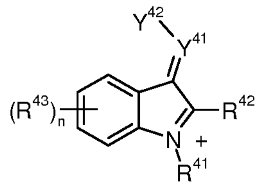

(V),

worin

$Y^{42}$ für einen Rest der Formeln (Va) oder (Vb)

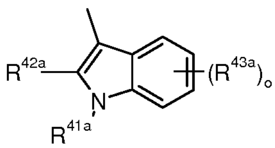

(Va),

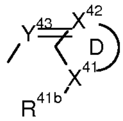

(Vb)

steht,

| | |
|---|---|
| $R^{41}$ , $R^{41a}$ und $R^{41b}$ | unabhängig von einander für Methyl, Ethyl, Propyl, Butyl, Benzyl oder Phenethyl stehen und $R^{41}$ und $R^{41a}$ zusätzlich für Wasserstoff stehen dürfen, |
| $R^{42}$ und $R^{42a}$ | unabhängig von einander für Wasserstoff, Methyl, Ethyl, Cyclohexyl, Phenyl, Tolyl, Anisyl oder Chlorphenyl stehen, |
| $R^{43}$ und $R^{43a}$ | unabhängig von einander für Wasserstoff, Methyl, Methoxy oder Chlor, steht oder zwei benachbarte $R^{43}$ oder $R^{43a}$ für -CH=CH-CH=CH- stehen, |
| n und o | unabhängig von einander für eine ganze Zahl von 0 bis 2 stehen, |
| $Y^{41}$ | für $CR^{44}$ oder $=CR^{45a}-CR^{46}=CR^{45b}-$ steht, wenn $Y^{42}$ für einen Rest der Formel (Va) steht, oder |
| $Y^{41}$ | für $CR^{44}$ steht, wenn $Y^{42}$ für einen Rest der Formel (Vb) steht, |
| $Y^{43}$ | für CH steht oder |
| $Y^{41}$ und $Y^{43}$ | beide für N stehen, |
| $R^{44}$, $R^{45a}$, $R^{45b}$ und $R^{46}$ | für Wasserstoff stehen und |
| D | zusammen mit $X^{41}$ und $X^{42}$ und den sie verbindenden Atomen für Pyridin-2-oder -4-ylen, Chinolin-2- oder -4-ylen, 1,3-Thiazol-2-ylen, 1,3-Thiazolin-2-ylen, Benzothiazol-2-ylen, 1,3,4-Thiadizol-2ylen, 1,3-Oxazolin-2-ylen, Benzoxazol-2-ylen, Imidazol-2-ylen, Imidazolin- |

2-ylen, Benzimidazol-2-ylen, Pyrrolin-2-ylen, 1,3,4-Triazol-2-ylen, 3-H-Indol-2-ylen oder Chinoxalin-2-ylen steht, die durch Methyl, Ethyl, Benzyl, Methoxy, Chlor, Cyano, Nitro oder Methoxycarbonyl substituiert sein können, wobei im Falle von Imidazol-2-ylen, Imidazolin-2-ylen und Benzimidazol-2-ylen beide N-Atome durch $R^{41b}$ substituiert sind und im Falle 1,3,4-Thiadizol-2-ylen als zusätzliche Substituenten Dimethylamino, Diethylamino, Dipropylamino, Dibutylamino, N-Methyl,N-cyanethylamino, Bis(cyanethyl)amino, N-Methyl-N-phenylamino, Pyrrolidino, Piperidino oder Morpholino in Frage kommen, oder

D zusammen mit zusammen mit $X^{41}$-$R^{41b}$ und $X^{42}$ und den sie verbindenden Atomen für 2H-Pyran-2-ylen, 4H-Pyran-4-ylen, 2H-thiopyran-2-ylen, 4H-Thiopyran-4-ylen steht, die durch 2 Reste der Gruppe Phenyl, Tolyl oder Anisyl substituiert sind.

Herausragend bevorzugt sind kationische Farbstoffe der Formel (V), worin

$Y^{42}$ für einen Rest der Formeln (Va) oder (Vb)

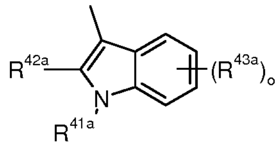

(Va),

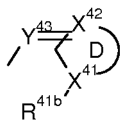

(Vb)

steht,

| | |
|---|---|
| $R^{41}$, $R^{41a}$ und $R^{41b}$ | unabhängig von einander für Methyl, Ethyl oder Benzyl stehen, |
| $R^{42}$ und $R^{42a}$ | unabhängig von einander für Wasserstoff, Methyl oder Phenyl stehen, |
| $R^{43}$ und $R^{43a}$ | für Wasserstoff stehen, |
| n und o | unabhängig von einander für 1 stehen, |
| $Y^{41}$ | für $CR^{44}$ oder $=CR^{45a}-CR^{46}=CR^{45b}-$ steht, wenn $Y^{42}$ für einen Rest der Formel (Va) steht, oder |
| $Y^{41}$ | für $CR^{44}$ steht, wenn $Y^{42}$ für einen Rest der Formel (Vb) steht, |
| $Y^{43}$ | für CH steht, |
| $R^{44}$, $R^{45a}$, $R^{45b}$ | und $R^{46}$ für Wasserstoff stehen und |
| D | zusammen mit $X^{41}$ und $X^{42}$ und den sie verbindenden Atomen für Chinolin-2- oder -4-ylen, 1,3-Thiazol-2-ylen, Benzothiazol-2-ylen, Imidazol-2-ylen, Imidazolin-2-ylen, Benzimidazol-2-ylen, Pyrrolin-2-ylen oder 3-H-Indol-2-ylen steht, die durch Methyl, Methoxy, Chlor, Cyano, Nitro oder Methoxy-carbonyl substituiert sein können, wobei im Falle von Imidazol-2-ylen, Imidazolin-2-ylen und Benzimidazol-2-ylen beide N-Atome durch $R^{41b}$ substituiert sind, oder |
| D | zusammen mit zusammen mit $X^{41}$-$R^{41b}$ und $X^{42}$ und den sie verbindenden Atomen für 2H-Pyran-2-ylen, 4H-Pyran-4-ylen, 2H-thiopyran-2-ylen, 4H-Thiopyran-4-ylen steht, die durch 2 Phenyl-Reste substituiert sind. |

Ebenfalls herausragend bevorzugt sind kationische Farbstoffen der Formel (V), worin die Paare $R^{41}$ und $R^{41a}$, $R^{42}$ und $R^{42a}$, $R^{43}$ und $R^{43a}$ sowie n und o jeweils die gleiche Bedeutung haben.

Ebenfalls ganz besonders bevorzugt sind kationische Farbstoffe der Formel (VI)

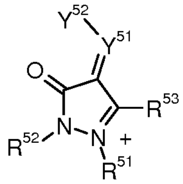

(VI),

worin

$Y^{52}$ für einen Rest der Formeln (VIa), (VIb) oder (VIc)

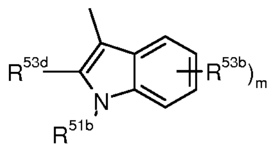

(VIa),

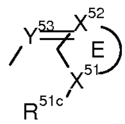

(VIb),

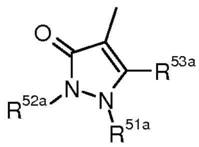

(VIc)

steht,

| | |
|---|---|
| $R^{51}$, $R^{51a}$, $R^{51b}$ und $R^{51c}$ | unabhängig von einander für Methyl, Ethyl, Propyl, Butyl, Benzyl oder Phenethyl stehen, |
| $R^{52}$ und $R^{52a}$ | unabhängig von einander für Cyclohexyl, Phenyl, Tolyl, Anisyl oder Chlorphenyl stehen, |
| $R^{53}$ und $R^{53a}$ | unabhängig von einander für Methyl, Cyano, Methoxycarbonyl oder Ethoxycarbonyl stehen, |
| $R^{53d}$ | für Methyl, Ethyl, Cyclohexyl, Phenyl, Tolyl, Anisyl oder Chlorphenyl steht, |
| $R^{53b}$ | für Wasserstoff, Methyl, Methoxy oder Chlor, steht oder zwei benachbarte $R^{53b}$ für -CH=CH-CH=CH- steht, |
| m | für eine ganze Zahl von 0 bis 2 steht, |
| $Y^{51}$ | für $CR^{54}$ oder $=CR^{55a}-CR^{56}=CR^{55b}-$ steht, wenn $Y^{52}$ für einen Rest der Formeln (VIa) oder (VIc) steht, oder |
| $Y^{51}$ | für $CR^{54}$ steht, wenn $Y^{52}$ für einen Rest der Formel (VIb) steht, |
| $Y^{53}$ | für CH steht oder |

$Y^{51}$ und $Y^{53}$ beide für N stehen,

$R^{54}$, $R^{55a}$, $R^{55b}$ und $R^{56}$ für Wasserstoff stehen,

E zusammen mit $X^{51}$ und $X^{52}$ und den sie verbindenden Atomen für Pyridin-2-oder -4-ylen, Chinolin-2- oder -4-ylen, 1,3-Thiazol-2-ylen, 1,3-Thiazolin-2-ylen, Benzothiazol-2-ylen, 1,3,4-Thiadizol-2ylen, 1,3-Oxazolin-2-ylen, Benzoxazol-2-ylen, Imidazol-2-ylen, Imidazolin-2-ylen, Benzimidazol-2-ylen, Pyrrolin-2-ylen, 1,3,4-Triazol-2-ylen, 3-H-Indol-2-ylen oder Chinoxalin-2-ylen steht, die durch Methyl, Ethyl, Benzyl, Methoxy, Chlor, Cyano, Nitro oder Methoxycarbonyl substituiert sein können, wobei im Falle von Imidazol-2-ylen, Imidazolin-2-ylen und Benzimidazol-2-ylen beide N-Atome durch $R^{51c}$ substituiert sind und im Falle 1,3,4-Thiadizol-2ylen als zusätzliche Substituenten Dimethylamino, Diethylamino, Dipropylamino, Dibutylamino, N-Methyl,N-cyanethylamino, Bis(cyanethyl)amino, N-Methyl-N-phenylamino, Pyrrolidino, Piperidino oder Morpholino in Frage kommen, oder

E zusammen mit zusammen mit $X^{51}$-$R^{51c}$ und $X^{52}$ und den sie verbindenden Atomen für 2H-Pyran-2-ylen, 4H-Pyran-4-ylen, 2H-thiopyran-2-ylen, 4H-Thiopyran-4-ylen steht, die durch 2 Reste der Gruppe Phenyl, Tolyl oder Anisyl substituiert sind.

Herausragend bevorzugt sind kationische Farbstoffe der Formel (VI), worin die Paare $R^{51}$ und $R^{51a}$, $R^{52}$ und $R^{52a}$ sowie $R^{53}$ und $R^{53a}$ jeweils die gleiche Bedeutung haben.

Herausragend bevorzugt sind kationische Farbstoffe der Formel (VI), worin

$Y^{52}$ für einen Rest der Formeln (VIa), (VIb) oder (VIc)

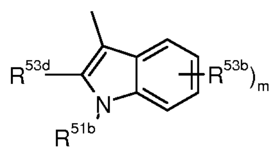

(VIa),

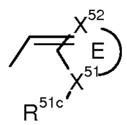

(VIb),

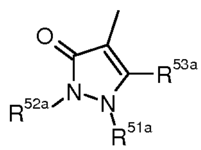

(VIc)

steht,

$R^{51}$, $R^{51a}$, $R^{51b}$ und $R^{51c}$ unabhängig von einander für Methyl, Ethyl oder Benzyl stehen,
$R^{52}$ und $R^{52a}$ unabhängig von einander für Phenyl, Tolyl, Anisyl oder Chlorphenyl stehen,
$R^{53}$ und $R^{53a}$ unabhängig von einander für Methyl oder Methoxycarbonyl stehen,
$R^{53d}$ für Methyl oder Phenyl steht,
$R^{53b}$ für Wasserstoff steht,
m für 1 steht,
$Y^{51}$ für $CR^{54}$ oder $=CR^{55a}-CR^{56}=CR^{55b}-$ steht, wenn $Y^{52}$ für einen Rest der Formeln (VIa) oder (VIc) steht, oder
$Y^{51}$ für $CR^{54}$ steht, wenn $Y^{52}$ für einen Rest der Formel (VIb) steht,
$Y^{53}$ für CH steht,

$R^{54}$, $R^{55a}$, $R^{55b}$ und $R^{56}$ für Wasserstoff stehen,

E zusammen mit $X^{51}$ und $X^{52}$ und den sie verbindenden Atomen für Chinolin-2- oder -4-ylen, 1,3-Thiazol-2-ylen, Benzothiazol-2-ylen, Imidazol-2-ylen, Imidazolin-2-ylen, Benzimidazol-2-ylen, Pyrrolin-2-ylen oder 3-H-Indol-2-ylen steht, die durch Methyl, Methoxy, Chlor, Cyano, Nitro oder Methoxy-carbonyl substituiert sein können, wobei im Falle von Imidazol-2-ylen, Imidazolin-2-ylen und Benzimidazol-2-ylen beide N-Atome durch $R^{41b}$ substituiert sind, oder

E zusammen mit zusammen mit $X^{51}$-$R^{51c}$ und $X^{52}$ und den sie verbindenden Atomen für 2H-Pyran-2-ylen, 4H-Pyran-4-ylen, 2H-thiopyran-2-ylen, 4H-Thiopyran-4-ylen steht, die durch 2 Phenyl-Reste substituiert sind.

Ebenfalls ganz besonders bevorzugt sind kationische Farbstoffe der Formel (VII)

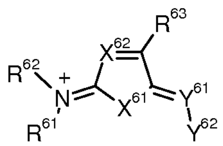

(VII),

worin

$Y^{62}$ für einen Rest der Formeln

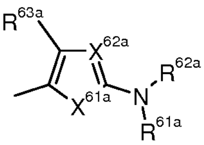

(VIIa),

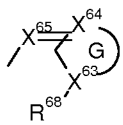

(VIIb) oder

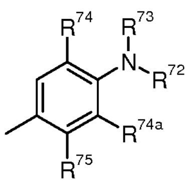

(VIIc) steht,

$X^{61}$ und $X^{61a}$ unabhängig von einander für O oder S stehen,

$X^{62}$ und $X^{62a}$ unabhängig von einander für $CR^{66}$ oder N stehen,

$R^{63}$ und $R^{63a}$ unabhängig von einander für Wasserstoff, Methyl, 2-Propyl, tert.-Butyl, Chlor, Phenyl, Tolyl, Anisyl, Chlorphenyl oder $NR^{64}R^{65}$ stehen,

$R^{61}$, $R^{61a}$, $R^{62}$, $R^{62a}$, $R^{64}$ und $R^{65}$ unabhängig voneinander Methyl, Ethyl, Propyl, Butyl, Chlorethyl, Cyanmethyl, Cyanethyl, Methoxyethyl, Cyclopentyl, Cyclohexyl, Cyclohexylmethyl, Benzyl, Phenyl, Tolyl, Anisyl oder Chlorophenyl stehen oder

$NR^{61}R^{62}$ und $NR^{64}R^{65}$ unabhängig voneinander für Pyrrolidino, Piperidino, Morpholino oder N-Methylpiperazino stehen,

$Y^{61}$ für $=CR^{67}$- oder N steht,

$R^{67}$ für Wasserstoff oder einen Rest der Formel (VIIa) steht,

G zusammen mit $X^{63}$ und $X^{64}$ und den sie verbindenden Atomen für Pyridin-2-oder -4-ylen, Chinolin-2- oder -4-ylen, 1,3-Thiazol-2-ylen, 1,3-Thiazolin-2-ylen, Benzothiazol-2-ylen, 1,3-Oxazolin-2-ylen, Benzoxazol-2-ylen, Imidazol-2-ylen, Imidazolin-2-ylen, Benzimidazol-2-ylen, Pyrrolin-2-ylen, 3-H-Indol-2-ylen oder Chinoxalin-2-ylen steht, die durch Methyl, Ethyl, Benzyl, Methoxy, Chlor, Cyano, Nitro oder Methoxycarbonyl substituiert sein können, wobei im Falle von Imidazol-2-ylen, Imidazolin-2-ylen und Benzimidazol-2-ylen beide N-Atome durch $R^{68}$ substituiert sind,

$R^{68}$ Methyl, Ethyl, Propyl, Butyl, Benzyl oder Phenethyl steht,

$X^{65}$ für N oder C-$R^{67}$ steht,

$R^{66}$ und $R^{67}$ unabhängig von einander für Wasserstoff oder Cyano steht,

$R^{72}$ und $R^{73}$ unabhängig voneinander für Methyl, Ethyl, Propyl, Butyl, Chlorethyl, Cyanmethyl, Cyanethyl, Methoxyethyl, Cyclopentyl, Cyclohexyl, Cyclohexylmethyl, Benzyl, Phenyl, Tolyl, Anisyl oder Chlorophenyl stehen und

$R^{72}$ zusätzlich für Wasserstoff stehen kann, oder

$NR^{72}R^{73}$ für Pyrrolidino, Piperidino, Morpholino oder N-Methylpiperazino stehen,

$R^{74a}$ für Wasserstoff steht,

$R^{74}$ für Wasserstoff, Methyl, Methoxy oder Chlor steht oder

$R^{74}$; $R^{73}$ eine $-CH_2CH_2-$, $-CH_2CH_2CH_2-$ oder $-CH_2CH_2$-O-Brücke bilden, in der bis zu drei Wasserstoffatome durch Methylgruppen ersetzt sein können,

$R^{75}$ für Wasserstoff, Chlor, Methyl, Methoxy, Acetamino, Propionylamino, oder Methansulfonylamino steht.

Herausragend bevorzugt sind kationische Farbstoffe der Formel (VII), worin

$Y^{62}$ für einen Rest der Formeln

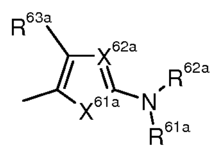

(VIIa),

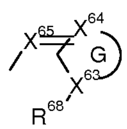

(VIIb) oder

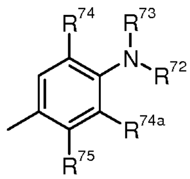

(VIIc) steht,

| | |
|---|---|
| $X^{61}$ und $X^{61a}$ | unabhängig von einander für S stehen, |
| $X^{62}$ und $X^{62a}$ | unabhängig von einander für $CR^{66}$ oder N stehen, |
| $R^{63}$ und $R^{63a}$ | unabhängig von einander für Wasserstoff, Methyl, Phenyl oder $NR^{64}R^{65}$ stehen, |
| $R^{61}$, $R^{61a}$, $R^{62}$, $R^{62a}$, $R^{64}$ und $R^{65}$ | unabhängig voneinander Methyl, Ethyl, Propyl, Butyl, Cyanethyl, Benzyl oder Phenyl stehen oder |
| $NR^{61}R^{62}$ und $NR^{64}R^{65}$ | unabhängig voneinander für Pyrrolidino, Piperidino oder Morpholino stehen, |
| $Y^{61}$ | für $=CR^{67}$- steht, |
| $R^{67}$ | für Wasserstoff oder einen Rest der Formel (VIIa) steht, |
| G | zusammen mit $X^{63}$ und $X^{64}$ und den sie verbindenden Atomen für Chinolin-2- oder -4-ylen, 1,3-Thiazol-2-ylen, Benzothiazol-2-ylen, Imidazol-2-ylen, Imidazolin-2-ylen, Benzimidazol-2-ylen, Pyrrolin-2-ylen oder 3-H-Indol-2-ylen steht, die durch Methyl, Methoxy, Chlor, Cyano, Nitro oder Methoxy-carbonyl substituiert sein können, wobei im Falle von Imidazol-2-ylen, Imidazolin-2-ylen und Benzimidazol-2-ylen beide N-Atome durch $R^{41b}$ substituiert sind, |
| $R^{68}$ | Methyl, Ethyl oder Benzyl steht, |
| $X^{65}$ | für $C-R^{67}$ steht, |
| $R^{66}$ und $R^{67}$ | für Wasserstoff stehen, |
| $R^{72}$ und $R^{73}$ | unabhängig voneinander für Methyl, Ethyl, Chlorethyl, Cyanmethyl, Cyanethyl, Benzyl oder Phenyl stehen oder |
| $NR^{72}R^{73}$ | für Pyrrolidino, Piperidino oder Morpholino stehen, |
| $R^{74}$ und $R^{74a}$ | für Wasserstoff stehen, |
| $R^{75}$ | für Wasserstoff oder Methyl steht. |

Ebenfalls herausragend bevorzugt sind kationische Farbstoffe der Formel (VII), worin $X^{61}$ und $X^{61a}$, $X^{62}$ und $X^{62a}$, $R^{61}$ und $R^{61a}$, $R^{62}$ und $R^{62a}$, $R^{63}$ und $R^{63a}$ jeweils paarweise gleich sind.

Ebenfalls ganz besonders bevorzugt sind kationische Farbstoffe der Formel (VIII)

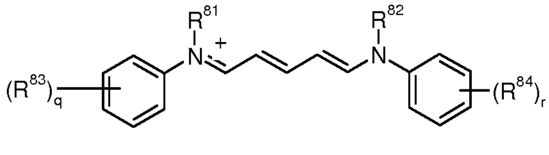

(VIII),

worin

| | |
|---|---|
| $R^{81}$ und $R^{82}$ | unabhängig von einander für Methyl, Ethyl, Propyl, Butyl, Chlorethyl, Cyanmethyl, Cya- |

| | |
|---|---|
| | nethyl, Methoxyethyl, Cyclopentyl, Cyclohexyl, Cyclohexylmethyl, Benzyl, Phenyl, Tolyl, Anisyl oder Chlorophenyl stehen, |
| $R^{83}$ und $R^{84}$ | unabhängig von einander für Wasserstoff, Methyl, Methoxy, Chlor, Cyano, Nitro, Methoxycarbonyl oder Ethoxycarbonyl steht oder zwei benachbarte $R^{83}$ oder $R^{84}$ für -CH=CH-CH=CH- stehen, oder |
| $R^{83}$; $R^{81}$ und/oder $R^{84}$; $R^{82}$ | eine $-CH_2CH_2-$, $-CH_2CH_2CH_2-$ oder $-CH_2CH_2-O-$Brücke bilden, in der bis zu drei Wasserstoffatome durch Methylgruppen ersetzt sein können, |
| q und r | unabhängig von einander für eine ganze Zahl von 0 bis 2 stehen. |

Herausragend bevorzugt sind kationische Farbstoffe der Formel (VIII), worin

| | |
|---|---|
| $R^{81}$ und $R^{82}$ | unabhängig von einander für Methyl oder Ethyl stehen, |
| $R^{83}$ und $R^{84}$ | unabhängig von einander für Wasserstoff, Methyl, Methoxy, Chlor, Cyano, Nitro, Methoxycarbonyl oder Ethoxycarbonyl steht oder zwei benachbarte $R^{83}$ oder $R^{84}$ für -CH=CH-CH=CH- stehen, oder |
| $R^{83}$; $R^{81}$ und/oder $R^{84}$; $R^{82}$ | eine $-CH_2CH_2-$ oder $-CH_2CH_2CH_2-$Brücke bilden und |
| q und r | für 1 stehen. |

Ebenfalls herausragend bevorzugt sind kationische Farbstoffe der Formel (VIII), worin
die Paare $R^{81}$ und $R^{82}$, $R^{83}$ und $R^{84}$ sowie q und r gleich sind.

Ebenfalls ganz besonders bevorzugt sind kationische Farbstoffe der Formel (IX)

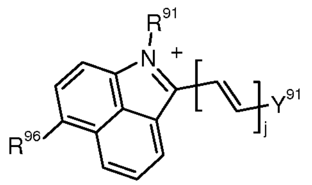

(IX),

worin

$Y^{91}$ für einen Rest der Formeln (IXa) oder (IXb)

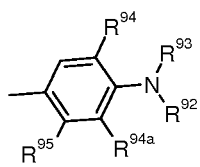

(IXa),

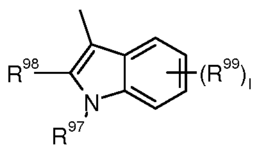

(IXb)

steht,

| | |
|---|---|
| $R^{91}$ | Methyl, Ethyl, Propyl, Butyl, Cyanethyl, Benzyl oder Phenethyl steht, |
| $R^{92}$ und $R^{93}$ | unabhängig voneinander für Methyl, Ethyl, Propyl, Butyl, Chlorethyl, Cyanmethyl, Cyanethyl, Methoxyethyl, Cyclopentyl, Cyclohexyl, Cyclohexylmethyl, Benzyl, Phenyl, Tolyl, Anisyl, 4-Ethoxyphenyl oder Chlorophenyl stehen oder |

$NR^{92}R^{93}$ für Pyrrolidino, Piperidino, Morpholino oder N-Methylpiperazino stehen,

$R^{94a}$ für Wasserstoff steht,

$R^{94}$ für Wasserstoff, Methyl, Methoxy oder Chlor steht oder

$R^{94}$; $R^{93}$ eine $-CH_2CH_2-$ oder $-CH_2CH_2CH_2-$Brücke bilden, in der bis zu drei Wasserstoffatome durch Methylgruppen ersetzt sein können,

$R^{95}$ für Wasserstoff, Chlor, Methyl, Methoxy, Acetamino, Propionylamino, oder Methansulfonylamino steht,

$R^{96}$ für Wasserstoff oder Brom steht,

$R^{97}$ für Methyl, Ethyl, Propyl, Butyl, Benzyl oder Phenethyl steht,

$R^{98}$ für Wasserstoff, Methyl, Ethyl, Cyclohexyl, Phenyl, Tolyl, Anisyl oder Chlorphenyl steht,

$R^{99}$ für Wasserstoff, Methyl, Methoxy oder Chlor, steht oder zwei benachbarte $R^{99}$ für -CH=CH-CH=CH- steht,

l für eine ganze Zahl von 0 bis 2 steht und

j für 0 oder 1 steht.

Herausragend bevorzugt sind kationische Farbstoffen-der Formel (IX), worin

$R^{91}$ Methyl oder Ethyl steht,
$R^{92}$ und $R^{93}$ unabhängig voneinander für Methyl, Ethyl, Chlorethyl, Cyanethyl, Benzyl, Phenyl, Tolyl, Anisyl oder 4-Ethoxyphenyl stehen oder
$NR^{92}R^{93}$ für Pyrrolidino, Piperidino oder Morpholino steht,
$R^{94}$ und $R^{94a}$ für Wasserstoff stehen oder
$R^{94}$; $R^{93}$ eine $-CH_2CH_2-$ oder $-CH_2CH_2CH_2-$Brücke bilden, in der bis zu drei Wasserstoffatome durch Methylgruppen ersetzt sein können,
$R^{95}$ für Wasserstoff oder Methyl steht,
$R^{96}$ für Wasserstoff oder Brom steht,
$R^{97}$ für Methyl, Ethyl oder Benzyl steht,
$R^{98}$ für Wasserstoff, Methyl oder Phenyl steht,
$R^{99}$ für Wasserstoff steht,
l für 1 steht und
j für 0 oder 1 steht.

Ebenfalls ganz besonders bevorzugt sind kationische Farbstoffe der Formel (X)

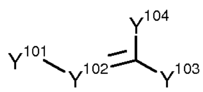

(X),

worin

$Y^{101}$ für einen Rest der Formeln

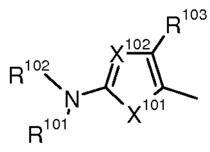

(Xa),

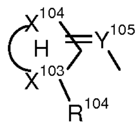

(Xb)

oder

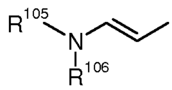

(Xc)

steht,

| | |
|---|---|
| $X^{101}$ | für O oder S steht, |
| $X^{102}$ | für $CR^{107}$ oder N steht, |
| $R^{103}$ | für Wasserstoff, Methyl, 2-Propyl, tert.-Butyl, Chlor, Phenyl, Tolyl, Anisyl, Chlorphenyl oder $NR^{101a}R^{102a}$ steht, |
| $R^{101}$, $R^{102,}$ $R^{101a,}$ $R^{102a}$ $R^{105}$ und $R^{106}$ | unabhängig von einander für Methyl, Ethyl, Propyl, Butyl, Chlorethyl, Cyanmethyl, Cyanethyl, Methoxyethyl, Cyclopentyl, Cyclohexyl, Cyclohexylmethyl, Benzyl, Phenyl, Tolyl, Anisyl oder Chlorophenyl stehen oder |
| $NR^{101}R^{102}$ und/oder $NR^{101a}R^{102a}$ und/oder $NR^{105}R^{106}$ | für Pyrrolidino, Morpholino, Piperazino oder Piperidino stehen, |
| $R^{107}$ | für Wasserstoff oder Cyano steht, |
| H | zusammen mit $X^{103}$ und $X^{104}$ und den sie verbindenden Atomen für Pyridin-2- oder -4-ylen, Chinolin-2- oder -4-ylen, 1,3-Thiazol-2-ylen, 1,3-Thiazolin-2-ylen, Benzothiazol-2-ylen, 1,3-Oxazolin-2-ylen, Benzoxazol-2-ylen, Imidazol-2-ylen, Imidazolin-2-ylen, Benzimidazol-2-ylen, Pyrrolin-2-ylen, 3-H-Indol-2-ylen oder Chinoxalin-2-ylen steht, die durch Methyl, Ethyl, Benzyl, Methoxy, Chlor, Cyano, Nitro oder Methoxycarbonyl substituiert sein können, wobei im Falle von Imidazol-2-ylen, Imidazolin-2-ylen und Benzimidazol-2-ylen beide N-Atome durch $R^{104}$ substituiert sind, |
| $R^{104}$ und $R^{114}$ | unabhängig von einander für Methyl, Ethyl, Propyl, Butyl, Benzyl oder Phenethyl stehen, |
| $Y^{102}$ | für CH steht, |
| $Y^{105}$ | für N oder CH steht, |
| $Y^{103}$ | für CN steht, |

$Y^{104}$ für einen kationischen Rest der Formeln

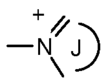

oder

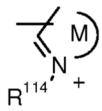

steht oder

$CY^{103}Y^{104}$ zusammen für einen Rest der Formeln

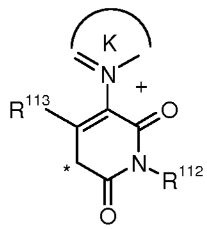

,

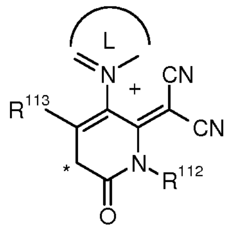

steht, wobei der Stern (*) das Ringatom anzeigt, von dem die Doppelbindung ausgeht,

$R^{112}$ für Wasserstoff, Methyl, Ethyl, Cyanethyl, Benzyl oder Phenyl steht,
$R^{113}$ für Methyl, Cyano, Methoxycarbonyl oder Ethoxycarbonyl steht,
J, K und L für einen Rest der Formeln

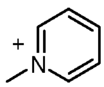 , 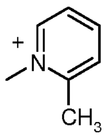 , 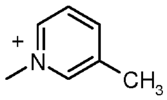 , 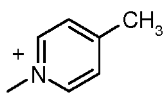 , 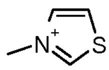 , 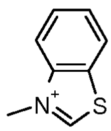

oder

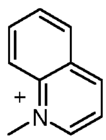

steht und

M für einen Rest der Formeln

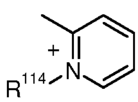 oder 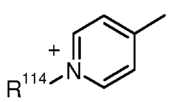

steht.

Herausragend bevorzugt sind kationische Farbstoffe der Formel (X), worin

$Y^{101}$ für einen Rest der Formeln

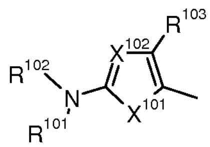

(Xa),

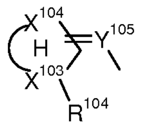

(Xb) oder

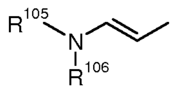

(Xc)

steht,

| | |
|---|---|
| $X^{101}$ | für S steht, |
| $X^{102}$ | für $CR^{107}$ oder N steht, |
| $R^{103}$ | für Wasserstoff, Methyl, Phenyl oder $NR^{101a}R^{102a}$ steht, |
| $R^{101}$, $R^{102}$, $R^{101a}$, $R^{102a}$ $R^{105}$ und $R^{106}$ | unabhängig von einander für Methyl, Ethyl, Cyanethyl, Benzyl oder Phenyl stehen oder |
| $NR^{101}R^{102}$ und/oder $NR^{101a}R^{102a}$ und/oder $NR^{105}R^{106}$ | für Pyrrolidino, Morpholino oder Piperazino stehen, |
| $R^{107}$ | für Wasserstoff oder Cyano steht, |
| H | zusammen mit $X^{103}$ und $X^{104}$ und den sie verbindenden Atomen für Chinolin-2- oder -4-ylen, 1,3-Thiazol-2-ylen, Benzothiazol-2-ylen, Imidazol-2-ylen, Imidazolin-2-ylen, Benzimidazol-2-ylen, Pyrrolin-2-ylen oder 3-H-Indol-2-ylen steht, die durch Methyl, Methoxy, Chlor, Cyano, Nitro oder Methoxycarbonyl substituiert sein können, wobei im Falle von Imidazol-2-ylen, Imidazolin-2-ylen und Benzimidazol-2-ylen beide N-Atome durch $R^{104}$ substituiert sind, |
| $R^{104}$ und $R^{114}$ | unabhängig von einander für Methyl, Ethyl oder Benzyl stehen, |
| $Y^{102}$ | für CH steht, |
| $Y^{105}$ | für CH steht, |
| $Y^{103}$ | für CN steht, |
| $Y^{104}$ | für einen kationischen Rest der Formeln |

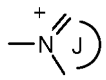

oder

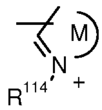

steht oder

CY$^{103}$Y$^{104}$ zusammen für einen Rest der Formeln

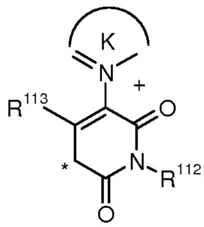

,

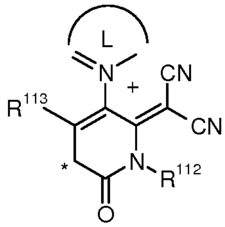

steht, wobei der Stern (*) das Ringatom anzeigt, von dem die Doppelbindung ausgeht,

R$^{112}$ für Methyl, Ethyl, Cyanethyl oder Benzyl steht,

R$^{113}$ für Methyl, Cyano oder Methoxycarbonyl steht,

J, K und L für einen Rest der Formeln

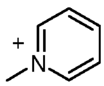

,

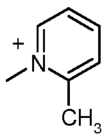

,

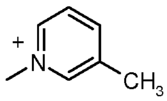

oder

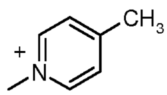

steht und

M für einen Rest der Formeln

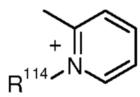

oder

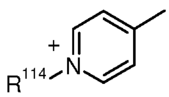

steht.

Ein weiterer Gegenstand der Erfindung sind Farbstoffe der Formel F$^+$ An$^-$, worin

F$^+$ die oben angegebene allgemeine oder bevorzugte Bedeutung besitzt, insbesondere die bei den Formeln (I) bis (X) angegebene allgemeine bis herausragend bevorzugte Bedeutung besitzt,

An$^-$ für ein 4-(sec-Alkyl)benzolsulfonat der Formel (LI)

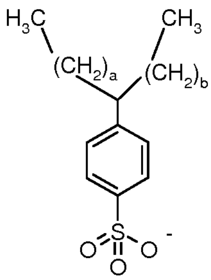

(LI)

steht,

a und b unabhängig von einander für eine ganze Zahl von 0 bis 20 stehen, wobei $a + b \geq 3$ ist.

Bevorzugt ist $a + b \geq 5$, besonders bevorzugt $\geq 7$, ganz besonders bevorzugt $\geq 9$.

Mit der Formel (LI) sind auch Mischungen von Anionen gemeint mit verschiedenen Werten von a und b, bei denen a + b gleich ist. Mit der Formel (LI) sind aber auch Mischungen von Anionen gemeint mit verschiedenen Werten von a und b.

Beispiele für Anionen der Formel (LI) sind:

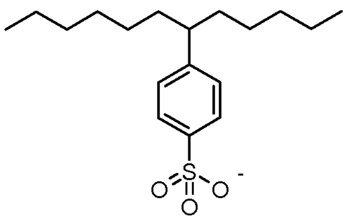

sowie als Mischung aller fünf denkbaren Isomeren.

Ein weiterer Gegenstand der Erfindung sind Farbstoffe der Formel $F^+$ $An^-$, worin

$F^+$ die oben angegebene allgemeine oder bevorzugte Bedeutung besitzt, insbesondere die bei den Formeln (I) bis (X) angegebene allgemeine bis herausragend bevorzugte Bedeutung besitzt,

$An^-$ für ein sec-Alkylsulfonat der Formel (LII)

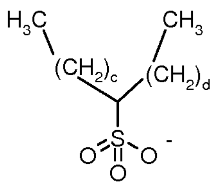

(LII)

steht,

c und d unabhängig von einander für eine ganze Zahl von 0 bis 20 stehen, wobei $c + d \geq 5$ ist.

Bevorzugt ist $c + d \geq 7$, besonders bevorzugt $\geq 9$, ganz besonders bevorzugt $\geq 11$.

Mit der Formel (LII) sind auch Mischungen von Anionen gemeint mit verschiedenen Werten von c und d, bei denen c + d gleich ist. Mit der Formel (LII) sind aber auch Mischungen von Anionen gemeint mit verschiedenen Werten von c und d.

Beispiele für Anionen der Formel (LII) sind:

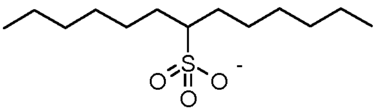 , 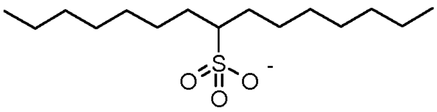 ,

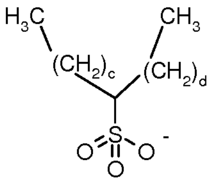 (mit c + d = 8 bis 12), 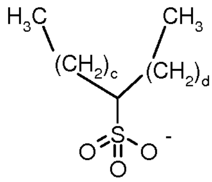 (c + d= 10 bis 14)

sowie als Mischung aller denkbaren Isomeren.

Ein weiterer Gegenstand der Erfindung sind Farbstoffe der Formel $F^+ An^-$, worin

$F^+$ die oben angegebene allgemeine oder bevorzugte Bedeutung besitzt, insbesondere die bei den Formeln (I) bis (X) angegebene allgemeine bis herausragend bevorzugte Bedeutung besitzt,

$An^-$ für ein verzweigtes Alkylsulfat der Formel (LIII)

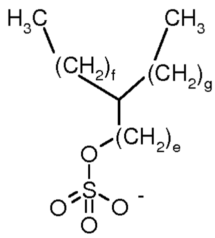

(LIII)

steht,

e für eine ganze Zahl von 0 bis 5 steht,

f und g unabhängig von einander für eine ganze Zahl von 0 bis 15 stehen, wobei e + f + g ≥ 5 ist und die $CH_2$-Gruppen noch durch weitere Methyl- oder Ethylgruppen substituiert sein können.

Bevorzugt ist e + f + g ≥ 7, besonders bevorzugt ≥ 9, ganz besonders bevorzugt ≥ 11.

e steht bevorzugt für 0 oder 1.

Bevorzugt sind zwei $CH_2$-Gruppen durch Methyl und/oder Ethyl susbtituiert.

Mit der Formel (LIII) sind auch Mischungen von Anionen gemeint mit verschiedenen Werten von e, f und g, bei denen e + f + g gleich ist. Mit der Formel (LIII) sind aber auch Mischungen von Anionen gemeint mit verschiedenen Werten von e, f und g.

Beispiele für Anionen der Formel (LIII) sind:

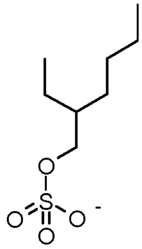 , 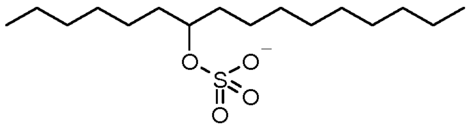 , 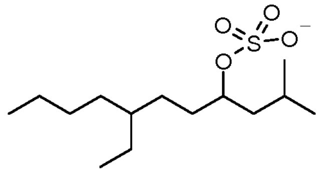 ,

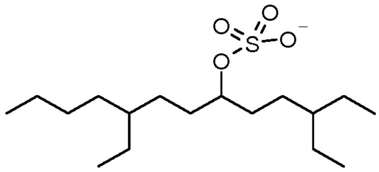 .

Ein weiterer Gegenstand der Erfindung sind Farbstoffe der Formel $F^+ An^-$, worin

$F^+$ die oben angegebene allgemeine oder bevorzugte Bedeutung besitzt, insbesondere die bei den Formeln (I) bis (X) angegebene allgemeine bis herausragend bevorzugte Bedeutung besitzt,

$An^-$ für einen cyclischen Phosphorsäureester der Formel (LIV)

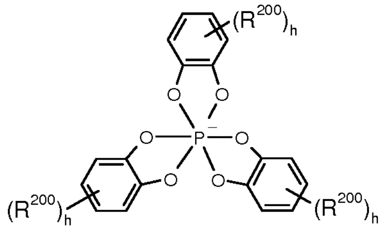 (LIV)

steht,

$R^{200}$ für Wasserstoff oder Halogen steht,
h für eine ganze Zahl von 1 bis 4 steht.

Vorzugsweise stehen $R^{200}$ für Chlor oder Brom und h für 4.

Beispiele für Anionen der Formel (LIV) sind:

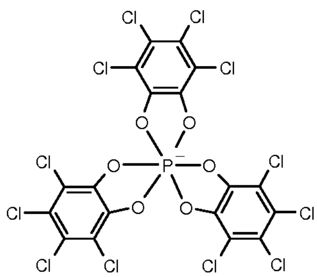 , 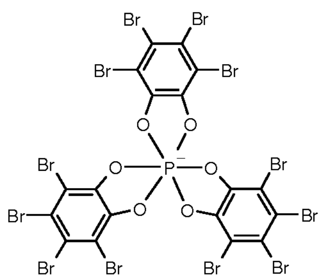

Ein weiterer Gegenstand der Erfindung sind Farbstoffe der Formel $F^+ An^-$, worin

F⁺ die oben angegebene allgemeine oder bevorzugte Bedeutung besitzt, insbesondere die bei den Formeln (III) bis (X) angegebene allgemeine bis herausragend bevorzugte Bedeutung besitzt,

An⁻ für ein Alkylsulfat der Formel (LV)

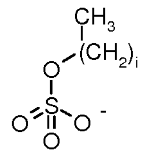

(LV)

steht,

i für eine ganze Zahl von 8 bis 25 steht.

Ein weiterer Gegenstand der Erfindung sind Farbstoffe der Formel $F^+$ $An^-$, worin

F⁺ die oben angegebene allgemeine oder bevorzugte Bedeutung besitzt, insbesondere die bei den Formeln (I) und (II) angegebene allgemeine bis herausragend bevorzugte Bedeutung besitzt,

An⁻ für ein Alkylsulfat der Formel (LV)

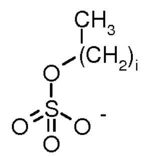

(LV)

steht,

i für eine ganze Zahl von 12 bis 25 steht oder

i für eine ganze Zahl von 18 bis 25 steht, wenn

F⁺ für die Formel (I) steht, $X^2$ für N und $X^1$ für O oder S stehen und $R^1$ bis $R^4$ gleich sind und für Methyl oder Ethyl stehen oder,

F⁺ für die Formel (II) steht und $NR^{11}R^{12}$, $NR^{13}R^{14}$ und $R^{18}R^{19}$ gleich sind und für Dimethylamino stehen und

alle anderen Reste die angegebene allgemeine bis herausragend bevorzugte Bedeutung besitzen.

Vorzugsweise steht i für eine ganze Zahl von 18 bis 25.

Beispiele für Anionen der Formel (LV) sind:

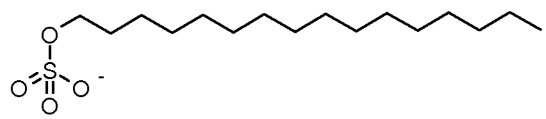

.

Ein weiterer Gegenstand der Erfindung sind Farbstoffe der Formel $F^+$ $An^-$, worin

F⁺ die oben angegebene allgemeine oder bevorzugte Bedeutung besitzt, insbesondere die bei den Formeln (I) bis (X) angegebene allgemeine bis herausragend bevorzugte Bedeutung besitzt,

An⁻ für ein Sulfosuccinat der Formel (LVI)

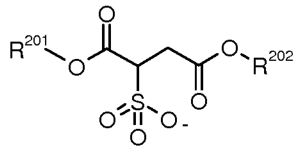

(LVI)

steht,

$R^{201}$ und $R^{202}$ unabhängig von einander für einen unverzweigten $C_4$- bis $C_{16}$-Alkylrest stehen.

Vorzugsweise sind $R^{201}$ und $R^{202}$ gleich.

Ein weiterer Gegenstand der Erfindung sind Farbstoffe der Formel $F^+$ $An^-$, worin

$F^+$ die oben angegebene allgemeine oder bevorzugte Bedeutung besitzt, insbesondere die bei den Formeln (I) bis (X) angegebene allgemeine bis herausragend bevorzugte Bedeutung besitzt,

$An^-$ für ein Sulfosuccinat der Formel (LVI)

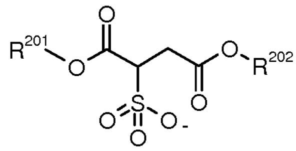

(LVI)

steht,

$R^{201}$ und $R^{202}$ unabhängig von einander für einen durch mindestens 4 Fluoratome substituierten $C_2$- bis $C_{12}$-Alkylrest, einen $C_5$- bis $C_7$-Cycloalkylrest oder einen $C_7$- bis $C_{10}$-Aralkylrest stehen.

Vorzugsweise sind $R^{201}$ und $R^{202}$ gleich.

Ein weiterer Gegenstand der Erfindung sind Farbstoffe der Formel $F^+$ $An^-$, worin

$F^+$ die oben angegebene allgemeine oder bevorzugte Bedeutung besitzt, insbesondere die bei den Formeln (I) mit $X^2$ = C-$R^5$ und (III), (VI) bis (X) angegebene allgemeine bis herausragend bevorzugte Bedeutung besitzt,

$An^-$ für ein Sulfosuccinat der Formel (LVI)

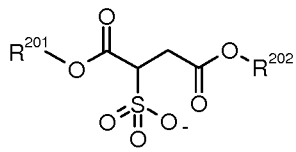

(LVI)

steht,

$R^{201}$ und $R^{202}$ unabhängig von einander für einen $C_4$- bis $C_{16}$-Alkylrest, der verzweigt sein kann, für einen durch mindestens 4 Fluoratome substituierten $C_2$- bis $C_{12}$-Alkylrest, für einen $C_5$- bis $C_7$-Cycloalkylrest oder für einen $C_7$- bis $C_{10}$-Aralkylrest stehen.

Vorzugsweise sind $R^{201}$ und $R^{202}$ gleich.

Ein weiterer Gegenstand der Erfindung sind Farbstoffe der Formel $F^+$ $An^-$, worin

$F^+$ für die Formel (I) mit $X^2$ = N und (II) steht, wobei

| | |
|---|---|
| $X^1$ | für O, S, N-$R^6$ oder $CR^{6a}R^{6b}$ steht, |
| $R^6$ | für Wasserstoff, Methyl, Ethyl, Propyl, Butyl, Cyclohexyl, Benzyl, Phenyl, Tolyl, Anisyl oder Chlorophenyl steht, |
| $R^{6a}$ und $R^{6b}$ | gleich sind und für Methyl, Ethyl oder gemeinsam für eine $-CH_2-CH_2-CH_2-$oder $-CH_2-CH_2-CH_2-CH_2-$Brücke stehen, |
| $R^1$ bis $R^4$ | unabhängig von einander für Wasserstoff, Methyl, Ethyl, Propyl, Butyl, Chlorethyl, Cyanmethyl, Cyanethyl, Methoxyethyl, Cyclopentyl, Cyclohexyl, Cyclohexylmethyl, Benzyl, Phenyl, Tolyl, Anisyl oder Chlorophenyl stehen, wobei mindestens einer der Reste $R^1$ bis $R^4$ nicht für Methyl steht, wenn $X^1$ für S steht oder $NR^1R^2$ nicht für Diethylamino steht, wenn $X^1$ für O steht, |
| $NR^1R^2$ und | $NR^3R^4$ unabhängig voneinander für Pyrrolidino, Piperidino, Morpholino oder N-Methylpiperazino stehen, |
| $R^9$, $R^{9a}$, $R^{9b}$, $R^{10}$, $R^{10a}$ und $R^{10b}$ | für Wasserstoff stehen oder jeweils einer der Reste $R^9$, $R^{9a}$, $R^{9b}$ und/oder einer der Reste $R^{10}$, $R^{10a}$ und $R^{10b}$ für Methyl steht oder |
| $R^1$; $R^9$, $R^2$; $R^{9a}$, $R^3$; $R^{10}$ und $R^4$; $R^{10a}$ | unabhängig von einander eine $-CH_2CH_2-$ oder$-CH_2CH_2CH_2-$Brücke bilden, |
| $R^{15}$ | für Wasserstoff, Chlor, Methyl, Methoxy oder $NR^{18}R^{19}$ steht, |
| $R^{11}$ bis $R^{14}$, $R^{18}$ und $R^{19}$ | unabhängig von einander für Wasserstoff, Ethyl, Propyl, Butyl, Chlorethyl, Cyanmethyl, Cyanethyl, Methoxyethyl, Cyclopentyl, Cyclohexyl, Cyclohexylmethyl, Benzyl, Phenyl, Tolyl, Anisyl oder Chlorophenyl stehen und |
| $R^{13}$, $R^{14}$, $R^{18}$ und $R^{19}$ | zusätzlich für Methyl stehen dürfen oder |
| $NR^{11}R^{12}$, $NR^{13}R^{14}$ und $NR^{18}R^{19}$ | unabhängig von einander für Pyrrolidino, Piperidino, Morpholino oder N-Methylpiperazino stehen, oder |
| $R^{12}$; $R^{17b}$, $R^{13}$; $R^{17c}$ und $R^{18}$; $R^{17a}$ | unabhängig von einander eine $-CH_2CH_2-$, $-CH_2CH_2CH_2-$oder $-CH_2CH_2-O-$Brücke bilden, in der bis zu drei Wasserstoffatome durch Methylgruppen ersetzt sein können, |
| $R^{16}$ | für Wasserstoff, Chlor, Methoxycarbonyl oder Ethoxycarbonyl steht, |
| $R^{16a}$ | für Wasserstoff steht und |
| $R^{17a}$, $R1^{7b}$ und $R^{17c}$ | unabhängig von einander für Wasserstoff oder Methyl stehen, |
| $An^-$ | für ein Sulfosuccinat der Formel (LVI) |

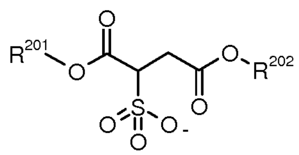

(LVI)

steht,

$R^{201}$ und $R^{202}$ unabhängig von einander für einen $C_4$- bis $C_{16}$-Alkylrest, der verzweigt sein kann, für einen durch mindestens 4 Fluoratome substituierten $C_2$- bis $C_{12}$-Alkylrest, für einen $C_5$- bis $C_7$-Cycloalkylrest oder für einen $C_7$- bis $C_{10}$-Aralkylrest stehen.

Ein weiterer Gegenstand der Erfindung sind Farbstoffe der Formel $F^+ An^-$, worin

| | |
|---|---|
| $F^+$ | für die Formel (II) steht, |
| $R^{15}$ | für Wasserstoff, Chlor, Methyl, Methoxy oder $NR^{18}R^{19}$ steht, |
| $R^{11}$ bis $R^{14}$, $R^{18}$, $R^{19}$ und $R^{20}$ | unabhängig von einander für Wasserstoff, Ethyl, Propyl, Butyl, Chlorethyl, Cyanmethyl, Cyanethyl, Methoxyethyl, Cyclopentyl, Cyclohexyl, Cyclohexylmethyl, Benzyl, Phenyl, Tolyl, Anisyl oder Chlorophenyl stehen oder |
| $NR^{11}R^{12}$, $NR^{13}R^{14}$ und $NR^{18}R^{19}$ | unabhängig von einander für Pyrrolidino, Piperidino, Morpholino oder N-Methylpiperazino stehen, oder |
| $R^{12}$; $R^{17b}$, $R^{13}$; $R^{17c}$ und $R^{18}$; $R^{17a}$ | unabhängig von einander eine eine $-CH_2CH_2-$,$-CH_2CH_2CH_2-$ oder $-CH_2CH_2-O-$Brücke bilden, die bis zu drei Methylgruppen tragen kann, |
| $R^{16}$ | für Wasserstoff, Chlor, Methoxycarbonyl oder Ethoxycarbonyl steht, |
| $R^{16a}$ | für Wasserstoff steht und |
| $R^{17a}$, $R1^{7b}$ und $R^{17c}$ | unabhängig von einander für Wasserstoff oder Methyl stehen. |
| $An^-$ | für ein Sulfosuccinat der Formel (LVI) |

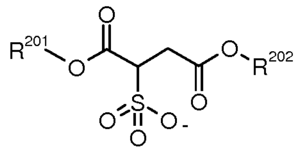

(LVI)

steht,

$R^{201}$ und $R^{202}$ unabhängig von einander für einen $C_4$- bis $C_{16}$-Alkylrest, der verzweigt sein kann, für einen durch mindestens 4 Fluoratome substituierten $C_2$- bis $C_{12}$-Alkylrest, für einen $C_5$- bis $C_7$-Cycloalkylrest oder für einen $C_7$- bis $C_{10}$-Aralkylrest stehen.

Ein weiterer Gegenstand der Erfindung sind Farbstoffe der Formel $F^+ An^-$, worin

| | |
|---|---|
| $F^+$ | für die Formel (IV) und (V) steht, wobei |
| C | zusammen mit $X^{31}$ und $X^{32}$ und den sie verbindenden Atomen für 2- oder 4-Pyridyl, 2- oder 4-Chinolyl, 1,3-Thiazol-2-yl, 1,3-Thiazolin-2-yl, Benzothiazol-2-yl, 1,3-Oxazolin-2-yl, Benzoxazol-2-yl, Imidazol-2-yl, Imidazolin-2-yl, Benzimidazol-2-yl, Pyrrolin-2-yl, 3H-Indol-2-yl oder Chinoxalin-2-yl steht, die durch Methyl, Ethyl, Benzyl, Methoxy, Chlor, Cyano, Nitro oder Methoxycarbonyl substituiert sein können, wobei im Falle von Imidazol-2-yl, Imidazolin-2-yl und Benzimidazol-2-yl beide N-Atome durch $R^{31}$ substituiert sind, oder |
| C | zusammen mit $X^{31}$-$R^{31}$ und $X^{32}$ und den sie verbindenden Atomen für Pyrylium-2- oder -4-yl, Thiopyrylium-2- oder -4-yl, die durch 2 Reste der Gruppe Phenyl, Tolyl oder Anisyl substituiert sind, steht, |
| $R^{31}$ | für Methyl, Ethyl, Propyl, Butyl, Benzyl oder Phenethyl steht, |
| $R^{32}$ und $R^{33}$ | unabhängig voneinander für Methyl, Propyl, Butyl, Chlorethyl, Cyanmethyl, Methoxyethyl, Cyclopentyl, Cyclohexyl, Cyclohexylmethyl, Benzyl, Phenyl, Tolyl, Anisyl oder Chlorophenyl stehen und |
| $R^{32}$ | zusätzlich für Wasserstoff oder Ethyl stehen kann oder |
| $NR^{32}R^{33}$ | für Pyrrolidino, Piperidino, Morpholino oder N-Methylpiperazino steht, |
| $R^{34}$ | für Wasserstoff, Chlor, Methyl oder Methoxy steht oder |
| $R^{34}$ mit $R^{32}$ | eine $-CH_2CH_2-$, $-CH_2CH_2CH_2-$ oder $-CH_2CH_2-O-$Brücke bilden, in der bis zu drei Wasserstoffatome durch Methylgruppen ersetzt sein können, |

$R^{35}$ für Wasserstoff, Chlor, Methyl, Methoxy, Acetamino, Propionylamino, oder Methansulfonylamino steht,

$R^{36}$ für Wasserstoff oder Cyano, steht,

$Y^{42}$ für einen Rest der Formeln (Va) oder (Vb)

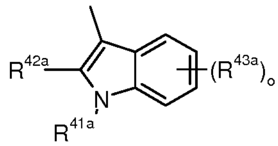

(Va),

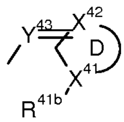

(Vb)

steht,

$R^{41}$, $R^{41a}$ und $R^{41b}$ unabhängig von einander für Methyl, Ethyl, Propyl, Butyl, Benzyl oder Phenethyl stehen und $R^{41}$ und $R^{41a}$ zusätzlich für Wasserstoff stehen dürfen,

$R^{42}$ und $R^{42a}$ unabhängig von einander für Wasserstoff, Ethyl, Cyclohexyl, Phenyl, Tolyl, Anisyl oder Chlorphenyl stehen,

$R^{43}$ und $R^{43a}$ unabhängig von einander für Wasserstoff, Methyl, Methoxy oder Chlor, steht oder zwei benachbarte $R^{43}$ oder $R^{43a}$ für -CH=CH-CH=CH- stehen,

n und o unabhängig von einander für eine ganze Zahl von 0 bis 2 stehen,

$Y^{41}$ für $CR^{44}$ oder $=CR^{41a}-CR^{46}=CR^{45b}-$ steht, wenn $Y^{42}$ für einen Rest der Formel (Va) steht, oder

$Y^{41}$ für $CR^{44}$ steht, wenn $Y^{42}$ für einen Rest der Formel (Vb) steht,

$Y^{43}$ für CH steht oder

$Y^{41}$ und $Y^{43}$ beide für N stehen,

$R^{44}$, $R^{45a}$, $R^{45b}$ und $R^{46}$ für Wasserstoff stehen und

D zusammen mit $X^{41}$ und $X^{42}$ und den sie verbindenden Atomen für Pyridin-2-oder -4-ylen, Chinolin-2- oder -4-ylen, 1,3-Thiazol-2-ylen, 1,3-Thiazolin-2-ylen, Benzothiazol-2-ylen, 1,3,4-Thiadiazol-2ylen, 1,3-Oxazolin-2-ylen, Benzoxazol-2-ylen, Imidazol-2-ylen, Imidazolin-2-ylen, Benzimidazol-2-ylen, Pyrrolin-2-ylen, 1,3,4-Triazol-2-ylen, 3-H-Indol-2-ylen oder Chinoxalin-2-ylen steht, die durch Methyl, Ethyl, Benzyl, Methoxy, Chlor, Cyano, Nitro oder Methoxycarbonyl substituiert sein können, wobei im Falle von Imidazol-2-ylen, Imidazolin-2-ylen und Benzimidazol-2-ylen beide N-Atome durch $R^{41b}$ substituiert sind und im Falle 1,3,4-Thiadizol-2-ylen als zusätzliche Substituenten Dimethylamino, Diethylamino, Dipropylamino, Dibutylamino, N-Methyl,N-cyanethylamino, Bis(cyanethyl)amino, N-Methyl-N-phenylamino, Pyrrolidino, Piperidino oder Morpholino in Frage kommen, oder

D zusammen mit zusammen mit $X^{41}$-$R^{41b}$ und $X^{42}$ und den sie verbindenden Atomen für 2H-Pyran-2-ylen, 4H-Pyran-4-ylen, 2H-thiopyran-2-ylen, 4H-Thiopyran-4-ylen steht, die durch 2 Reste der Gruppe Phenyl, Tolyl oder Anisyl substituiert sind,

An⁻ für ein Sulfosuccinat der Formel (LVI)

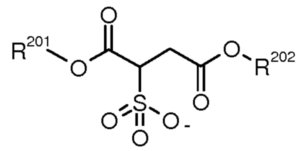

(LVI)

steht,

$R^{201}$ und $R^{202}$ unabhängig von einander für einen $C_4$- bis $C_{16}$-Alkylrest, der verzweigt sein kann, für einen durch mindestens 4 Fluoratome substituierten $C_2$- bis $C_{12}$-Alkylrest, für einen $C_5$- bis $C_7$-Cycloalkylrest oder für einen $C_7$- bis $C_{10}$-Aralkylrest stehen.

Besonders bevorzugt stehen $R^{201}$ und $R^{202}$ für einen $C_6$- bis $C_{12}$-Alkylrest, der verzweigt sein kann, oder für Cyclohexyl oder Benzyl. Ganz besonders bevorzugt stehen $R^{201}$ und $R^{202}$ für n-Hexyl, n-Octyl oder 2-Ethylhexyl. Ebenfalls ganz besonders bevorzugt stehen $R^{201}$ und $R^{202}$ für 2,2,3,3-Tetrafluorpropyl, 1H,1H-Heptafluorbutyl, Perfluoroctyl, 1H,1H,7H-Dodecafluorheptyl, 1H,1H,2H,2H-Tridecafluoroctyl.

Beispiele für Anionen der Formel (LVI) sind:

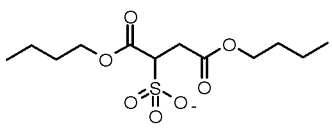 , 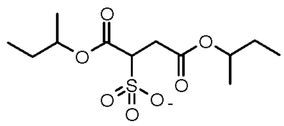 , 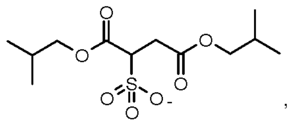 ,

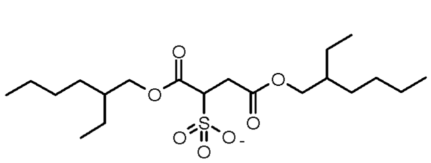 , 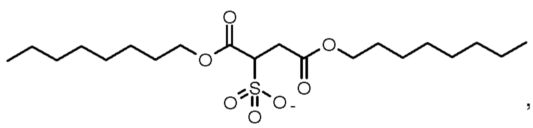 ,

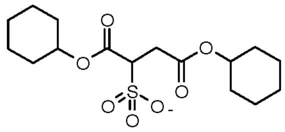 , 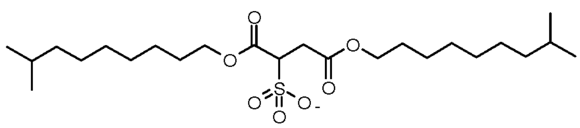 ,

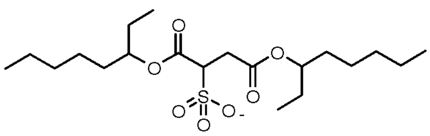 , 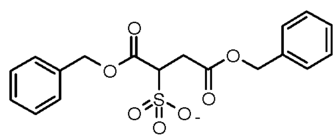 ,

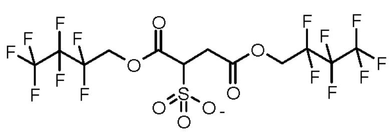

Ein weiterer Gegenstand der Erfindung sind Farbstoffe der Formel $F^+$ $An^-$, worin

$F^+$ die oben angegebene allgemeine oder bevorzugte Bedeutung besitzt, insbesondere die bei den Formeln (I) bis (X) angegebene allgemeine bis herausragend bevorzugte Bedeutung besitzt,

An⁻ für ein Estersulfonat der Formel (LVII)

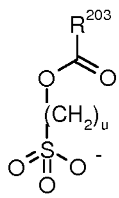

(LVII)

steht,

$R^{203}$ für einen $C_2$- bis $C_{22}$-Alkyl- oder Alkenylrest steht, der verzweigt oder substituiert sein kann, und

u für eine ganze Zahl von 2 bis 4 steht.

Beispiele für Anionen der Formel (LVII) sind:

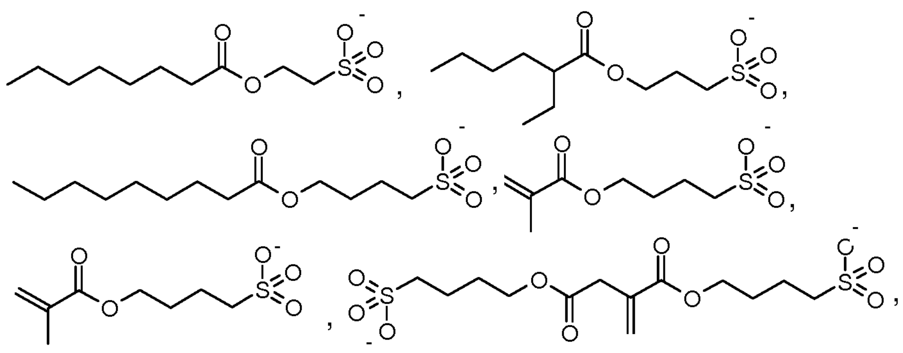

, , , , ,

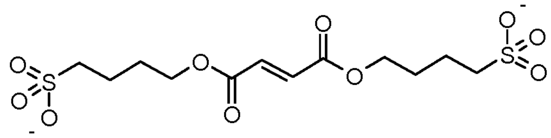

Ein weiterer Gegenstand der Erfindung sind Farbstoffe der Formel $F^+ An^-$, worin

$F^+$ die oben angegebene allgemeine oder bevorzugte Bedeutung besitzt, insbesondere die bei den Formeln (I) bis (X) angegebene allgemeine bis herausragend bevorzugte Bedeutung besitzt,

$An^-$ für ein Estersulfonat oder Estersulfate der Formel (LVIII)

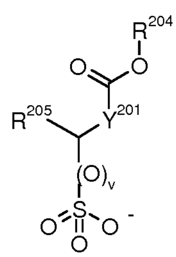

(LVIII)

steht,

v für 0 oder 1 steht,

$R^{204}$ für $C_1$- bis $C_{18}$-Alkyl, das verzweigt und/oder substituiert sein kann, steht,
$R^{205}$ für Wasserstoff oder $C_1$- bis $C_8$-Alkyl steht und
$Y^{201}$ für eine direkte Bindung, eine aliphatische $C_1$- bis $C_{22}$-Brücke oder eine olefinische $C_2$- bis $C_{22}$-Brücke steht,
wobei $Y^{201}$ und $R^{204}$ gemeinsam mindestens 7 C-Atome aufweisen.

Ein weiterer Gegenstand der Erfindung sind Farbstoffe der Formel $F^+ An^-$,
worin

$F^+$ die oben angegebene allgemeine oder bevorzugte Bedeutung besitzt, insbesondere die bei den Formeln (I) bis (X) angegebene allgemeine bis herausragend bevorzugte Bedeutung besitzt,

$An^-$ für ein fluoriertes Alkylsulfat der Formel (LX)

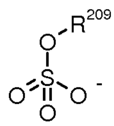
(LX),

worin

$R^{209}$ für einen $C_4$- bis $C_{18}$-Alkylrest steht, der mindestens 4 Fluoratome trägt.

Beispiele für Anionen der Formel (LX) sind:

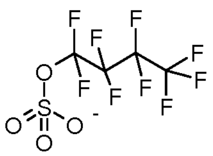
,
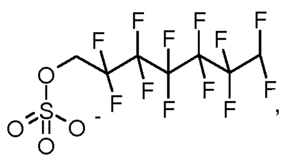
,
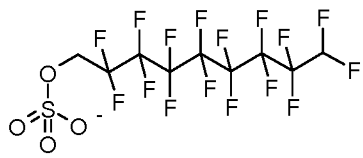
.

Beispiele für Anionen der Formel (LVIII) sind:

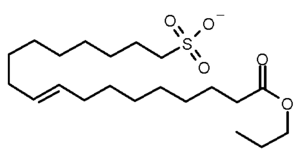
,
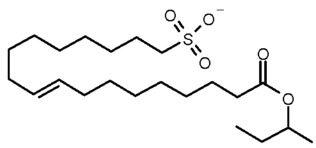
,
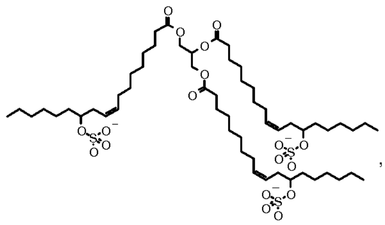
,

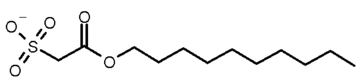

Ein weiterer Gegenstand der Erfindung sind Lösungen der erfindungsgemäßen Farbstoffe der Formel $F^+ An^-$.

Bevorzugt sind solche Lösungen in Estern und Ketonen sowie Mischungen davon. Geeignete Ester sind die Ethyl-, Propyl- und Butylester der Ameisen-, Essigsäure und Propionsäure. Unter Propyl sind 1- und 2-Propyl zu verstehen, unter Butyl sind 1- und 2-Butyl sowie 2-Methyl-1-propyl zu verstehen. Bevorzugte Ester sind Essigsäure-ethyl- und - 1-butylester. Geeignete Ketone sind Aceton, Butanon und Pentanon. Bevorzugtes Keton ist Butanon. Bevorzugte Mischungen bestehen aus Essigsäureethylester und/oder Essigsäure-1-butylester und /oder Butanon. Vorzugsweise ist der Anteil Butanon in solchen Mischungen $\leq 50\%$, besonders bevorzugt $\leq 20\%$.

Solche Lösungen haben eine Konzentration des erfindungemäßen Farbstoffs von 1 bis 50 Gew.-%, vorzugsweise 5 bis 40 Gew.-%, besonders bevorzugt 10 bis 30 Gew.-%. Bevorzugt sind solche Lösungen, die einen Wassergehalt <0,3%, besonders bevorzugt <0,2%, ganz besonders bevorzugt <0,1% aufweisen.

Ein weiterer Gegenstand der Erfindung ist ein Verfahren zur Herstellung der Farbstoffe der Formel (I), dadurch gekennzeichnet, dass man aus einer Suspension isoliert.

Hierbei wird der Farbstoff der Formel $F^+ An'^-$, worin $F^+$ die oben angegebene Bedeutung besitzt und $An'^-$ für ein Anion steht, das aus der Synthese oder Isolierung des Farbstoffs stammt, in einem geeigneten Lösungsmittel oder Lösungsmittelgemisch gelöst oder suspendiert. Ein Salz des erfindungsgemäßen Anions $M^+ An^-$, worin $M^+$ für ein Kation oder ein Äquivalent eines Kations steht und $An^-$ die oben angegebene Bedeutung eines Anions besitzt, wird ebenfalls in einem Lösungsmittel oder Lösungsmittelgemisch gelöst, wobei die Lösungsmittel für Farbstoff und Salz nicht gleich sein müssen, sich aber mischen müssen. Diese Lösung des Salzes $M^+ An^-$ wird nun bei Raumtemperatur oder erhöhter Temperatur zur Lösung oder Suspension des Farbstoffs $F^+ An'^-$ gegeben, wobei der erfindungsgemäße Farbstoff der Formel $F^+ An^-$ ausfällt. Er wird abfiltriert, gewaschen und, falls erforderlich, kann mit einem Lösungsmittel, in dem er sich nicht oder nur wenig löst, ausgerührt werden oder aus diesem Lösungsmittel umkristallisiert. Man erhält so den Farbstoff der Formel $F^+ An^-$, worin $F^+$ und $An^-$ die oben angegebene Bedeutung besitzen.

Beispiele für Anionen $An'^-$ sind Chlorid, Bromid, Sulfat, Hydrogensulfat, Nitrat, Methosulfat.

Beispiele für Kationen $M^+$ sind $Na^+$, $K^+$, $NH_4^+$.

Die Temperatur kann zwischen Raumtemperatur und dem Siedepunkt der Mischung liegen. Besonders bevorzugt ist zwischen Raumtemperatur und 50 °C.

Geeignete Lösungsmittel sind Alkohole wie Methanol, Ethanol, 2-Propanol, Nitrile wie Acetonitril, Säuren wie Eisessig, dipolare Lösungsmittel wie N-Ethylpyrrolidon, Ether wie Tetrahydrofuran oder Wasser.

Zum Ausrühren geeignete Lösungsmittel sind z. B. Diethylether oder tert.-Butylmethylether. Zum Umkristallisieren geeignete Lösungsmittel sind beispielsweise Eisessig oder Acetonitril. Gegebenenfalls kann die Fällung durch Zusatz von beispielsweise Methanol oder Wasser verbessert werden.

Eine andere Variante dieses Verfahrens ist möglich, wenn es sich um einen Farbstoff der Formel $F^+ An'^-$, der zu einer Anhydrobase deprotonierbar ist oder eine Carbinolbase der Formel F-OH bildet. Deprotonierbare Farbstoffe der Formel $F^+ An'^-$ sind solche der Formel $F'\text{-}H^+ An'^-$, wobei $F'\text{-}H^+$ die gleiche Bedeutung wie $F^+$ hat. Solche Farbstoffe lassen sich durch Basen in die neutrale Anhydrobase F' überführen, die mit einer Säure $H^+ An^-$ in den erfindungsgemäßen Farbstoff $F'\text{-}H^+ An^- = F^+ An^-$ überführt werden.

Beispiele sind:

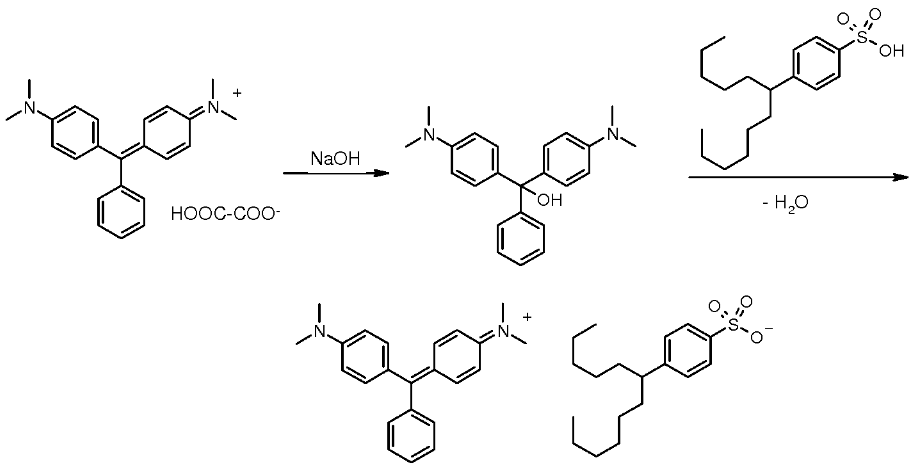

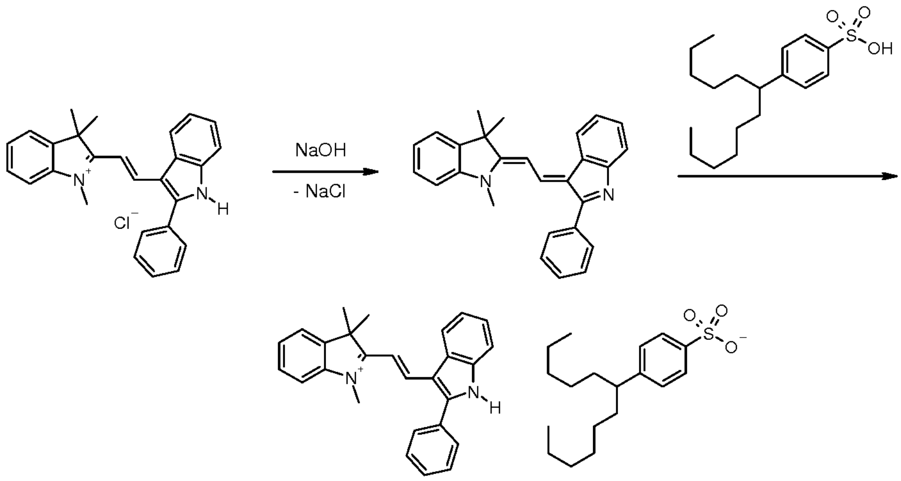


Ein weiterer Gegenstand der Erfindung ist ein Verfahren zur Herstellung der Farbstoffe der Formel (I), dadurch gekennzeichnet, dass man in einem Zweiphasengemisch aus Wasser und einem mit Wasser nicht mischbaren Lösungsmittel arbeitet.

Hierbei wird der Farbstoff der Formel $F^+$ $An'^-$, worin $F^+$ die oben angegebene Bedeutung besitzt und $An'^-$ für ein Anion steht, das aus der Synthese oder Isolierung des Farbstoffs stammt, zusammen mit einem Salz des erfindungsgemäßen Anions $M^+$ $An^-$, worin $M^+$ für ein Kation oder ein Äquivalent eines Kations steht und $An^-$ die oben angegebene Bedeutung eines Sulfosuccinats besitzt, in einer Mischung aus Wasser und einem mit Wasser nicht mischbaren Lösungsmittel gegebenenfalls bei höherer Temperatur verrührt. Die Wasserphase wird abgetrennt. Dies kann bei Raumtemperatur oder bei höherer Temperatur geschehen. Vorteilhaft wird die organische Phase, die den Farbstoff der Formel $F^+$ $An^-$ enthält, ein oder mehrmals mit frischem Wasser verrührt. Jeweils wird die Wasserphase abgetrennt. Die organische Phase wird in geeigneter Weise getrocknet und schließlich eingedampft. Falls erforderlich, kann der Trockenrückstand noch mit einem Lösungsmittel, in dem er sich nicht oder nur wenig löst, ausgerührt werden oder aus diesem Lösungsmittel umkristallisiert werden. Man erhält so den Farbstoff der Formel $F^+$ $An^-$, worin $F^+$ und $An^-$ die oben angegebene Bedeutung besitzen.

Beispiele für Anionen $An'^-$ sind Chlorid, Bromid, Sulfat, Hydrogensulfat, Nitrat, Methosulfat.

Beispiele für Kationen $M^+$ sind $Na^+$, $K^+$ und $NH_4^+$.

Die Temperatur kann zwischen Raumtemperatur und dem Siedepunkt der Mischung liegen. Besonders bevorzugt ist zwischen Raumtemperatur und 40 bis 50 °C

Geeignete mit Wasser nicht mischbare Lösungsmittel sind halogenierte Alkane wie Dichlormethan, Trichlormethan, Tetrachlorethan sowie Aromaten wie Toluol oder Chlorbenzol.

Zum Ausrühren geeignete Lösungsmittel sind z. B. Diethylether oder tert.-Butylmethylether. Zum Umkristallisieren geeignete Lösungsmittel sind beispielsweise Eisessig oder Acetonitril.

Ein weiterer Gegenstand der Erfindung ist ein Verfahren zur Herstellung der Sulfosuccinate, dadurch gekennzeichnet, dass man in einem Zweiphasengemisch aus Wasser und einem Ester arbeitet.

Hierbei wird der Farbstoff der Formel $F^+$ $An'^-$, worin $F^+$ die oben angegebene Bedeutung besitzt und $An'^-$ für ein Anion steht, das aus der Synthese oder Isolierung des Farbstoffs stammt, zusammen mit einem Salz des erfindungsgemäßen Anions $M^+$ $An^-$, worin $M^+$ für ein Kation oder ein Äquivalent eines Kations steht und $An^-$ die oben angegebene Bedeutung eines Sulfosuccinats besitzt, in einer Mischung aus Wasser und einem Ester gegebenenfalls bei höherer Temperatur verrührt. Die Wasserphase wird abgetrennt. Dies kann bei Raumtemperatur oder bei höherer Temperatur geschehen. Vorteilhaft wird die Esterphase, die den Farbstoff der Formel $F^+$ $An^-$ enthält, ein oder mehrmals mit frischem Wasser verrührt. Jeweils wird die Wasserphase abgetrennt. Die Esterphase wird in geeigneter Weise getrocknet. Man erhält so eine Lösung eines Farbstoffs der Formel $F^+$ $An^-$, worin $F^+$ und $An^-$ die oben angegebene Bedeutung besitzen.

Beispiele für Anionen $An'^-$ sind Chlorid, Bromid, Sulfat, Hydrogensulfat, Nitrat, Methosulfat.

Mit Ester sind solche der Ameisensäure, Essigsäure, Propionsäure und Buttersäure gemeint, vorzugsweise solche der Essigsäure und Propionsäure.

Beispiele für Ester sind Ameisensäurepropylester, Ameisensäurebutylester, Essigsäureethylester, Essigsäurebutylester, Essigsäure-methoxypropyl-ester, Essigsäureethoxypropyl-ester, Propionsäuremethylester, Propionsäureethylester, Buttersäuremethylester. Bevorzugt sind Essigsäureethylester und Essigsäurebutylester.

Beispiele für Kationen $M^+$ sind $Na^+$, $K^+$ und $NH_4^+$.

Die Temperatur kann zwischen Raumtemperatur und dem Siedepunkt der Mischung liegen. Besonders bevorzugt ist zwischen Raumtemperatur und 50 °C.

Unter Trocknen der Esterphase versteht man das Entfernen von mitgerissenem und/oder gelöstem Wasser. Mitgerissenes Wasser kann beispielsweise durch Filtrieren über eine geeignete Membran oder ein hydrophobiertes Filterpapier entfernt werden. Geeignete Trockenmethoden sind Trocknen über wasserfreien Salzen wie Natriumsulfat oder Magnesiumsulfat oder über Molekularsieb. Eine weitere Trockenmethode ist das Abdestillieren des Wassers als Azeotrop. Vorteilhaft werden verschiedene dieser Methoden nach einander durchgeführt.

Ein weiterer Gegenstand der Erfindung ist ein Verfahren zur Herstellung der Sulfosuccinate, dadurch gekennzeichnet, dass man in einem Ester in Abwesenheit von Wasser arbeitet.

Hierbei wird der Farbstoff der Formel $F^+ An'^-$, worin $F^+$ die oben angegebene Bedeutung besitzt und $An'^-$ für ein Anion steht, das aus der Synthese oder Isolierung des Farbstoffs stammt, zusammen mit einem Salz des erfindungsgemäßen Anions $M^+ An^-$, worin $M^+$ für ein Kation oder ein Äquivalent eines Kations steht und $An^-$ die oben angegebene Bedeutung eines Sulfosuccinats besitzt, in einem Ester gegebenenfalls bei höherer Temperatur verrührt und von dem Ungelösten abfiltriert. Man erhält so eine Lösung eines Farbstoffs der Formel $F^+ An^-$, worin $F^+$ und $An^-$ die oben angegebene Bedeutung besitzen, die ohne weitere Trocknung verwendet werden kann. Es kann jedoch im Einzelfall - beispielsweise, wenn die eingesetzten Edukte nicht komplett wasserfrei waren - auch eine zusätzliche Trocknung erforderlich sein, die wie oben beschrieben durchgeführt wird.

Beispiele für Anionen $An'^-$ sind Chlorid, Bromid, Sulfat, Hydrogensulfat, Nitrat, Methosulfat.

Mit Ester sind die oben aufgeführten Ester gemeint.

Bevorzugte Ester sind Essigsäureethylester und Essigsäurebutylester.

Beispiele für Kationen $M^+$ sind $Na^+$, $K^+$ und $NH_4^+$.

Die Temperatur kann zwischen Raumtemperatur und dem Siedepunkt des Essigesters liegen. Besonders bevorzugt ist zwischen Raumtemperatur und 60 °C.

Bei dem Ungelösten handelt es sich hauptsächlich um das Salz der Zusammensetzung $M^+ An'^-$.

Ein weiterer Gegenstand der Erfindung sind Farbstoffe der Formeln (Vc) und (Vd)

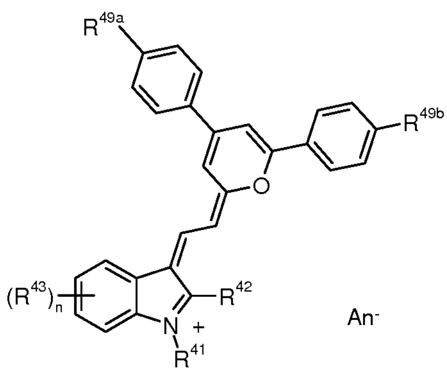

(Vc),

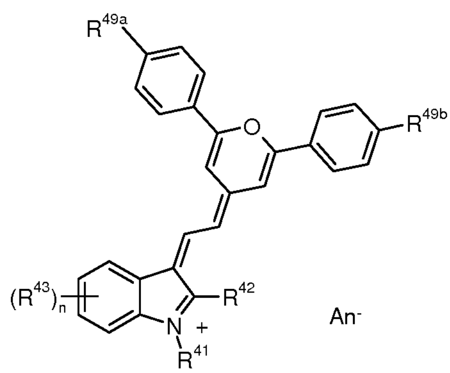

(Vd),

worin

| | |
|---|---|
| $R^{49a}$ und $R^{49b}$ | für Wasserstoff, $C_1$- bis $C_4$-Alkyl, $C_1$- bis $C_4$-Alkoxy, Cyano oder Halogen stehen und vorzugsweise gleich sind, |
| $R^{41}$ | für Wasserstoff, $C_1$- bis $C_{16}$-Alkyl, $C_3$- bis $C_6$-Alkenyl, $C_5$- bis $C_7$-Cycloalkyl oder $C_7$- bis $C_{16}$-Aralkyl oder $C_6$- bis $C_{10}$-Aryl steht, |
| $R^{42}$ | $C_1$- bis $C_{16}$-Alkyl, $C_3$- bis $C_6$-Alkenyl, $C_5$- bis $C_7$-Cycloalkyl oder $C_7$- bis $C_{16}$-Aralkyl, $C_6$- bis $C_{10}$-Aryl oder Hetaryl steht, |
| $R^{43}$ | für Wasserstoff, $C_1$- bis $C_4$-Alkyl, $C_1$- bis $C_4$-Alkoxy, Halogen, Cyano, Nitro oder $C_1$- bis $C_4$-Alkoxycarbonyl steht oder zwei benachbarte $R^{43}$ für-CH=CH-CH=CH- stehen, |
| n | für eine ganze Zahl von 0 bis 2 steht, |
| $An^-$ | für ein Anion, vorzugsweise ein erfindungsgemäßes Anion, steht. |

Bevorzugt sind Farbstoffe der Formeln (Vc) und (Vd), worin

| | |
|---|---|
| $R^{49a}$ und $R^{49b}$ | für Wasserstoff stehen, |
| $R^{41}$ | für Wasserstoff, Methyl, Ethyl, Cyanethyl, Allyl oder Benzyl steht, |
| $R^{42}$ | für Methyl, Ethyl, Cyclohexyl, Phenyl, Tolyl, Anisyl oder Chlorphenyl steht, |
| $R^{43}$ | für Wasserstoff, Chlor, Cyano, Methyl, Methoxy, Methoxycarbonyl oder Ethoxycarbonyl steht, |
| n | für 1 steht, |
| $An^-$ | für ein Anion, vorzugsweise ein erfindungsgemäßes Anion, steht. |

Als Polyisocyanat-Komponente a) können alle dem Fachmann an sich gut bekannten Verbindungen oder deren Mischungen eingesetzt werden, die im Mittel zwei oder mehr NCO-Funktionen pro Molekül aufweisen. Diese können auf aromatischer, araliphatischer, aliphatischer oder cycloaliphatischer Basis sein. In untergeordneten Mengen können auch Monoisocyanate und/oder ungesättigte Gruppen enthaltende Polyisocyanate mit verwendet werden.

Beispielsweise geeignet sind Butylendiisocyanat, Hexamethylendiisocyanat (HDI), Isophorondiisocyanat (IPDI), 1,8-Diisocyanato-4-(isocyanatomethyl)-octan, 2,2,4- und/oder 2,4,4-Trimethylhexamethylendiisocyanat, die isomeren Bis-(4,4'-isocyanatocyclohexyl)-methan und deren Mischungen beliebigen Isomerengehalts, Isocyanatomethyl-1,8-octandiisocyanat, 1,4-Cyclohexylendiisocyanat, die isomeren Cyclohexandimethylendiisocyanate, 1,4-Phenylendiisocyanat, 2,4- und/oder 2,6-Toluylendiisocyanat, 1,5-Naphthylendiisocyanat, 2,4'- oder 4,4'-Diphenylmethandiisocyanat und/oder Triphenylmethan-4,4',4"-triisocyanat.

Ebenfalls möglich ist der Einsatz von Derivaten monomerer Di- oder Triisocyanate mit Urethan-, Harnstoff-, Carbodiimid-, Acylharnstoff-, Isocyanurat-, Allophanat-, Biuret-, Oxadiazintrion-, Uretdion- und/oder Iminooxadiazindionstrukturen.

Bevorzugt ist der Einsatz von Polyisocyanaten auf Basis aliphatischer und/oder cycloaliphatischer Di- oder Triisocyanate.

Besonders bevorzugt handelt es sich bei den Polyisocyanaten der Komponente a) um di- oder oligomerisierte aliphatische und/oder cycloaliphatische Di- oder Triisocyanate.

Ganz besonders bevorzugt sind Isocyanurate, Uretdione und/oder Iminooxadiazindione basierend auf HDI, 1,8-Diisocyanato-4-(isocyanatomethyl)-octan oder deren Mischungen.

Ebenfalls können als Komponente a) NCO-funktionelle Prepolymere mit Urethan-, Allophanat-, Biuret- und/oder Amidgruppen eingesetzt werden. Prepolymere der Komponente a) werden in dem Fachmann an sich gut bekannter Art und Weise durch Umsetzung von monomeren, oligomeren oder Polyisocyanaten al) mit isocyanatreaktiven Verbindungen a2) in geeigneter Stöchiometrie unter optionalem Einsatz von Katalysatoren und Lösemitteln erhalten.

Als Polyisocyanate a1) eignen sich alle dem Fachmann an sich bekannten aliphatischen, cycloaliphatischen, aromatischen oder araliphatischen Di- und Triisocyanate, wobei es unerheblich ist, ob diese mittels Phosgenierung oder nach phosgenfreien Verfahren erhalten wurden. Daneben können auch die diem Fachmann an sich gut bekannten höhermolekularen Folgeprodukte monomerer Di- und/oder Triisocyanate mit Urethan-, Harnstoff-, Carbodiimid-, Acylharnstoff-, Isocyanurat-, Allophanat-, Biuret-, Oxadiazintrion-, Uretdion-, Iminooxadiazindionstruktur jeweils einzeln oder in beliebigen Mischungen untereinander eingesetzt werden.

Beispiele für geeignete monomere Di- oder Triisocyanate, die als Komponente a1) eingesetzt werden können, sind Butylendiisocyanat, Hexamethylendiisocyanat (HDI), Isophorondiisocyanat (IPDI), Trimethyl-hexamethylen-diisocyanat (TMDI), 1,8-Diiso-cyanato-4-(isocyanatomethyl)-octan, Isocyanatomethyl-1,8-octandiisocyanat (TIN), 2,4- und/oder 2,6-Toluen-diisocyanat.

Als isocyanatreaktive Verbindungen a2) zum Aufbau der Prepolymere werden bevorzugt OH-funktionelle Verbindungen eingesetzt. Diese sind analog den OH-funktionellen Verbindungen wie sie nachfolgend für die Komponente b) beschrieben sind.

Ebenfalls möglich ist der Einsatz von Aminen zur Prepolymerherstellung. Beispielsweise geeignet sind Ethylendiamin, Diethylentriamin, Triethylentetramin, Propylendiamin, Diaminocyclohexan, Diaminobenzol, Diaminobisphenyl, difunktionelle Polyamine wie z.B. die Jeffamine®, aminterminierte Polymere mit zahlenmittleren Molmassen bis 10000 g/Mol oder deren beliebige Gemische untereinander.

Zur Herstellung von Biuretgruppen-haltigen Prepolymeren wird Isocyanat im Überschuss mit Amin umgesetzt, wobei eine Biuretgruppe entsteht. Als Amine eignen sich in diesem Falle für die Umsetzung mit den erwähnten Di-, Tri- und Polyisocyanaten alle oligomeren oder polymeren, primären oder sekundären, difunktionellen Amine der vorstehend genannten Art.

Bevorzugte Prepolymere sind Urethane, Allophanate oder Biurete aus aliphatischen Isocyanat-funktionellen Verbindungen und oligomeren oder polymeren Isocyanat-reaktiven Verbindungen mit zahlenmittleren Molmassen von 200 bis 10000 g/Mol, besonders bevorzugt sind Urethane, Allophanate oder Biurete aus aliphatischen Isocyanat-funktionellen Verbindungen und oligomeren oder polymeren Polyolen oder Polyaminen mit zahlenmittleren Molmassen von 500 bis 8500 g/Mol und ganz besonders bevorzugt sind Allophanate aus HDI oder TMDI und difunktionellen Polyetherpolyolen mit zahlenmittleren Molmassen von 1000 bis 8200 g/Mol.

Bevorzugt weisen die vorstehend beschriebenen Prepolymere Restgehalte an freiem monomeren Isocyanat von weniger als 1 Gew.-%, besonders bevorzugt weniger als 0.5 Gew.-% und ganz besonders bevorzugt weniger als 0.2 Gew.-% auf.

Selbstverständlich kann die Polyisocyanat-Komponente anteilsmäßig neben den beschriebenen Prepolymeren weitere Isocyanatkomponenten enthalten. Hierfür kommen aromatische, araliphatische, aliphatische und cycloaliphatische Di-, Tri- oder Polyisocyanate in Betracht. Es können auch Mischungen solcher Di-, Tri- oder Polyisocyanate eingesetzt werden. Beispiele geeigneter Di-, Tri- oder Polyisocyanate sind Butylendiisocyanat, Hexamethylendiisocyanat (HDI), Isophorondiisocyanat (IPDI), 1,8-Diisocyanato-4-(isocyanatomethyl)octan, 2,2,4- und/oder 2,4,4-Trimethylhexamethylendiisocyanat (TMDI), die isomeren Bis(4,4'-isocyanatocyclohexyl)methane und deren Mischungen beliebigen Isomerengehalts, Isocyanatomethyl-1,8-octandiisocyanat, 1,4-Cyclohexylendiisocyanat, die isomeren Cyclohexandimethylendiisocyanate, 1,4-Phenylendiisocyanat, 2,4- und/oder 2,6-Toluylendiisocyanat, 1,5-Naphthylendiisocyanat, 2,4'- oder 4,4'-Diphenylmethandiisocyanat, Triphenylmethan-4,4',4"-triisocyanat oder deren Derivate mit Urethan-, Harnstoff-, Carbodiimid-, Acylharnstoff-, Isocyanurat-, Allophanat-, Biuret-, Oxadiazintrion-, Uretdion-, Iminooxadiazindionstruktur und Mischungen derselben. Bevorzugt sind Polyisocyanate auf Basis oligomerisierter und/oder derivatisierter Diisocyanate, die durch geeignete Verfahren von überschüssigem Diisocyanat befreit wurden, insbesondere die des Hexamethylendiisocyanat. Besonders bevorzugt sind die oligomeren Isocyanurate, Uretdione und Iminooxadiazindione des HDI sowie deren Mischungen.

Es ist gegebenenfalls auch möglich, dass die Polyisocyanat-Komponente a) anteilsmäßig Isocyanate enthält, die teilweise mit isocyanat-reaktiven ethylenisch ungesättigten Verbindungen umgesetzt sind. Bevorzugt werden hierbei als isocyanat-reaktives ethylenisch ungesättigte Verbindungen $\alpha,\beta$-ungesättigte Carbonsäurederivate wie Acrylate, Methacrylate, Maleinate, Fumarate, Maleimide, Acrylamide, sowie Vinylether, Propenylether, Allylether und Dicyclopentadienyl-Einheiten enthaltende Verbindungen, die mindestens eine gegenüber Isocyanaten reaktive Gruppe aufweisen, eingesetzt. Besonders bevorzugt sind dies Acrylate und Methacrylate mit mindestens einer isocyanatreaktiven Gruppe. Als hydroxyfunktionelle Acrylate oder Methacrylate kommen beispielsweise Verbindungen wie 2-Hydroxyethyl(meth)acrylat, Polyethylenoxid-mono(meth)acrylate, Polypropylenoxid-mono(meth)acrylate, Polyalkylenoxidmono(meth)acrylate, Poly($\varepsilon$-caprolacton)mono(meth)-acrylate, wie z.B. Tone® M100 (Dow, USA), 2-Hydroxypropyl(meth)acrylat, 4-Hydroxybutyl(meth)acrylat, 3-Hydroxy-2,2-dimethylpropyl(meth)acrylat, die hydroxyfunktionellen Mono-, Di- oder Tetra(meth)acrylate mehrwertiger Alkohole wie Trimethylolpropan, Glycerin, Pentaerythrit, Dipentaerythrit, ethoxyliertes, propoxyliertes oder alkoxyliertes Trimethylolpropan, Glycerin, Pentaerythrit, Dipentaerythrit oder deren technische Gemische in Betracht. Darüberhinaus sind isocyanat-reaktive oligomere oder polymere ungesättigte Acrylat- und/oder Methacrylatgruppen enthaltende Verbindungen alleine oder in Kombination mit den vorgenannten monomeren Verbindungen geeignet. Der Anteil an Isocyanaten an der Isocyanatkomponente a), die teilweise mit isocyanat-reaktiven ethylenisch ungesättigten Verbindungen umgesetzt sind beträgt 0 bis 99 %, bevorzugt 0 bis 50 %, besonders bevorzugt 0 bis 25 % und ganz besonders bevorzugt 0 bis 15 %.

Es ist gegebenenfalls auch möglich, dass die vorgenannten Polyisocyanat-Komponente a) vollständig oder

anteilsmäßig Isocyanate enthält, die ganz oder teilweise mit dem Fachmann aus der Beschichtungstechnologie bekannten Blockierungsmitteln umgesetzt sind. Als Beispiel für Blockierungsmittel seien genannt: Alkohole, Lactame, Oxime, Malonester, Alkylacetoacetate, Triazole, Phenole, Imidazole, Pyrazole sowie Amine, wie z.B. Butanonoxim, Diisopropylamin, 1,2,4-Triazol, Dimethyl-1,2,4-triazol, Imidazol, Malonsäurediethylester, Acetessigester, Acetonoxim, 3,5-Dimethylpyrazol, ε-Caprolactam, N-tert.-Butyl-benzylamin, Cyclopentanoncarboxyethylester oder beliebige Gemische dieser Blockierungsmittel.

Besonders bevorzugt ist, wenn die Polyisocyanat-Komponente ein aliphatisches Polyisocyanat oder ein aliphatisches Präpolymer und bevorzugt ein aliphatisches Polyisocyanat oder Präpolymer mit primären NCO-Gruppen ist.

Als Polyol-Komponente b) können an sich alle polyfunktionellen, isocyanatreaktiven Verbindungen eingesetzt werden, die im Mittel wenigstens 1.5 isocyanatreaktive Gruppen pro Molekül aufweisen.

Isocyanatreaktive Gruppen im Rahmen der vorliegenden Erfindung sind bevorzugt Hydroxy-, Amino- oder Thiogruppen, besonders bevorzugt sind Hydroxyverbindungen.

Geeignete polyfunktionelle, isocyanatreaktive Verbindungen sind beispielsweise Polyester-, Polyether-, Polycarbonat-, Poly(meth)acrylat- und/oder Polyurethanpolyole.

Als Polyesterpolyole sind beispielsweise lineare Polyesterdiole oder verzweigte Polyesterpolyole geeignet, wie sie in bekannter Weise aus aliphatischen, cycloaliphatischen oder aromatischen Di- bzw. Polycarbonsäuren bzw. ihren Anhydriden mit mehrwertigen Alkoholen einer OH-Funktionalität ≥ 2 erhalten werden.

Beispiele für solche Di- bzw. Polycarbonsäuren bzw. Anhydride sind Bernstein-, Glutar-, Adipin-, Pimelin-, Kork-, Azelain-, Sebacin-, Nonandicarbon-, Decandicarbon-, Terephthal-, Isophthal-, o-Phthal-, Tetrahydrophthal-, Hexahydrophthal- oder Trimellitsäure sowie Säureanhydride wie o-Phthal-, Trimellit- oder Bernsteinsäureanhydrid oder deren beliebige Gemische untereinander.

Beispiele für geeignete Alkohole sind Ethandiol, Di-, Tri-, Tetraethylenglykol, 1,2-Propandiol, Di-, Tri-, Tetrapropylenglykol, 1,3-Propandiol, Butandiol-1,4, Butandiol-1,3, Butandiol-2,3, Pentandiol-1,5, Hexandiol-1,6, 2,2-Dimethyl-1,3-propandiol, 1,4-Dihydroxycyclohexan, 1,4-Dimethylolcyclohexan, Octandiol-1,8, Decandiol-1,10, Dodecandiol-1,12, Trimethylolpropan, Glycerin oder deren beliebige Gemische untereinander.

Die Polyesterpolyole können auch auf natürlichen Rohstoffen wie Rizinusöl basieren. Ebenfalls möglich ist, dass die Polyesterpolyole auf Homo- oder Mischpolymerisaten von Lactonen basieren, wie sie bevorzugt durch Anlagerung von Lactonen bzw. Lactongemischen wie Butyrolacton, ε-Caprolacton und/oder Methyl-ε-caprolacton an hydroxyfunktionelle Verbindungen wie mehrwertige Alkohole einer OH-Funktionalität ≥ 2 beispielsweise der vorstehend genannten Art erhalten werden können.

Solche Polyesterpolyole haben bevorzugt zahlenmittlere Molmassen von 400 bis 4000 g/Mol, besonders bevorzugt von 500 bis 2000 g/Mol. Ihre OH-Funktionalität beträgt bevorzugt 1.5 bis 3.5, besonders bevorzugt 1.8 bis 3.0.

Geeignete Polycarbonatpolyole sind in an sich bekannter Weise durch Umsetzung von organischen Carbonaten oder Phosgen mit Diolen oder Diol-Mischungen zugänglich.

Geeignete organische Carbonate sind Dimethyl-, Diethyl- und Diphenylcarbonat.

Geeignete Diole bzw. Mischungen umfassen die an sich im Rahmen der Polyestersegmente genannten mehrwertigen Alkoholen einer OH-Funktionalität ≥ 2, bevorzugt 1,4-Butandiol, 1,6-Hexandiol und/oder 3-Methylpentandiol, oder auch Polyesterpolyole können zu Polycarbonatpolyolen umgearbeitet werden.

Solche Polycarbonatpolyole haben bevorzugt zahlenmittlere Molmassen von 400 bis 4000 g/Mol, besonders bevorzugt von 500 bis 2000 g/Mol. Die OH-Funktionalität dieser Polyole beträgt bevorzugt 1.8 bis 3.2, besonders bevorzugt 1.9 bis 3.0.

Geeignete Polyetherpolyole sind gegebenenfalls blockweise aufgebaute Polyadditionsprodukte cyclischer Ether an OH- oder NH-funktionelle Startermoleküle.

Geeignete cyclische Ether sind beispielsweise Styroloxide, Ethylenoxid, Propylenoxid, Tetrahydrofuran, Butylenoxid, Epichlorhydrin, sowie ihre beliebigen Mischungen.

Als Starter können die an sich im Rahmen der Polyesterpolyole genannten mehrwertigen Alkohole einer OH-Funktionalität ≥ 2 sowie primäre oder sekundäre Amine und Aminoalkohole verwendet werden.

Bevorzugte Polyetherpolyole sind solche der vorgenannten Art ausschließlich basierend auf Propylenoxid oder statistische oder Block-Copolymere basierend auf Propylenoxid mit weiteren 1-Alkylenoxiden, wobei der 1-Alykenoxidanteil nicht höher als 80 Gew.-% ist. Besonders bevorzugt sind Propylenoxid-homopolymere sowie statistische oder Block-Copolymere, die Oxyethylen-, Oxypropylen- und/oder Oxybutyleneinheiten aufweisen, wobei der Anteil der Oxypropyleneinheiten bezogen auf die Gesamtmenge aller Oxyethylen-, Oxypropylen- und Oxybutyleneinheiten mindestens 20 Gew.-%, bevorzugt mindestens 45 Gew.-% ausmacht. Oxypropylen- und Oxybutylen umfasst hierbei alle jeweiligen linearen und verzweigten C3- und C4-Isomere.

Solche Polyetherpolyole haben bevorzugt zahlenmittlere Molmassen von 250 bis 10000 g/Mol, besonders bevorzugt von 500 bis 8500 g/Mol und ganz besonders bevorzugt von 600 bis 4500 g/Mol. Die OH-Funktionalität beträgt bevorzugt 1.5 bis 4.0, besonders bevorzugt 1.8 bis 3.1.

Daneben sind als Bestandteile der Polyol-Komponente b) als polyfunktionelle, isocyanatreaktive Verbindungen

auch niedermolekulare, d.h. mit Molekulargewichten kleiner 500 g/mol, kurzkettige, d.h. 2 bis 20 Kohlenstoffatome enthaltende aliphatische, araliphatische oder cycloaliphatische di, tri oder polyfunktionelle Alkohole geeignet.

Dies können beispielsweise sein Ethylenglykol, Diethylenglykol, Triethylenglykol, Tetraethylenglykol, Dipropylenglykol, Tripropylenglykol, 1,2-Propandiol, 1,3-Propandiol, 1,4-Butandiol, Neopentylglykol, 2-Ethyl-2-butylpropandiol, Trimethylpentandiol, stellungsisomere Diethyloctandiole, 1,3-Butylenglykol, Cyclohexandiol, 1,4-Cyclohexandimethanol, 1,6-Hexandiol, 1,2- und 1,4-Cyclohexandiol, hydriertes Bisphenol A (2,2-Bis(4-hydroxy-cyclohexyl)propan), 2,2-Dimethyl-3-hydroxypropionsäure (2,2-dimethyl-3-hydroxypropyl-ester). Beispiele geeigneter Triole sind Trimethylolethan, Trimethylolpropan oder Glycerin. Geeignete höherfunktionelle Alkohole sind Ditrimethylolpropan, Pentaerythrit, Dipentaerythrit oder Sorbit.

Besonders bevorzugt ist, wenn die Polyolkomponente ein difunktioneller Polyether-, Polyester oder ein Polyether-polyester-block-copolyester oder ein Polyether-Polyester-Blockcopolymer mit primären OH-Funktionen ist.

Besonders bevorzugt ist eine Kombination aus Komponenten a) und b) bei der Herstellung der Matrixpolymere bestehend aus Additionsprodukten von Butyrolacton, e-Caprolacton und/oder Methyl-e-caprolacton an Polyetherpolyolen einer Funktionalität von 1,8 bis 3,1 mit zahlenmittleren Molmassen von 200 bis 4000 g/mol in Verbindung mit Isocyanuraten, Uretdionen, Iminooxadiazindionen und/oder anderen Oligomeren basierend auf HDI. Ganz besonders bevorzugt sind Additionsprodukte von e-Caprolacton an Poly(tetrahydrofurane) mit einer Funktionalität von 1,9 bis 2,2 und zahlenmittleren Molmassen von 500 bis 2000 g/mol (insbesondere 600 bis 1400 g/mol), deren zahlenmittlere Gesamtmolmasse von 800 bis 4500 g/Mol, insbesondere von 1000 bis 3000 g/Mol liegt in Verbindung mit Oligomeren, Isocyanuraten und/oder Iminooxadiazindionen basierend auf HDI.

Die eingesetzten Photoinitiatoren sind üblicherweise durch aktinische Strahlung aktivierbare Initiatoren, die eine Polymerisation der entsprechenden polymerisierbaren Gruppen auslösen. Photoinitiatoren sind an sich bekannte, kommerziell vertriebene Verbindungen, wobei zwischen unimolekularen (Typ I) und bimolekularen (Typ II) Initiatoren unterschieden wird. Die Typ-II Photoinitiatoren können insbesondere einen kationischen Farbstoff und einen Coinitiator umfassen. Als Co-Initiatoren können Ammoniumarylborate, wie beispielhaft in EP-A 0223587 beschriebenen, eingesetzt werden. Als Ammoniumarylborat eignen sich beispielsweise Tetrabutylammonium Triphenylhexylborat, Tetrabutylammonium Triphenylbutylborat, Tetrabutylammonium Trinapthylhexylborat, Tetrabutylammonium Tris(4-tert.butyl)-phenylbutylborat, Tetrabutylammonium Tris-(3-fluorphenyl)-hexylborat, Tetramethylammonium Triphenylbenzylborat, Tetra(n-hexyl)-ammonium (sec-Butyl)triphenylborat, 1-Methyl-3-octylimidazolium Dipentyldiphenylborat und Tetrabutylammonium Tris-(3-Chlor-4-methylphenyl)-hexylborat (Cunningham et al., RadTech'98 North America UV/EB Conference Proceedings, Chicago, Apr. 19-22, 1998).

Es kann vorteilhaft sein, Gemische dieser Verbindungen einzusetzen. Je nach zur Härtung verwendeter Strahlungsquelle muss Typ und Konzentration an Photoinitiator in dem Fachmann bekannter Weise angepasst werden. Näheres ist zum Beispiel in P. K. T. Oldring (Ed.), Chemistry & Technology of UV & EB Formulations For Coatings, Inks & Paints, Vol. 3, 1991, SITA Technology, London, S. 61 - 328 beschrieben.

Bevorzugte Photoinitiatoren sind Mischungen aus Tetrabutylammonium Tetrahexylborat, Tetrabutylammonium Triphenylhexylborat, Tetrabutylammonium Tris-(3-fluorphenyl)-hexylborat ([191726-69-9], CGI 7460, Produkt der BASF SE, Basel) und Tetrabutylammonium Tris-(3-Chlor-4-methylphenyl)-hexylborat ([1147315-11-4], CGI 909, Produkt der BASF SE, Basel) mit den erfindungsgemäßen Farbstoffen der Formel $F^+An^-$.

Gemäß einer weiteren bevorzugten Ausführungsform ist vorgesehen, dass die Photopolymer-Formulierung zusätzlich Urethane als Weichmacher enthält, wobei die Urethane insbesondere mit wenigstens einem Fluoratom substituiert sein können.

Bevorzugt können die Urethane die allgemeine Formel (CI)

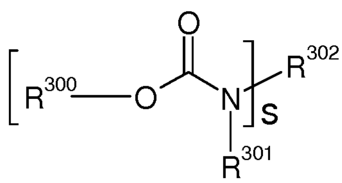

(CI)

haben, in der s≥1 und s≤8 ist und $R^{300}$, $R^{301}$, $R^{302}$ unabhängig voneinander Wasserstoff, lineare, verzweigte, cyclische oder heterocyclische unsubstituierte oder gegebenenfalls auch mit Heteroatomen substituierte organische Reste sind, wobei bevorzugt mindestens einer der Reste $R^{300}$, $R^{301}$, $R^{302}$ mit wenigstens einem Fluoratom substituiert ist und besonders bevorzugt $R^{300}$ ein organischer Rest mit mindestens einem Fluoratom ist. Besonders bevorzugt ist $R^{302}$ ein linearer, verzweigter, cyclischer oder heterocyclischer unsubstituierter oder gegebenenfalls auch mit Heteroatomen wie beispielsweise Fluor substituierter organischer Rest.

Bei einer weiteren bevorzugten Ausführungsform ist vorgesehen, dass das Schreibmonomer wenigstens ein

mono- und / oder ein multifunktionales Schreibmonomer umfasst, wobei es sich insbesondere um mono- und multifunktionelle Acrylat-Schreibmonimere handeln kann. Besonders bevorzugt kann das Schreibmonomer wenigstens ein monofunktionelles und ein multifunktionelles Urethan(meth)acrylat umfassen.

Bei den Acrylat-Schreibmonomeren kann es sich insbesondere um Verbindungen der allgemeinen Formel (CII)

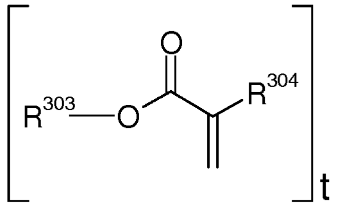

(CII)

handeln, bei denen t≥1 und t≤4 ist und $R^{303}$, $R^{304}$ unabhängig voneinander Wasserstoff, lineare, verzweigte, cyclische oder heterocyclische unsubstituierte oder gegebenenfalls auch mit Heteroatomen substituierte organische Reste sind. Besonders bevorzugt ist $R^{304}$ Wasserstoff oder Methyl und/oder $R^{303}$ ein linearer, verzweigter, cyclischer oder heterocyclischer unsubstituierter oder gegebenenfalls auch mit Heteroatomen substituierter organischer Rest.

Ebenso ist es möglich, dass weitere ungesättigte Verbindungen wie α,β-ungesättigte Carbonsäurederivate wie Acrylate, Methacrylate, Maleinate, Fumarate, Maleimide, Acrylamide, weiterhin Vinylether, Propenylether, Allylether und Dicyclopentadienyl-Einheiten enthaltende Verbindungen sowie olefinisch ungesättigte Verbindungen wie z.B. Styrol, α-Methylstyrol, Vinyltoluol, Olefinine, wie z.B. 1-Octen und/oder 1-Decen, Vinylestern, (Meth)acrylnitril, (Meth)acrylamid, Methacrylsäure, Acrylsäure zugesetzt werden. Bevorzugt sind aber Acrylate und Methacrylate.

Als Acrylate bzw. Methacrylate werden allgemein Ester der Acrylsäure bzw. Methacrylsäure bezeichnet. Beispiele verwendbarer Acrylate und Methacrylate sind Methylacrylat, Methylmethacrylat, Ethylacrylat, Ethylmethacrylat, Ethoxyethylacrylat, Ethoxyethylmethacrylat, n-Butylacrylat, n-Butylmethacrylat, tert.-Butylacrylat, tert.-Butylmethacrylat, Hexylacrylat, Hexylmethacrylat, 2-Ethylhexylacrylat, 2-Ethylhexylmethacrylat, Butoxyethylacrylat, Butoxyethylmethacrylat, Laurylacrylat, Laurylmethacrylat, Isobornylacrylat, Isobornylmethacrylat, Phenylacrylat, Phenylmethacrylat, p-Chlorphenylacrylat, p-Chlorphenylmethacrylat, p-Bromphenylacrylat, p-Bromphenyl-methacrylat, 2,4,6-Trichlorphenylacrylat, 2,4,6-Trichlorphenylmethacrylat, 2,4,6-Tribromphenyl-acrylat, 2,4,6-Tribromphenylmethacrylat, Pentachlorphenylacrylat, Pentachlorphenylmethacrylat, Pentabromphenylacrylat, Pentabromphenylmethacrylat, Pentabrombenzylacrylat, Pentabrombenzylmethacrylat, Phenoxyethylacrylat, Phenoxyethylmethacrylat, Phenoxyethoxyethylacrylat, Phenoxyethoxyethylmethacrylat, Phenylthioethylacrylat, Phenylthioethylmethacrylat, 2-Naphthylacrylat, 2-Naphthylmethacrylat, 1,4-Bis-(2-thionaphthyl)-2-butylacrylat, 1,4-Bis-(2-thionaphthyl)-2-butylmethacrylat, Propan-2,2-diylbis[(2,6-dibrom-4,1-phenylen)oxy(2-{[3,3,3-tris(4-chlorphenyl)-propanoyl]-oxy}propan-3,1-diyl)oxyethan-2,1-diyl]-diacrylat, Bisphenol A Diacrylat, Bisphenol A Dimethacrylat, Tetrabromobisphenol A Diacrylat, Tetrabromobisphenol A Dimethacrylat sowie deren ethoxylierte Analogverbindungen, N-Carbazolylacrylate, um nur eine Auswahl verwendbarer Acrylate und Methacrylate zu nennen.

Selbstverständlich können auch weitere Urethanacrylate verwendet werden. Unter Urethanacrylaten versteht man Verbindungen mit mindestens einer Acrylsäureestergruppe, die zusätzlich über mindestens eine Urethanbindung verfügen. Es ist bekannt, dass solche Verbindungen durch Umsetzung eines Hydroxy-funktionellen Acrylsäureesters mit einer Isocyanat-funktionellen Verbindung erhalten werden können.

Beispiele hierfür verwendbarer Isocyanat-funktionelle Verbindungen sind aromatische, araliphatische, aliphatische und cycloaliphatische Di-, Tri- oder Polyisocyanate. Es können auch Mischungen solcher Di-, Tri- oder Polyisocyanate eingesetzt werden. Beispiele geeigneter Di-, Tri- oder Polyisocyanate sind Butylendiisocyanat, Hexamethylendiisocyanat (HDI), Isophorondiisocyanat (IPDI), 1,8-Diisocyanato-4-(isocyanatomethyl)oktan, 2,2,4- und/oder 2,4,4-Trimethylhexamethylendiisocyanat, die isomeren Bis(4,4'-isocyanatocyclohexyl)methane und deren Mischungen beliebigen Isomerengehalts, Isocyanatomethyl-1,8-octandiisocyanat, 1,4-Cyclohexylendiisocyanat, die isomeren Cyclohexandimethylendiisocyanate, 1,4-Phenylendiisocyanat, 2,4- und/oder 2,6-Toluylendiisocyanat, 1,5-Naphthylendiisocyanat, 2,4'- oder 4,4'-Diphenylmethandiisocyanat, 1,5-Naphthylendiisocyanat, m-Methylthiophenylisocyanat, Triphenylmethan-4,4',4"-triisocyanat und Tris(p-isocyanatophenyl)thiophosphat oder deren Derivate mit Urethan-, Harnstoff-, Carbodiimid-, Acylharnstoff-, Isocyanurat-, Allophanat-, Biuret-, Oxadiazintrion-, Uretdion-, Iminooxadiazindionstruktur und Mischungen derselben. Bevorzugt sind dabei aromatische oder araliphatische Di-, Tri- oder Polyisocyanate.

Als hydroxyfunktionelle Acrylate oder Methacrylate für die Herstellung von Urethanacrylaten kommen beispielsweise Verbindungen in Betracht wie 2-Hydroxyethyl-(meth)acrylat, Polyethylenoxid-mono(meth)acrylate, Polypropylenoxidmono(meth)acrylate, Polyalkylenoxidmono(meth)-acrylate, Poly(ε-caprolacton)mono(meth)acrylate, wie z.B. Tone® M100 (Dow, Schwalbach, DE), 2-Hydroxypropyl(meth)acrylat, 4-Hydroxybutyl-(meth)acrylat, 3-Hydroxy-2,2-dimethylpropyl-(meth)acrylat, Hydroxypropyl(meth)acrylat, Acrylsäure-(2-hydroxy-3-phenoxypropylester), die hydroxyfunktionellen Mono-, Di- oder Tetraacrylate mehrwertiger Alkohole wie Trimethylolpropan, Glycerin, Pentaerythrit, Dipentaerythrit, ethoxyliertes, propoxyliertes oder alkoxyliertes Trimethylolpropan, Glycerin, Pentaerythrit, Dipentaerythrit oder deren technische Gemische. Bevorzugt sind 2-Hydroxyethylacrylat, Hydroxypropylacrylat, 4-Hydroxybutylacrylat und Poly(ε-caprolacton)mono(meth)acrylate. Darüber hinaus sind als isocyanat-reaktive oligomere oder polymere ungesättigte Acrylat- und/oder Methacrylatgruppen enthaltende Verbindungen alleine oder in Kombination mit den vorgenannten monomeren Verbindungen geeignet. Ebenfalls verwendet werden können die an sich bekannten hydroxylgruppenhaltigen Epoxy-(meth)acrylate mit OH-Gehalten von 20 bis 300 mg KOH/g oder hydroxylgruppenhaltige Polyurethan(meth)acrylate mit OH-Gehalten von 20 bis 300 mg KOH/g oder acrylierte Polyacrylate mit OH-Gehalten von 20 bis 300 mg KOH/g sowie deren Mischungen untereinander und Mischungen mit hydroxylgruppenhaltigen ungesättigten Polyestern sowie Mischungen mit Polyester(meth)acrylaten oder Mischungen hydroxylgruppenhaltiger ungesättigter Polyester mit Polyester(meth)acrylaten.

Bevorzugt sind insbesondere Urethanacrylate erhältlich aus der Umsetzung von Tris(p-isocyanatophenyl)thiophosphat und m-Methylthiophenylisocyanat mit alkoholfunktionellen Acrylaten wie Hydroxyethyl(meth)acrylat, Hydroxypropyl(meth)acrylat und Hydroxybutyl(meth)acrylat.

Gegenstand der Erfindung ist auch ein holographisches Medium, enthaltend eine erfindungsgemäße Photopolymer-Formulierung oder erhältlich unter Verwendung einer erfindungsgemäßen Photopolymer-Formulierung. Noch ein weiterer Gegenstand der Erfindung ist die Verwendung einer erfindungsgemäßen Photopolymer-Formulierung zur Herstellung holographischer Medien.

Die erfindungsgemäßen holographischen Medien können durch entsprechende Belichtungsprozesse für optische Anwendungen im gesamten sichtbaren und nahen UV-Bereich (300-800 nm) zu Hologrammen verarbeitet werden können. Visuelle Hologramme umfassen alle Hologramme, die nach dem Fachmann bekannten Verfahren aufgezeichnet werden können. Darunter fallen unter anderem In-Line (Gabor) Hologramme, Off-Axis Hologramme, Full-Aperture Transfer Hologramme, Weißlicht-Transmissionshologramme ("Regenbogenhologramme), Denisyukhologramme, Off-Axis Reflektionshologramme, Edge-Lit Hologramme sowie holographische Stereogramme. Bevorzugt sind Reflexionshologramme, Denisyukhologramme, Transmissionshologramme.

Mögliche optische Funktionen der Hologramme, die mit den erfindungsgemäßen Photopolymer-Formulierungen hergestellt werden können entsprechen den optische Funktionen von Lichtelementen wie Linsen, Spiegel, Umlenkspiegel, Filter, Streuscheiben, Beugungselemente, Lichtleiter, Lichtlenker (waveguides), Projektionsscheiben und/oder Masken. Häufig zeigen diese optischen Elemente eine Frequenzselektivität, je nachdem wie die Hologramme belichtet wurden und welche Dimensionen das Hologramm hat.

Zudem können mittels der erfindungsgemäßen Photopolymer-Formulierungen auch holographische Bilder oder Darstellungen hergestellt werden, wie zum Beispiel für persönliche Portraits, biometrische Darstellungen in Sicherheitsdokumenten, oder allgemein von Bilder oder Bildstrukturen für Werbung, Sicherheitslabels, Markenschutz, Markenbranding, Etiketten, Designelementen, Dekorationen, Illustrationen, Sammelkarten, Bilder und dergleichen sowie Bilder, die digitale Daten repräsentieren können u.a. auch in Kombination mit den zuvor dargestellten Produkten. Holographische Bilder können den Eindruck eines dreidimensionalen Bildes haben, sie können aber auch Bildsequenzen, kurze Filme oder eine Anzahl von verschiedenen Objekten darstellen, je nachdem aus welchem Winkel, mit welcher (auch bewegten) Lichtquelle etc. diese beleuchtet wird. Aufgrund dieser vielfältigen Designmöglichkeiten stellen Hologramme, insbesondere Volumenhologramme, eine attraktive technische Lösung für die oben genannten Anwendung dar.

Die Photopolymere-Formulierungen können insbesondere zur Herstellung holographischer Medien in Form eines Films verwendet werden. Dabei wird als Träger eine Lage eines für Licht im sichtbaren Spektralbereich (Transmission größer als 85% im Wellenlängenbereich von 400 bis 780 nm) transparenten Materials oder Materialverbunds ein- oder beidseitig beschichtet sowie ggf. eine Abdeckschicht auf der oder den Photopolymerlagen appliziert.

Bevorzugte Materialien oder Materialverbünde des Trägers basieren auf Polycarbonat (PC), Polyethylenterephthalat (PET), Polybutylenterephthalat, Polyethylen, Polypropylen, Celluloseacetat, Cellulosehydrat, Cellulosenitrat, Cycloolefinpolymere, Polystyrol, Polyepoxide, Polysulfon, Cellulosetriacetat (CTA), Polyamid, Polymethylmethacrylat, Polyvinylchlorid, Polyvinylbutyral oder Polydicyclopentadien oder deren Mischungen. Besonders bevorzugt basieren sie auf PC, PET und CTA. Materialverbünde können Folienlaminate oder Coextrudate sein. Bevorzugte Materialverbünde sind Duplex- und Triplexfolien aufgebaut nach einem der Schemata A/B, A/B/A oder A/B/C. Besonders bevorzugt sind PC/PET, PET/PC/PET und PC/TPU (TPU = Thermoplastisches Polyurethan).

Alternativ zu den vorgenannten Kunststoffträgern können auch planare Glasplatten eingesetzt werden, die insbesondere für großflächige abbildungsgenaue Belichtungen Verwendung finden, z.B. für holographische Lithographie (Holographic interference lithography for integrated optics. IEEE Transactions on Electron Devices (1978), ED-25(10), 1193-1200, ISSN:0018-9383).

Die Materialien oder Materialverbünde des Trägers können einseitig oder beidseitig antihaftend, antistatisch, hydrophobiert oder hydrophiliert ausgerüstet sein. Die genannten Modifikationen dienen an der Photopolymerschicht zugewandten Seite dem Zweck, dass die Photopolymerlage von dem Träger zerstörungsfrei abgelöst werden kann. Eine Modifikation der der Photopolymerlage abgewandten Seite des Trägers dient dazu, dass die erfindungsgemäßen

Medien speziellen mechanischen Anforderungen genügen, die z.B. bei der Verarbeitung in Rollenlaminatoren, insbesondere bei Rolle-zu-Rolle-Verfahren, gefordert sind.

Ein weiterer Gegenstand der vorliegenden Erfindung ist ein Farbstoff der der Formel $F^+An^-$, in der $F^+$ für einen kationischen Farbstoff und $An^-$ für ein Anion steht und bei dem das Anion $An^-$ ausgewählt aus der Gruppe Sec-alkylbenzolsulfonate, verzweigte Alkylsulfate, n-Alkylsulfate, Sec-Alkylsulfonate, Sulfosuccinate, Ester-sulfate und -sulfonate ist. Beonsders bevorzugt ist hier, wenn der kationische Farbstoff $F^+$ aus der Gruppe der Acridin-, Xanthen-, Thioxanthen-, Phenazin-, Phenoxazin-, Phenothiazin-, Tri(het)arylmethan-, insbesondere Diamino- und Triamino(het)arylmethan-, Mono-, Di- und Trimethincyanin-, Hemicyanin-, extern kationische Merocyanin-, extern kationische Neutrocyanin-, Nullmethin-, insbesondere Naphtholactam- und Streptocyanin-Farbstoffe ausgewählt ist.

## Beispiele

Die Erfindung wird im Folgenden näher anhand von Beispielen näher erläutert.

## Messmethoden:

Die angegebenen OH-Zahlen wurden gemäß DIN 53240-2 bestimmt.

Die angegebenen NCO-Werte (Isocyanat-Gehalte) wurden gemäß DIN EN ISO 11909 bestimmt.

Die angegebenen Wassergehalte (KF) aus Lösung wurden gemäß DIN 51777 bestimmt.

Die Bestimmung des Gehaltes an 2-Hydroxyethylacrylat (HEA) wird in Anlehnung an DIN/ISO 10283 (2007) durchgeführt. 1.41 g Anthracen (Kalibriersubstanz) als interne Standardsubstanz werden in einem 1 Liter Messkolben eingewogen und mit Ethylacetat aufgefüllt. Ca. 1 g Probe wird eingewogen und mit 10 mL der wie oben beschrieben hergestellten Lösung des internen Standards und 10 mL Ethylacetat versetzt, davon werden 2.0 μL gaschromatographisch aufgetrennt und der Gehalt an HEA flächenkorrigiert in Gew.-% berechnet.

Die Wasseraufnahme der Beispiele wurde bestimmt, indem zunächst jeweils 5-10 g der Farbstoffe in einer offenen Glasschale bei einem Druck von 200 mbar und einer Temperatur von 50 °C bis zur Massenkonstanz getrocknet wurden. Gewogen wurde dabei nach Entnahme aus dem Vakuumtrockenschrank, nachdem die Proben unter Feuchtigkeitsausschluss während 60 min auf Raumtemperatur abkühlen konnten. Zum Ausschluss von Feuchtigkeit vor der Wägung wurden die Glasschalen mit Parafilm M® (Pechiney Plastic Packaging, Chicago, IL 60631, USA, www.parafilm.com) luftdicht verschlossen. und dann gewogen wurden. Anschließend wurde 7 Tage an der Luft bei Raumtemperatur (22 °C) und einer relativen Luftfeuchtigkeit von 90 % bis zur Massenkonstanz stehen gelassen und gewogen. Die Wasseraufnahme ergab sich dann aus der Formel (F-1)

$$W = (m_f/m_t - 1)*100\% \quad \text{(F-1)},$$

worin $m_f$ die Masse des Farbstoffs nach Wassersättigung und $m_t$ die Masse des getrockneten Farbstoffs sind.

Messung des Plateaumoduls $G_0$ des Matrixnetzwerkes der Photopolymeren mittels eines Oszillationsrheometers im Rahmen der vorliegenden Erfindung

Zur Herstellung der Photopolymerformulierung zur Bestimmung des Plateaumoduls $G_0$ des Matrixnetzwerkes werden die Schreibmonomere sowie Additive, die isocyanatreaktive Komponente und die Farbstofflösung zusammengegeben und im Speedmixer 5 Minuten gemischt. Die Farbstoff wurde vorher in N-Ethylpyrrolidon gelöst. Dann wird Isocyanat zugegeben und im Speedmixer 1 Minute gemischt. Im Folgenden wird eine Lösung des Katalysators in N-Ethylpyrrolidon zugegeben und im Speedmixer erneut 1 Minute gemischt. Die Konzentration des Katalysators in N-Ethylpyrrolidon beträgt 10 Gewichtsprozent.

Die noch flüssige Formulierung wird dann in das Platte - Platte Messsystem eines Rheometers (Firma Anton Paar Physica Modell MCR 301 ausgerüstet mit dem Ofenmodel CTD 450 der auf 80°C vorgeheizt war) eingebracht. Dann wird die Aushärtung der Matrix der Photopolymerformulierung über die Zeit unter folgenden Bedingungen gemessen:

- Plattenabstand 250μm.
- Messmodus Oszillation bei einer konstanten Kreisfrequenz $\omega_0$ von 10 rad/s und einer geregelten Deformationsamplitude von 1%.
- Temperatur 80°C, Normalkraftregelung auf 0 Newton eingestellt
- Aufzeichnung des Speichermoduls G' über der Messzeit für höchstens 2 Stunden oder bis ein konstanter Wert $G_{max}$

von G' erreicht wurde. Dieser Wert wird dann als Plateaumodul $G_0$ des Matrixnetzwerkes der Photopolymeren genommen.

Figur 3 zeigt den Verlauf der Aushärtung des Matrixnetzwerkes als Darstellung des Speichermoduls G' über der Härtezeit.

Der Plateaumodul $G_0$ kann nach (M. Doi, S.F. Edwards, The Theory of Polymer Dynamics, Oxford Science Publications, 1986) mit dem mittleren Molekulargewicht $M_c$ der zwei Polymerstränge verbrückenden Segmente wie folgt in Beziehung gesetzt werden.

$$G_0 = \frac{\rho \cdot R \cdot T}{M_C}$$

R ist die Avogadro Konstante, T die absolute Temperatur in Kelvin und p die Massendichte. Ein kleiner Plateaumodul $G_0$ oder ein großes mittleres Molekulargewicht Mc der zwei Polymerstränge verbrückenden Segmente charakterisieren ein Netzwerk mit geringer Vernetzungsdichte.

Bei fester Zusammensetzung der Photopolymerformulierung zeigt daher ein erniedrigter Plateaumodul $G_0$ eine unvollständige Vernetzung des Matrixpolymeren an.

Messung der holographischen Eigenschaften DE und $\Delta$n der holographischen Medien mittels Zweistrahlinterferenz in Reflexionsanordnung.

Mit einem holographischen Versuchsaufbau wie in Figur 1 dargestellt, wurden die Beugungseffizienz (DE) der Medien gemessen. Der Strahl eines He-Ne Lasers (Emissionswellenlänge 633 nm) wurde mit Hilfe des Raumfilter (SF) und zusammen mit der Kollimationslinse (CL) in einen parallelen homogenen Strahl umgewandelt. Die finalen Querschnitte des Signal und Referenzstrahls werden durch die Irisblenden (I) festgelegt. Der Durchmesser der Irisblendenöffnung beträgt 0.4 cm. Die polarisationsabhängigen Strahlteiler (PBS) teilen den Laserstrahl in zwei kohärente gleich polarisierte Strahlen. Über die $\lambda/2$ Plättchen wurden die Leistung des Referenzstrahls auf 0.5 mW und die Leistung des Signalstrahls auf 0.65 mW eingestellt. Die Leistungen wurden mit den Halbleiterdetektoren (D) bei ausgebauter Probe bestimmt. Der Einfallswinkel ($\alpha_0$) des Referenzstrahls beträgt - 21.8°, der Einfallswinkel ($\beta_0$) des Signalstrahls beträgt 41.8°. Die Winkel werden ausgehend von der Probennormale zur Strahlrichtung gemessen. Gemäß Figur 1 hat daher $\alpha_0$ ein negatives Vorzeichen und $\beta_0$ ein positives Vorzeichen. Am Ort der Probe (Medium) erzeugte das Interferenzfeld der zwei überlappenden Strahlen ein Gitter heller und dunkler Streifen die senkrecht zur Winkelhalbierenden der zwei auf die Probe einfallenden Strahlen liegen (Reflexionshologramm). Der Streifenabstand A, auch Gitterperiode genannt, im Medium beträgt ~225 nm (der Brechungsindex des Mediums zu -1.504 angenommen).

Figur 1 zeigt die Geometrie eines Holographie Media Testers (HMT) bei $\lambda$ = 633 nm (He-Ne Laser): M = Spiegel, S = Verschluss, SF = Raumfilter, CL = Kollimatorlinse, $\lambda/2$ = $\lambda/2$ Platte, PBS = polarisationsempfindlicher Strahlteiler, D = Detektor, I = Irisblende, $\alpha_0$ = - 21.8°, $\beta_0$ = 41.8° sind die Einfallswinkel der kohärenten Strahlen außerhalb der Probe (des Mediums) gemessen. RD = Referenzrichtung des Drehtisches.

Es wurden auf folgende Weise Hologramme in das Medium geschrieben:

- Beide Shutter (S) sind für die Belichtungszeit *t* geöffnet.
- Danach wurde bei geschlossenen Shuttern (S) dem Medium 5 Minuten Zeit für die Diffusion der noch nicht polymerisierten Schreibmonomere gelassen.

Die geschriebenen Hologramme wurden nun auf folgende Weise ausgelesen. Der Shutter des Signalstrahls blieb geschlossen. Der Shutter des Referenzstrahls war geöffnet. Die Irisblende des Referenzstrahls wurde auf einen Durchmesser < 1 mm geschlossen. Damit erreichte man, dass für alle Drehwinkel ($\Omega$) des Mediums der Strahl immer vollständig im zuvor geschriebenen Hologramm lag. Der Drehtisch überstrich nun computergesteuert den Winkelbereich von $\Omega_{min}$ bis $\Omega_{max}$ mit einer Winkelschrittweite von 0.05°. $\Omega$ wird von der Probennormale zur Referenzrichtung des Drehtisches gemessen. Die Referenzrichtung des Drehtisches ergibt sich dann wenn beim Schreiben des Hologramms der Einfallswinkel des Referenz- und des Signalstrahls betragsmäßig gleich sind also ao = -31.8° und $\beta_0$ = 31.8° gilt. Dann beträgt $\Omega_{recording}$ = 0°. Für ao = -21.8° und $\beta_0$ = 41.8° beträgt $\Omega_{recording}$ daher 10°. Allgemein gilt für das Interferenzfeld beim Schreiben ("recording") des Hologramms:

$$\alpha_0 = \theta_0 + \Omega_{recording}.$$

$\theta_0$ ist der Halbwinkel im Laborsystem außerhalb des Mediums und es gilt beim Schreiben des Hologramms:

$$\theta_0 = \frac{\alpha_0 - \beta_0}{2}.$$

In diesem Fall gilt also $\theta_0$ = -31.8°. An jedem angefahrenen Drehwinkel $\Omega$ wurden die Leistungen des in der nullten Ordnung transmittierten Strahls mittels des entsprechenden Detektors D und die Leistungen des in die erste Ordnung abgebeugten Strahls mittels des Detektors D gemessen. Die Beugungseffizienz ergab sich bei jedem angefahrenen Winkel $\Omega$ als der Quotient aus:

$$\eta = \frac{P_D}{P_D + P_T}$$

$P_D$ ist die Leistung im Detektor des abgebeugten Strahls und $P_T$ ist die Leistung im Detektor des transmittierten Strahls.

Mittels des oben beschriebenen Verfahrens wurde die Braggkurve, sie beschreibt den Beugungswirkungsgrad $\eta$ in Abhängigkeit des Drehwinkels $\Omega$, des geschriebenen Hologramms gemessen und in einem Computer gespeichert. Zusätzlich wurde auch die in die nullte Ordnung transmittierte Intensität gegen den Drehwinkel $\Omega$ aufgezeichnet und in einem Computer gespeichert.

Die maximale Beugungseffizienz (DE = $\eta_{max}$) des Hologramms, also sein Spitzenwert, wurde bei $\Omega_{reconstruction}$ ermittelt. Eventuell musste dazu die Position des Detektors des abgebeugten Strahls verändert werden, um diesen maximalen Wert zu bestimmen.

Der Brechungsindexkontrast $\Delta n$ und die Dicke *d* der Photopolymerschicht wurde nun mittels der Coupled Wave Theorie (siehe; H. Kogelnik, The Bell System Technical Journal, Volume 48, November 1969, Number 9 Seite 2909 - Seite 2947) an die gemessene Braggkurve und den Winkelverlauf der transmittierten Intensität ermittelt. Dabei ist zu beachten, dass wegen der durch die Photopolymerisation auftretenden Dickenschwindung der Streifenabstand $\Lambda'$ des Hologramms und die Orientierung der Streifen (slant) vom Streifenabstand $\Lambda$ des Interferenzmusters und dessen Orientierung abweichen kann. Demnach wird auch der Winkel $\alpha_0'$ bzw. der entsprechende Winkel des Drehtisches $\Omega_{reconstruction}$, bei dem maximale Beugungseffizienz erreicht wird von $\alpha_0$ bzw. vom entsprechenden $\Omega_{recording}$ abweichen. Dadurch verändert sich die Bragg-Bedingung. Diese Veränderung wird im Auswerteverfahren berücksichtigt. Das Auswerteverfahren wird im Folgenden beschrieben:
Alle geometrischen Größen, die sich auf das geschriebene Hologramm beziehen und nicht auf das Interferenzmuster werden als gestrichene Größen dargestellt.

Für die Braggkurve $\eta(\Omega)$ eines Reflexionshologramms gilt nach Kogelnik:

$$\eta = \begin{cases} \dfrac{1}{1 - \dfrac{1-(\xi/\nu)^2}{\sin^2\left(\sqrt{\xi^2 - \nu^2}\right)}}, \text{für } \nu^2 - \xi^2 < 0 \\ \dfrac{1}{1 + \dfrac{1-(\xi/\nu)^2}{\sinh^2\left(\sqrt{\nu^2 - \xi^2}\right)}}, \text{für } \nu^2 - \xi^2 \geq 0 \end{cases}$$

mit:

$$\nu = \frac{\pi \cdot \Delta n \cdot d'}{\lambda \cdot \sqrt{|c_s \cdot c_r|}}$$

$$\xi = -\frac{d'}{2 \cdot c_s} \cdot DP$$

$$c_s = \cos(\vartheta') - \cos(\psi') \cdot \frac{\lambda}{n \cdot \Lambda'}$$

$$c_r = \cos(\vartheta')$$

$$DP = \frac{\pi}{\Lambda'} \cdot \left( 2 \cdot \cos(\psi' - \vartheta') - \frac{\lambda}{n \cdot \Lambda'} \right)$$

$$\psi' = \frac{\beta' + \alpha'}{2}$$

$$\Lambda' = \frac{\lambda}{2 \cdot n \cdot \cos(\psi' - \alpha')}$$

Beim Auslesen des Hologramms ("reconstruction") gilt wie analog oben dargestellt:

$$\vartheta'_0 = \theta_0 + \Omega$$

$$\sin(\vartheta'_0) = n \cdot \sin(\vartheta')$$

An der Bragg-Bedingung ist das "Dephasing" *DP* = 0. Und es folgt entsprechend:

$$\alpha'_0 = \theta_0 + \Omega_{reconstruction}$$

$$\sin(\alpha'_0) = n \cdot \sin(\alpha')$$

Der noch unbekannt Winkel β' kann aus dem Vergleich der Bragg-Bedingung des Interferenzfeldes beim Schreiben des Hologramms und der Bragg-Bedingung beim Auslesen des Hologramms ermittelt werden unter der Annahme, dass nur Dickenschwindung stattfindet. Dann folgt:

$$\sin(\beta') = \frac{1}{n} \cdot \left[ \sin(\alpha_0) + \sin(\beta_0) - \sin(\theta_0 + \Omega_{reconstruction}) \right]$$

ν ist die Gitterstärke, ξ ist der Detuning Parameter und ψ" die Orientierung (Slant) des Brechungsindexgitters das geschrieben wurde. α' und β' entsprechen den Winkeln $\alpha_0$ und $\beta_0$ des Interferenzfeldes beim Schreiben des Hologramms, aber im Medium gemessen und für das Gitter des Hologramms gültig (nach Dickenschwindung). n ist der mittlere Brechungsindex des Photopolymers und wurde zu 1.504 gesetzt. λ ist die Wellenlänge des Laserlichts im Vakuum.

Die maximale Beugungseffizienz (DE = $\eta_{max}$ ergibt sich dann für ξ = 0 zu:

$$DE = \tanh^2(\nu) = \tanh^2\left( \frac{\pi \cdot \Delta n \cdot d'}{\lambda \cdot \sqrt{\cos(\alpha') \cdot \cos(\alpha' - 2\psi)}} \right)$$

Figur 1 zeigt die gemessene transmittierte Leistung $P_T$ (rechte *y*-Achse) als durchgezogene Linie gegen das Winkeldetuning ΔΩ aufgetragen, die gemessene Beugungseffizienz η (linke *y*-Achse) als ausgefüllte Kreise gegen das Winkeldetuning ΔΩ aufgetragen (soweit die endliche Größe des Detektors es erlaubte) und die Anpassung der Kogelnik Theorie als gestrichelte Linie (linke *y*-Achse).

Die Messdaten der Beugungseffizienz, die theoretische Braggkurve und die transmittierte Intensität werden wie in Figur 2 gezeigt gegen den zentrierten Drehwinkel $\Delta\Omega \equiv \Omega_{reconstruction} - \Omega = \alpha'_0 - \vartheta'_0$, auch Winkeldetuning genannt, aufgetragen.

Da DE bekannt ist wird die Form der theoretischen Braggkurve nach Kogelnik nur noch durch die Dicke *d*' der

Photopolymerschicht bestimmt. Δn wird über DE für gegebene Dicke *d'* so nachkorrigiert, dass Messung und Theorie von DE immer übereinstimmen. *d'* wird nun solange angepasst bis die Winkelpositionen der ersten Nebenminima der theoretischen Braggkurve mit den Winkelpositionen der ersten Nebenmaxima der transmittierten Intensität übereinstimmen und zudem die volle Breite bei halber Höhe (FWHM) für die theoretische Braggkurve und für die transmittierte Intensität übereinstimmen.

Da die Richtung in der ein Reflexionshologramm bei der Rekonstruktion mittels eines Ω-Scans mitrotiert, der Detektor für das abgebeugte Licht aber nur einen endlichen Winkelbereich erfassen kann, wird die Braggkurve von breiten Holgrammen (kleines *d'*) bei einem Ω-Scan nicht vollständig erfasst, sondern nur der zentrale Bereich, bei geeigneter Detektorpositionierung. Daher wird die zur Braggkurve komplementäre Form der transmittierten Intensität zur Anpassung der Schichtdicke *d'* zusätzlich herangezogen.

Figur 2 zeigt die Darstellung der Braggkurve η nach der Coupled Wave Theorie (gestrichelte Linie), des gemessenen Beugungswirkungsgrades (ausgefüllte Kreise) und der transmittierten Leistung (schwarz durchgezogene Linie) gegen das Winkeldetuning ΔΩ.

Für eine Formulierung wurde diese Prozedur eventuell mehrfach für verschiedene Belichtungszeiten t an verschiedenen Medien wiederholt, um festzustellen bei welcher mittleren Energiedosis des einfallenden Laserstrahls beim Schreiben des Hologramms DE in den Sättigungswert übergeht. Die mittlere Energiedosis *E* ergibt sich wie folgt aus den Leistungen der zwei den Winkeln ao und $\beta_0$ zugeordneten Teilstrahlen (Referenzstrahl mit $P_r$ = 0.50 mW und Signalstrahl mit $P_s$ = 0.63 mW), der Belichtungszeit t und dem Durchmesser der Irisblende (0.4 cm):

$$E\,(\mathrm{mJ/cm^2}) = \frac{2\cdot[P_r + P_s]\cdot t\,(\mathrm{s})}{\pi\cdot 0.4^2\ \mathrm{cm}^2}$$

Die Leistungen der Teilstrahlen wurden so angepasst, dass in dem Medium bei den verwendeten Winkeln $\alpha_0$ und $\beta_0$, die gleiche Leistungsdichte erreicht wird.

Als Alternative I wurde auch ein dem in Abbildung 1 dargestellten Aufbau äquivalenter Test mit einem grünen Laser mit der Emissionswellenlänge λ im Vakuum von 532 nm durchgeführt. Dabei beträgt ao = -11.5° und $\beta_0$ = 33.5° und $P_r$ = 1.84 mW und $P_s$ = 2.16 mW.

Als Alternative II wurde auch ein dem in Abbildung 1 dargestellten Aufbau äquivalenter Test mit einem blauen Laser mit der Emissionswellenlänge λ im Vakuum von 473 nm durchgeführt. Dabei beträgt ao = -22.0° und $\beta_0$ = 42.0° und $P_r$ = 1.78 mW und $P_s$ = 2.22 mW.

**Substanzen:**

Die verwendeten Farbstoffe, Salze sowie Lösungsmittel und Reagenzien wurden im Chemikalienhandel bezogen.

| | |
|---|---|
| CGI-909 | Tetrabutylammonium-tris(3-chlor-4-methylphenyl)(hexyl)borat, [1147315-11-4] ist ein von der BASF SE, Basel, Schweiz, hergestelltes Produkt. |
| Desmorapid Z | Dibutylzinn-dilaurat [77-58-7], Produkt der Bayer MaterialScience AG, Leverkusen, Deutschland. |
| Desmodur® N 3900 | Produkt der Bayer MaterialScience AG, Leverkusen, DE, Hexandiisocyanat-basiertes Polyisocyanat, Anteil an Iminooxadiazindion mindestens 30 %, NCO-Gehalt: 23.5 %. |
| Fomrez UL 28 | Urethanisierungskatalysator, Handelsprodukt der Momentive Performance Chemicals, Wilton, CT, USA. |
| Safranin O bzw. T | Es wurde gefunden, dass das käufliche Safranin O/T aus sechs farbigen Komponenten besteht. Drei davon konnten aufgeklärt werden: |

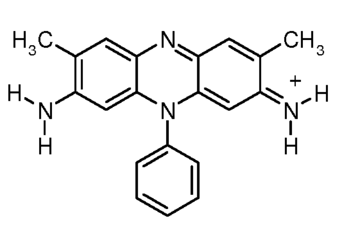

75-80%

+

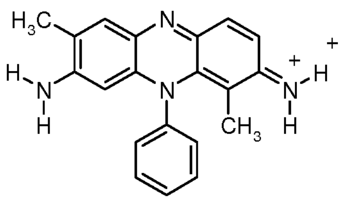

8-10%

+

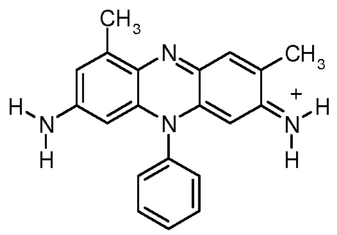

8-10%

Die vierte ist ein weiteres Isomeres mit 2 Methylgruppen. Für die beiden anderen sind nach Massenspektrum die Strukturen

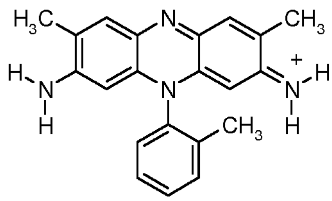

und

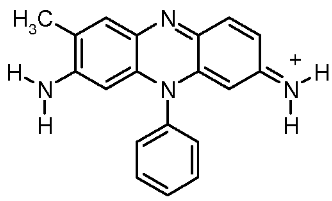

oder Isomere davon plausibel. Der Einfachheit halber wird im Folgenden, wenn Safranin O eingesetzt wird, nur die Formel des Hauptkomponente angegeben. Gemeint ist damit aber stets die Mischung aller sechs Komponenten - auch in Kombination mit den erfindungsgemäßen Anionen.

**Beispiel 1**

3,00 g Safranin O, das einer Mischung mit dem Farbstoff der Formel

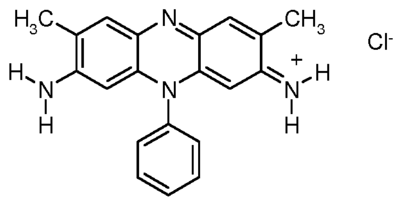

als Hauptkomponente entspricht (2010 bezogen von Chemos GmbH, Deutschland, Art.-Nr. 1308), wurden in einer Mischung aus 20 ml Methanol und 30 ml Wasser gelöst. Eine Lösung von 2,98 g Natrium-4-(sec-dodecyl)benzolsulfonat (Mischung mit den fünf verschiedenen sec-Dodecyl-Resten) wurde hergestellt aus 3,10 g 4-(sec-Dodecyl)benzolsulfonsäure 90-proz. (2010 bezogen von Fluka, Art.-Nr. 44198) durch Neutralisation einer Lösung in 50 ml Wasser mit 1M Natronlauge. Diese Lösung wurde während 30 min unter gutem Rühren bei Raumtemperatur zu der Farbstofflösung getropft. Während 30 min wurden 100 ml Wasser zugetropft. Die rote Suspension wurde 5 h bei Raumtemperatur gerührt, abgesaugt, mit 200 ml Wasser in Portionen gewaschen und bei 50 °C im Vakuum getrocknet. Man erhielt 5,99 g (91,2 % d. Th.) eines Gemischs als rotes Pulver, das in einer Formel (Farbstoff: Hauptkomponente, Anion: idealisiert)

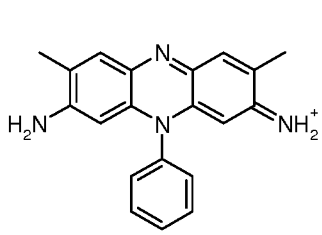

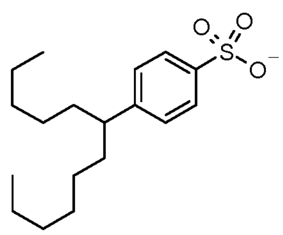

entspricht.

$\lambda_{max}$ in Methanol: 528 nm.
Geeignete Laserwellenlänge: 532 nm.

**Beispiel 2**

5,00 g des Farbstoffs der Formel

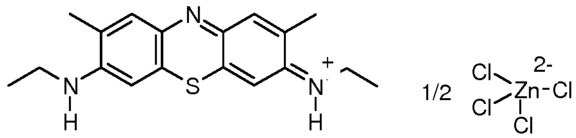

,

(New Methylene Blue, bezogen von in 2008 TCI Europe b.v.) wurden in einer Mischung aus 60 ml Wasser und 10 ml Eisessig gelöst. Diese Lösung wurde mit 100 ml Wasser und 20 ml Methanol verdünnt. 5,44 g einer 50 proz. Lösung von Natrium-2-ethylhexylsulfat (2009 bezogen von Aldrich) wurden mit 17 ml Wasser verdünnt. Diese Lösung wurde bei Raumtemperatur unter gutem Rühren während 60 min zu der Farbstofflösung getropft. Man erhielt eine Suspension, die noch 2 h nachgerührt wurde. Dann wurde abgesaugt und mit 200 ml Wasser in Portionen gewaschen. Nach dem Trocknen bei 50 °C im Vakuum erhielt man 4,85 g (79,4 % d. Th.) eines blauen Pulvers der Formel

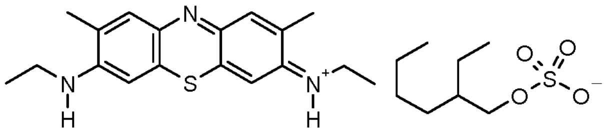

.

$\lambda_{max}$ in Methanol: 625 nm.
Geeignete Laserwellenlänge: 633 nm.

**Beispiel 3**

3,00 g des Farbstoffs der Formel

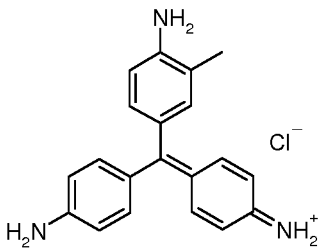

,

(Fuchsin, 2009 bezogen von Alfa-Aesar) wurden in 70 ml Methanol gelöst. 2,56 g Natriumdodecylsulfat (2009 bezogen von Applichem) wurden in 25 ml Wasser gelöst. Diese Lösung wurde unter gutem Rühren bei Raumtemperatur während 30 min zur Farbstofflösung getropft. Man erheilt eine tief rotviolette Lösung, die durch langsame Zugabe von insgesamt 40 ml Wasser während 5 h gefällt wurde. Es wurde abgesaugt, mit 60 ml einer 1:1-Mischung aus Wasser und Methanol und schließlich mit 150 ml Wasser gewaschen. Nach dem Trocknen bei 50 °C im Vakuum erhielt man 3,38 g (67,0 % d. Th.) eines violetten Pulvers der Formel

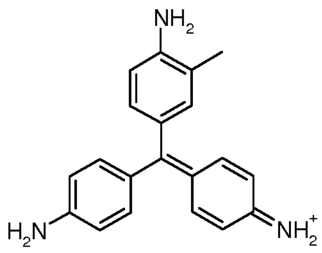 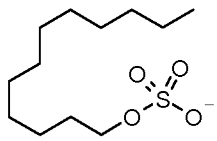 .

$\lambda_{max}$ in Methanol: 551 nm.
Geeignete Laserwellenlänge: 532 nm.

**Beispiel 4**

2,00 g Safranin O (Lieferquelle siehe Beispiel 1), das einer Mischung mit dem Farbstoff der Formel

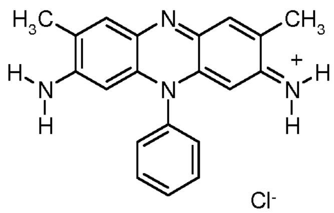

als Hauptkomponente entspricht, wurden in 60 ml Acetonitril bei 50 °C gelöst. 4,96 g des Triethylammoniumsalzes der Formel

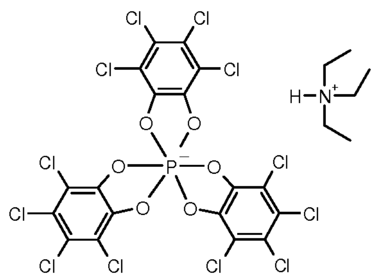 ,

hergestellt gemäß J. Org. Chem. 2004, 69, 8521-8524, wurden in 30 ml Acetonitril bei 50 °C gelöst. Diese Lösung wurde während 10 min bei 50 °C unter gutem Rühren zur Farbstofflösung getropft. Es wurde auf Raumtemperatur abgekühlt und mit 150 ml Wasser ausgefällt. Die rote Suspension wurde abgesaugt, mit 150 ml Wasser portionsweise gewaschen und bei 50 °C im Vakuum getrocknet. Man erhielt 5,34 g (86,3 % d. Th.) eines roten Pulvers der Formel

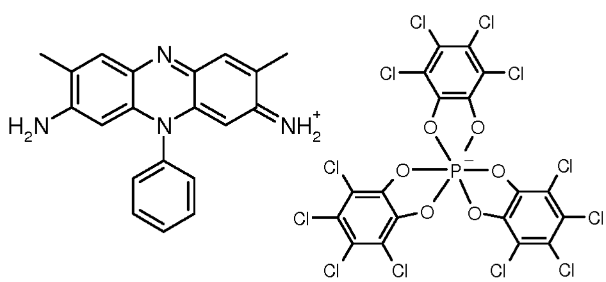 .

$\lambda_{max}$ in Methanol: 528 nm.
Geeignete Laserwellenlänge: 532 nm.

**Beispiel 5**

2,00 g Safranin O (Lieferquelle siehe Beispiel 1), das einer Mischung mit dem Farbstoff der Formel

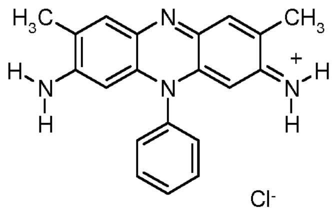

als Hauptkomponente entspricht, wurden in 20 ml Wasser teilweise gelöst. 1,74 g Natriumoleat (1982 bezogen von Riedel-de-Haen) wurden in 30 ml Wasser gelöst. Diese Lösung wurde zu der teilweisen Lösung des Farbstoffs gegeben und 24 h bei Raumtemperatur gerührt. Es hat sich ein harziges rotes Produkt gebildet, von dem die wässrige Phase dekantiert wurde. Das Harz wurde mit 30 ml frischem Wasser 24 h verrührt. Erneut wurde dekantiert. Das rote Harz wurde bei 50 °C im Vakuum getrocknet, schließlich mit 30 ml tert.-Butylmethylether verrührt. Die gebildete Suspension wurde abgesaugt, mit 5 ml tert.-Butylmethylether gewaschen und bei 50 °C im Vakuum getrocknet. Man erhielt 2,72 g (79,9 % d. Th.) eines roten Pulvers der Formel

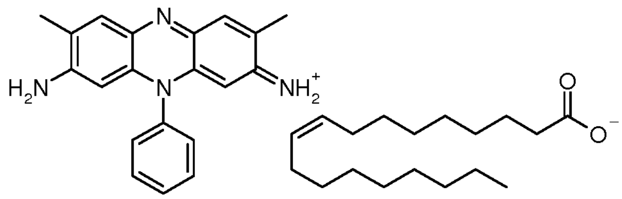

.

$\lambda_{max}$ in Methanol: 528 nm.
Geeignete Laserwellenlänge: 532 nm.

**Beispiel 6**

2,00 g des Farbstoffs der Formel

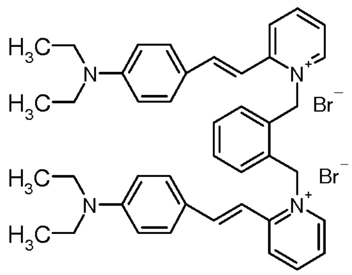

wurden in 45 ml Methanol unter Rühren in der Siedehitze gelöst. 1,78 g Natriumtetraphenylborat (2010 bezogen von ABCR) wurden zugesetzt. Die entstandene Suspension wurde 15 min gekocht, abgekühlt, abgesaugt, mit 20 ml Methanol und 100 ml Wasser gewaschen und bei 50 °C im Vakuum getrocknet. Zur Reinigung wurde der rohe Farbstoff in der minimal nötigen Menge N-Ethylpyrrolidon bei Raumtemperatur gelöst, mit der fünffachen Menge Methanol verdünnt und schließlich mit Wasser bis zur blass gefärbten Mutterlauge gefällt. Es wurde abgesaugt, mit 50 ml Methanol in Portionen gewaschen und bei 50 °C im Vakuum getrocknet. Man erhielt 2,45 g (75,5 % d. Th.) eines roten, leicht grünlich schillernden Pulvers der Formel

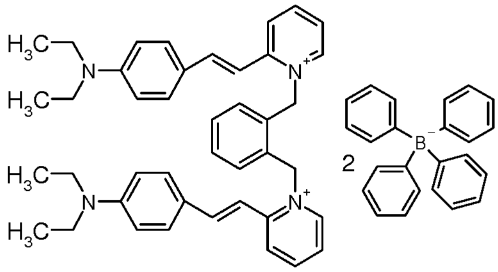

.

$\lambda_{max}$ in Methanol: 486 nm.
Geeignete Laserwellenlänge: 473 nm.

Der Ausgangsfarbstoff wurde analog zu bekannten Verfahren folgendermaßen hergestellt: 5,78 g 2-Methylpyridin und 8,20 g $\alpha,\alpha'$-Dibrom-o-xylol wurden in 60 ml $\gamma$-Butyrolacton 2h bei 80 °C gerührt. Nach dem Abkühlen wurde abgesaugt und getrocknet. 12,0 g dieses Materials wurden in einer Mischung aus 27 ml Eisessig und 27 ml Morpholin langsam mit 9,45 g 4-Diethylaminobenzaldehyd versetzt und 2h bei 80 °C gerührt. Nach dem Abkühlen wurde auf Wasser ausgetragen, isoliert und getrocknet.

**Beispiel 7**

2,00 g des Farbstoffs der Formel

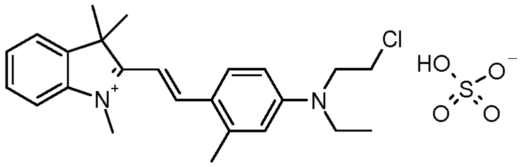

,

(C. I. Basic Violet 7) wurden in 30 ml Ethanol gelöst. Unter Lichtausschluss wurden 6,39 g einer 20-proz. wässrigen Lösung von Lithium-butyl-triphenylborat (2009 bezogen von Hokko Chemical Ind., Japan) unter Rühren bei Raumtemperatur zugetropft. Die dicke rote Suspension wurde 4 h gerührt, abgesaugt, mit 15 ml Ethanol und 100 ml Wasser in Portionen gewaschen und bei 50 °C unter Lichtausschluss im Vakuum getrocknet. Man erhielt 2,78 g (97,7 % d. Th.) eines lila-farbenen Pulvers der Formel

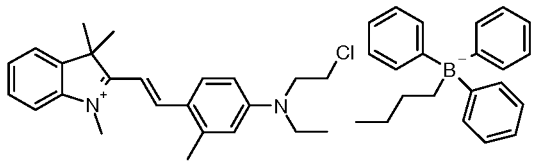

.

$\lambda_{max}$ in Methanol: 549 nm.
Geeignete Laserwellenlänge: 532 nm.

**Beispiel 8**

3,00 g des Farbstoffs der Formel

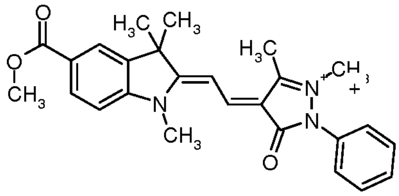
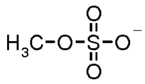
,

hergestellt nach DE-PS 1 158 646, wurden in 50 ml Methanol teilweise gelöst. 1,90 g Natriumtetraphenylborat (2010 bezogen von ABCR) wurden in 15 ml Methanol gelöst. Diese Lösung wurde unter Rühren bei Raumtemperatur zur Farbstoffsuspension während 30 min getropft. Dabei wandelte sich die rote Suspension in eine orange um. Nach 2 h Rühren wurde abgesaugt, mit 10 ml Methanol und 100 ml Wasser in Portionen gewaschen und bei 50 °C im Vakuum getrocknet. Man erhielt 2,00 g (28,2 % d. Th.) eines rot-orangen Pulvers der Formel

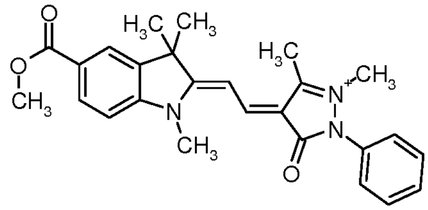
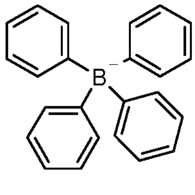
.

$\lambda_{max}$ in Methanol: 467 nm.
Geeignete Laserwellenlänge: 473 nm.

**Beispiel 9**

15,0 g Natrium-bis(2-ethylhexyl)sulfosuccinat (2010 bezogen von Aldrich) wurden in 350 ml Wasser bei 50 °C gelöst. 24,5 g des Farbstoffs der Formel

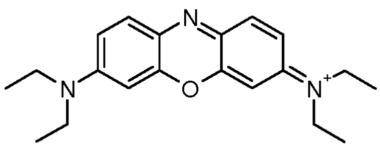
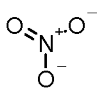
,

(Basic Blue 3), als 53 Gew.-%. Ware und 220 ml Essigsäurebutylester wurden zugesetzt und 4 h wurde bei 50 °C gerührt. Die wässrige Phase wurde abgetrennt und die organische Phase wurde dreimal mit 50 ml frischem Wasser bei 50 °C verrührt. Schließlich wurde jedes Mal die wässrige Phase abgetrennt, die letzte bei Raumtemperatur. Die tiefblaue organische Phase wurde mit wasserfreiem Magnesiumsulfat getrocknet, filtriert und durch azeotrope Destillation bei 150 mbar vom Restwasser befreit. Durch Zusatz von wasserfreiem Essigsäurebutylester wurden schließlich 250 g tiefblaue Lösung hergestellt, die 9,68 Gew.-% an dem Farbstoff der Formel

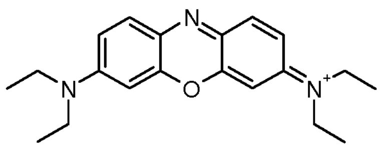
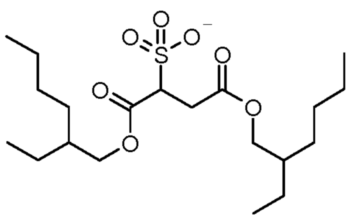

war (96,4 % d. Th.).
Wassergehalt (KF): 0,1 %
$\lambda_{max}$ in Methanol: 643 nm.
Geeignete Laserwellenlänge: 633 nm.

Eindampfen der Lösung lieferte 24,2 g eines tiefblauen Glases, das allmählich in Form von goldglänzenden Prismen kristallisiert. Hiervon ließen sich beispielsweise wieder 20 Gew.-%ige Lösungen in Butanon oder Essigsäureethylester/Butanon 7:3 herstellen.

## Beispiel 10

3,71 g wasserfreies Natrium-bis(2-ethylhexyl)sulfosuccinat (2010 bezogen von Aldrich) wurden in 50 ml wasserfreiem Essigsäureethylester gelöst. 4,00 g des wasserfreien Farbstoffs der Formel

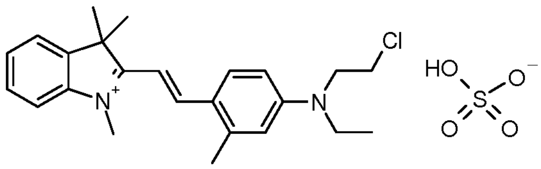

,

(Basic Violet 7), wurden zugesetzt. Die tiefrote Mischung wurde 3 h bei Raumtemperatur gerührt und über einen Faltenfilter filtriert. Man erhielt 49,3 g einer rubinroten Lösung, die 13,5 Gew.-%. an dem Farbstoff der Formel

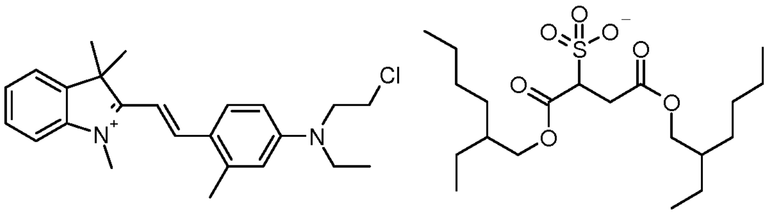

ist (99,2 % d. Th.).

Wassergehalt (KF): 0,08%
$\lambda_{max}$ in Methanol: 549 nm.
Geeignete Laserwellenlänge: 532 nm.

## Beispiel 11

2,78 g Natrium-di-n-octylsulfosuccinat, hergestellt nach Phys. Chem. Chem. Phys. 1999, 1, 4395, wurden in 20 ml Essigsäureethylester gelöst. 2,20 g des Farbstoffs der Formel

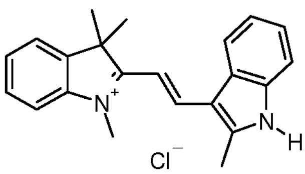

,

(Basic Orange 21), wurden zugesetzt. Die tieforange Mischung wurde 8 h bei 45 °C gerührt, auf Raumtemperatur abgekühlt und über einen Faltenfilter filtriert. Man erhielt eine tieforange Lösung, die zunächst durch azeotrope Destillation bei Normaldruck von eingeschlepptem Wasser befreit wurde und dann durch Zusatz von wasserfreiem Essigsäureethylester auf 23,0 g Masse eingestellt wurde. Sie war 20,0 Gew.-%. an dem Farbstoff der Formel

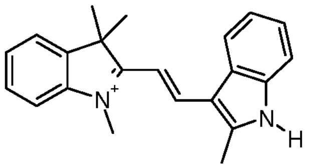 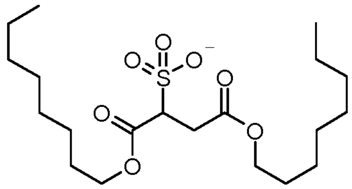 .

(99,5 % d. Th.).

Wassergehalt (KF): 0,04%
$\lambda_{max}$ in Methanol: 492 nm.
Geeignete Laserwellenlänge: 473 nm.

**Beispiel 12**

3,33 g des Farbstoffs der Formel

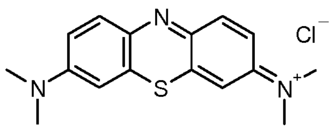 ,

(Methylenblau, 2010 bezogen von Applichem, 90 % Gehalt) wurden in einer Mischung aus 72 ml Wasser und 9 ml Methanol gelöst und von wenig Ungelösten abfiltriert. Unter Lichtausschluss wurden unter Rühren 14,36 g einer 20 Gew.-%. wässrigen Lösung von Lithium-n-butyltriphenylborat (2009 bezogen von Hokko Chemical Ind., Japan) zugetropft. Nach 1 h Rühren wurde unter Lichtausschluss abgesaugt, mit 50 ml Wasser gewaschen und bei 50 °C i. Vak. getrocknet. Man erhielt 4,73 g (86,4 % d. Th.) eines blauen Pulvers der Formel

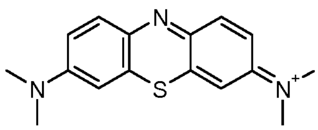 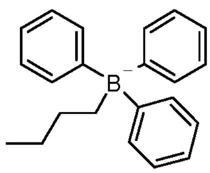 .

$\lambda_{max}$ in Methanol: 653 nm, 612 (sh) nm.
Geeignete Laserwellenlänge: 633 nm.

In analoger Weise lassen sich die Farbstoffe der folgenden Tabelle 2 herstellen.

| Beispiel | $F^+$ | $An^-$ | Geeignete Laserwellenlänge (nm) |
|---|---|---|---|
| 13 | 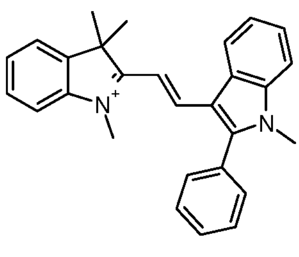 | 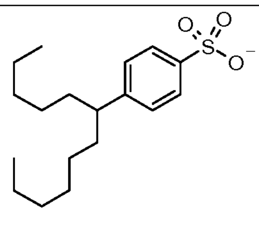 Isomerenmischung | 473<br>532 |

| Beispiel | F⁺ | An⁻ | Geeignete Laserwellen-länge (nm) |
|---|---|---|---|
| 14 | 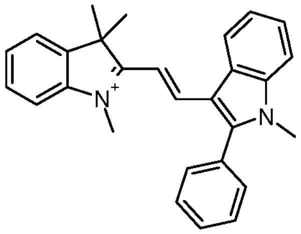 | 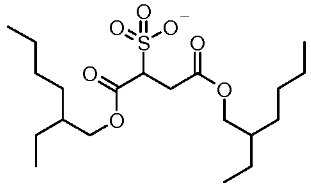 | 473<br>532 |
| 15 | 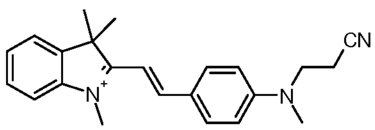 | 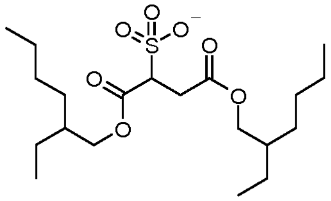 | 532 |
| 16 | 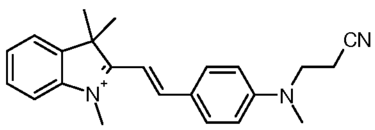 | 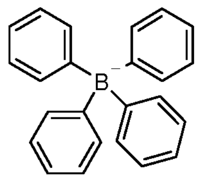 | 532 |
| 17 | 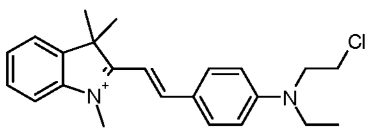 | 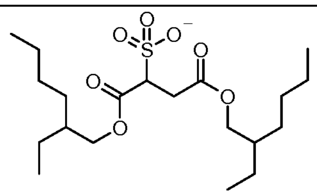 | 532 |
| 18 | 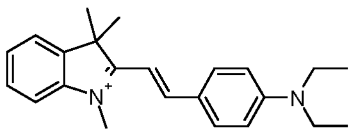 | 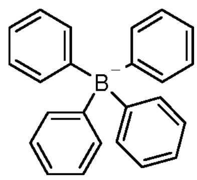 | 532 |
| 19 | 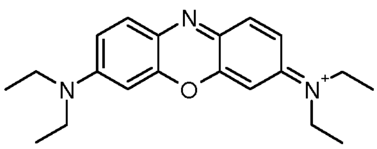 | 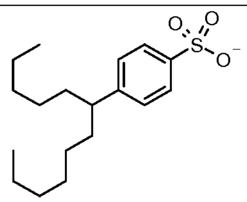<br>Isomerenmischung | 633 |

| Beispiel | $F^+$ | $An^-$ | Geeignete Laserwellenlänge (nm) |
|---|---|---|---|
| 20 | 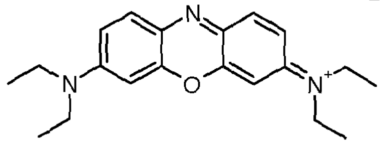 | 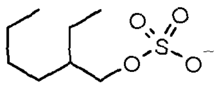 | 633 |
| 21 | 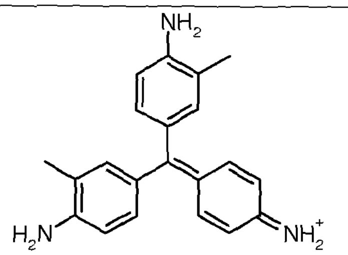 | 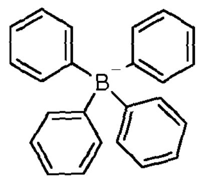 | 532 |
| 22 | 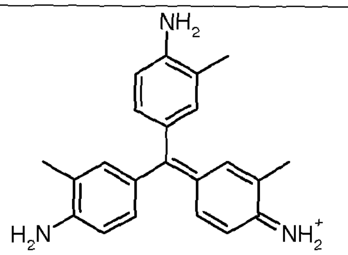 | 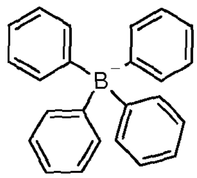 | 532 |
| 23 | 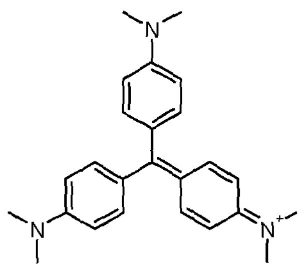 | 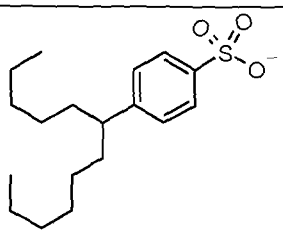 Isomerenmischung | 532 |
| 24 | 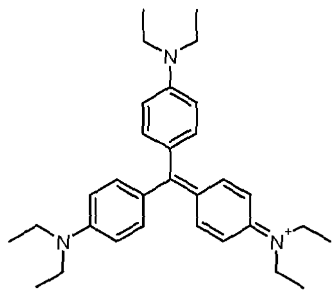 | 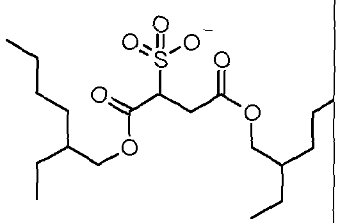 | 532 |
| 25 | 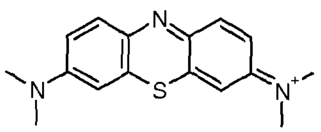 | 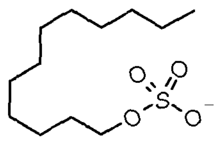 | 633 |

| Beispiel | $F^+$ | $An^-$ | Geeignete Laserwellenlänge (nm) |
|---|---|---|---|
| 26 | 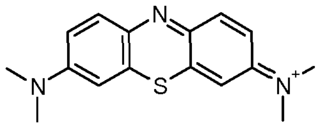 | 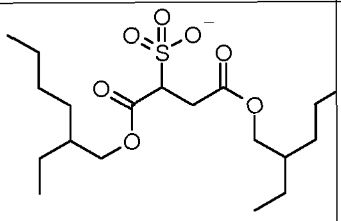 | 633 |
| 27 | 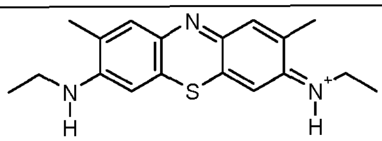 | 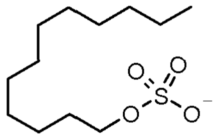 | 633 |
| 28 | 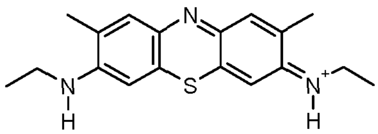 | 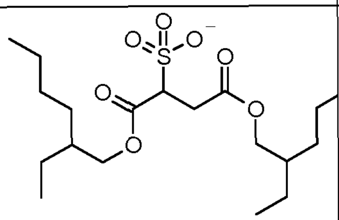 | 633 |
| 29 | 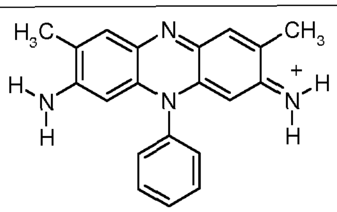 | 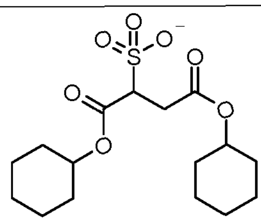 | 532 |
| 30 | 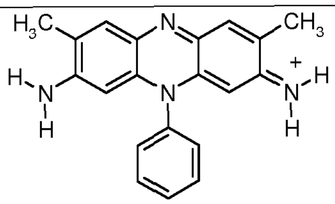 | 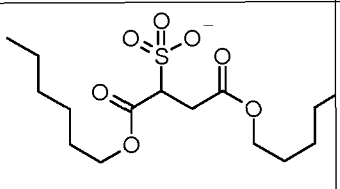 | 532 |
| 31 | 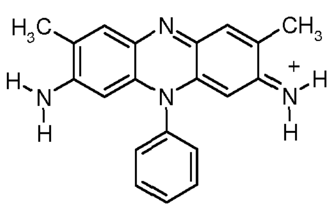 | 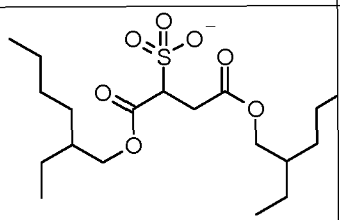 | 532 |

| Beispiel | F⁺ | An⁻ | Geeignete Laserwellenlänge (nm) |
|---|---|---|---|
| 32 | 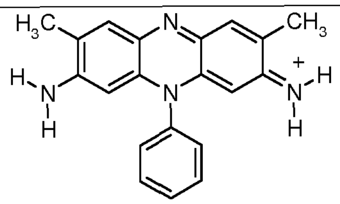 | 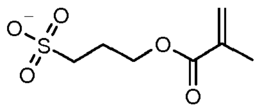 | 532 |
| 33 | 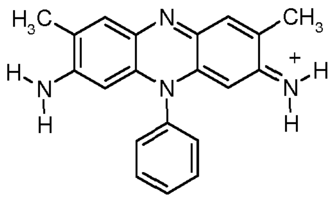 | 1/3 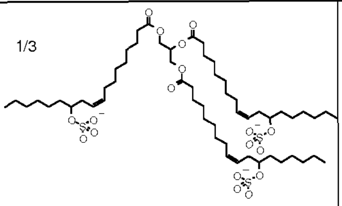 | 532 |
| 34 | 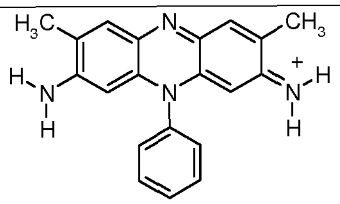 | 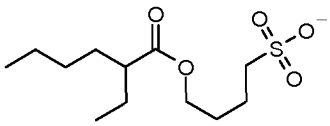 | 532 |
| 35 | 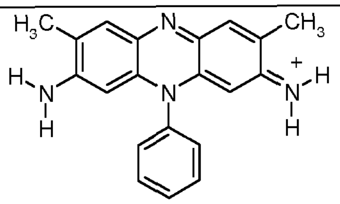 | 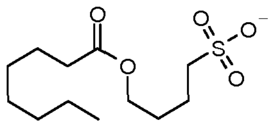 | 532 |
| 36 | 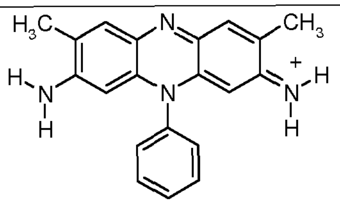 | 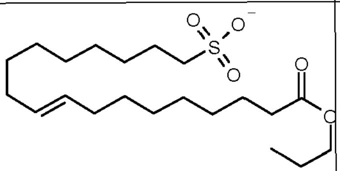 | 532 |
| 37 | 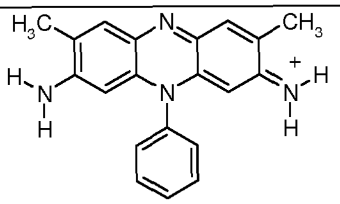 | 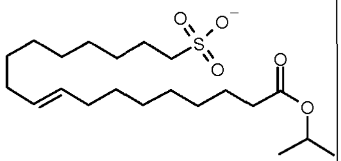 | 532 |

| Beispiel | F⁺ | An⁻ | Geeignete Laserwellenlänge (nm) |
|---|---|---|---|
| 38 | 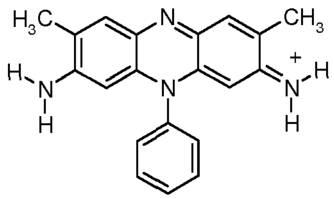 | 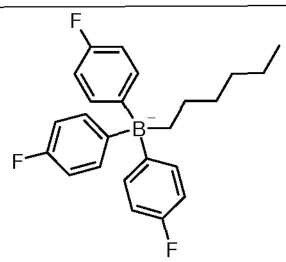 | 532 |
| 39 | 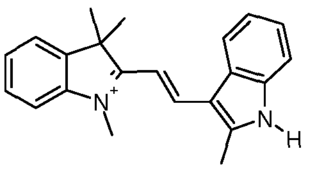 | 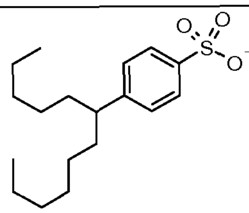<br>Isomerenmischung | 473 |
| 40 | 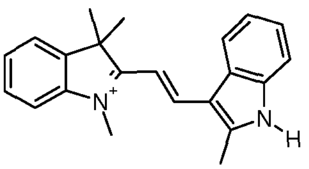 | 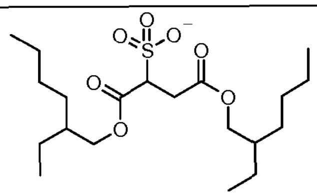 | 473 |
| 41 | 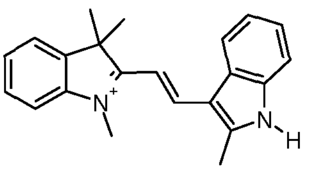 | 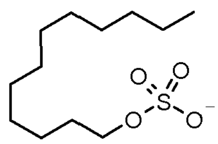 | 473 |
| 42 | 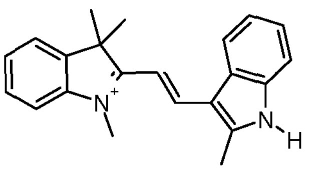 | 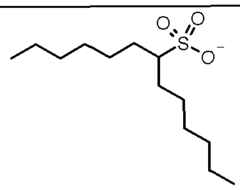<br>Isomerenmischung | 473 |
| 43 | 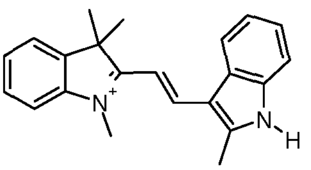 | 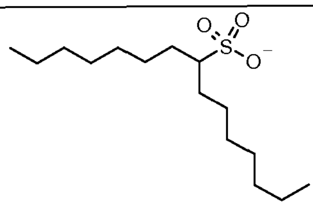<br>Isomerenmischung | 473 |

| Beispiel | $F^+$ | $An^-$ | Geeignete Laserwellenlänge (nm) |
|---|---|---|---|
| 44 | 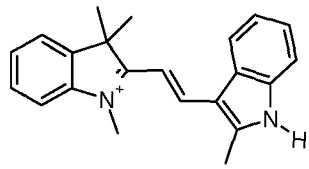 | 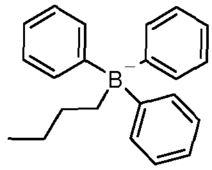 | 473 |
| 45 | 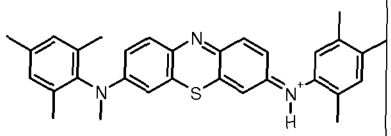 | 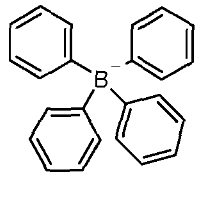 | 633 |
| 46 | 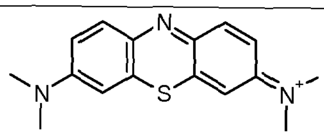 | 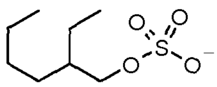 | 633 |
| 47 | 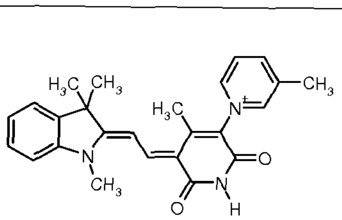 | 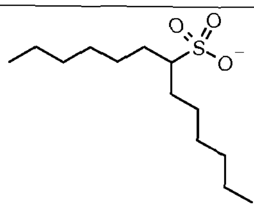 Isomerenmischung | 473 |
| 48 | 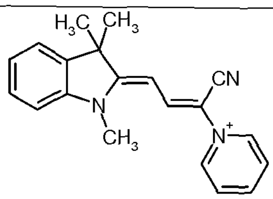 | 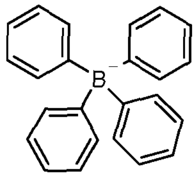 | 473 |
| 49 | 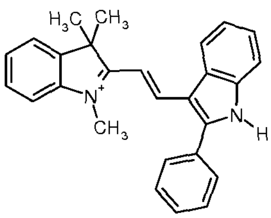 | 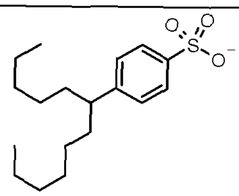 Isomerenmischung | 473 |
| 50 | 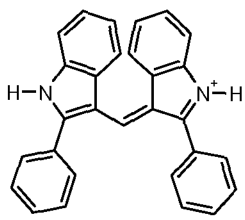 | 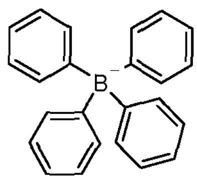 | 473 |

| Beispiel | F+ | An- | Geeignete Laserwellen-länge (nm) |
|---|---|---|---|
| 51 | 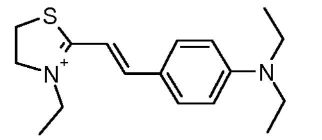 | 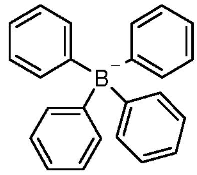 | 473 |
| 52 | 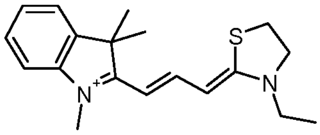 | 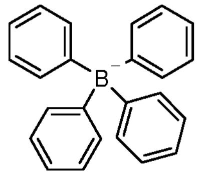 | 473 |
| 53 | 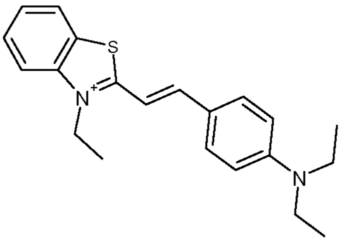 | 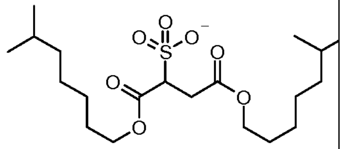 | 532 |
| 54 | 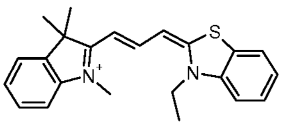 | 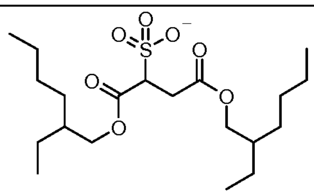 | 532 |
| 55 | 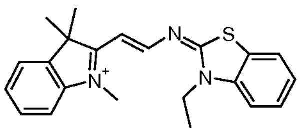 | 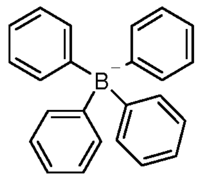 | 532 |
| 56 | 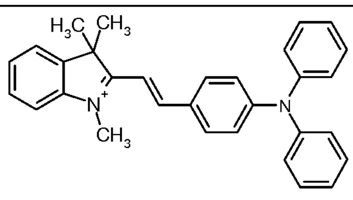 | 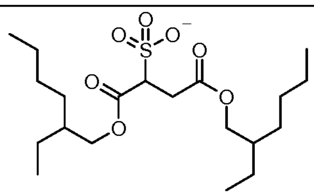 | 532 |
| 57 | 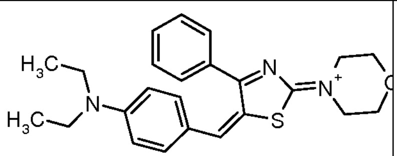 | 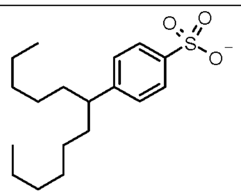 | 532 |

| Beispiel | F⁺ | An⁻ | Geeignete Laserwellen-länge (nm) |
|---|---|---|---|
| | | Isomerenmischung | |
| 58 | 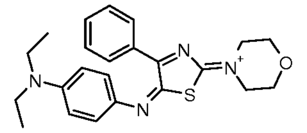 | 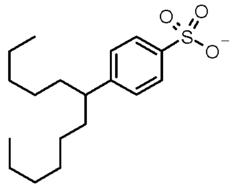 Isomerenmischung | 633 |
| 59 | 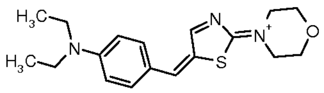 | 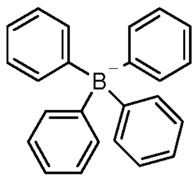 | 532 |
| 60 | 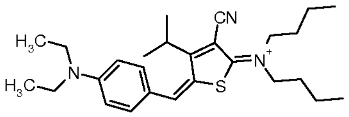 | 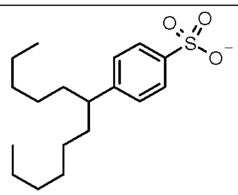 Isomerenmischung | 532 |
| 61 | 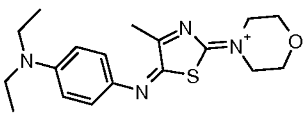 | 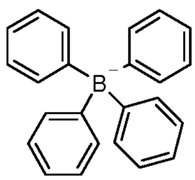 | 633 |
| 62 | 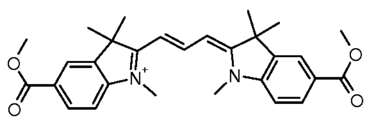 | 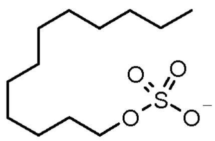 | 532 |
| 63 | 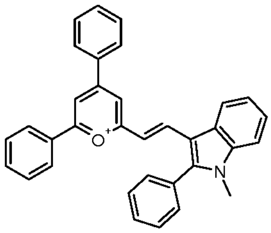 | 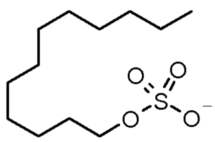 | 532 |

| Beispiel | $F^+$ | $An^-$ | Geeignete Laserwellenlänge (nm) |
|---|---|---|---|
| 64 | 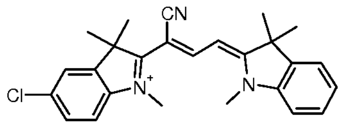 | 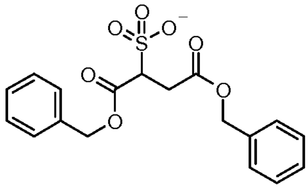 | 532 |
| 65 | 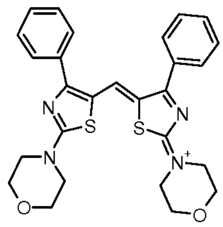 | 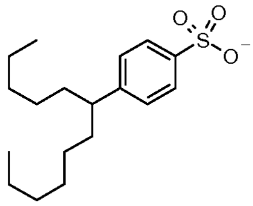<br>Isomerenmischung | 532 |
| 66 | 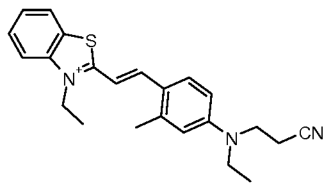 | 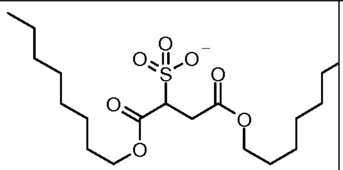 | 532 |
| 67 | 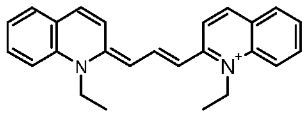 | 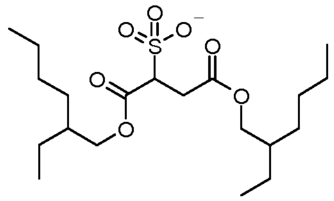 | 633 |
| 68 | 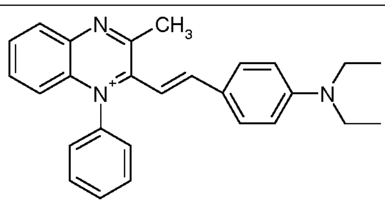 | 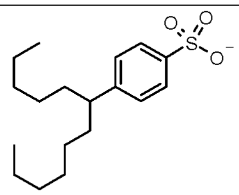<br>Isomerenmischung | 633 |
| 69 | 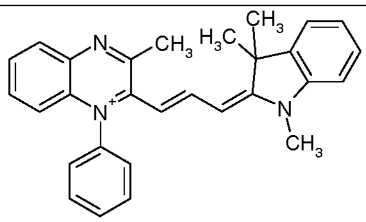 | 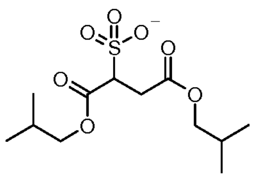 | 633 |

| Beispiel | $F^+$ | $An^-$ | Geeignete Laserwellen-länge (nm) |
|---|---|---|---|
| 70 | 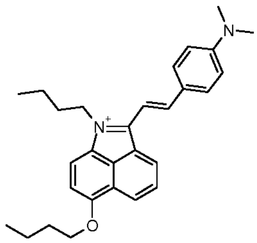 | 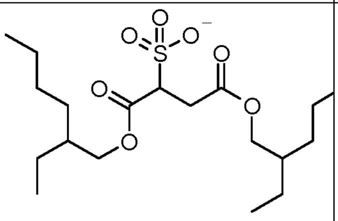 | 633 |
| 71 | 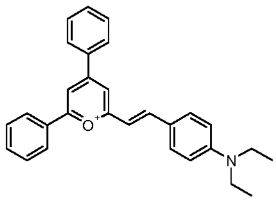 | 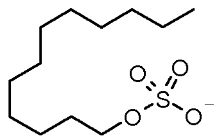 | 633 |
| 72 | 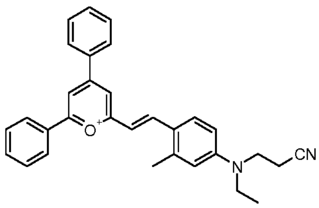 | 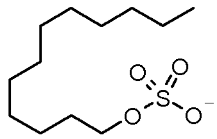 | 633 |
| 73 | 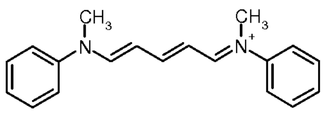 | 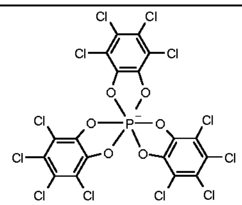 | 473 |
| 74 | 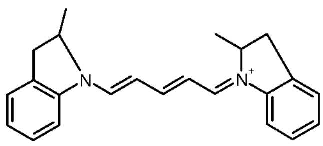 | 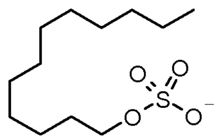 | 473 |
| 75 | 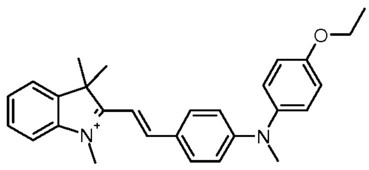 | 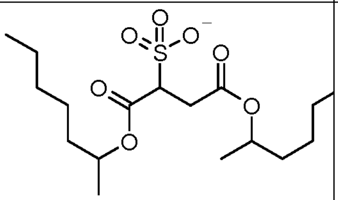 | 532 |
| 76 | 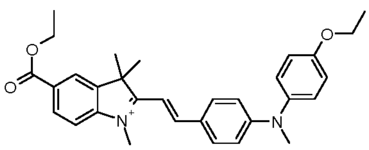 | 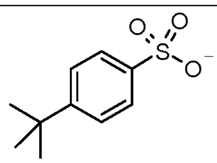 | 532 |

| Beispiel | F+ | An- | Geeignete Laserwellen-länge (nm) |
|---|---|---|---|
| 77 | 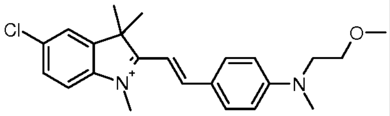 | 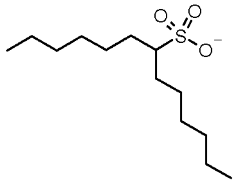<br>Isomerenmischung | 532 |
| 78 | 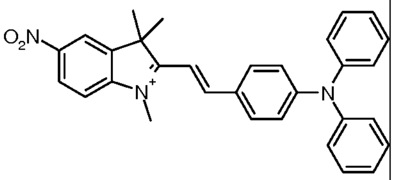 | 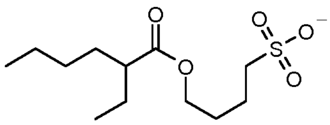 | 532 |
| 79 | 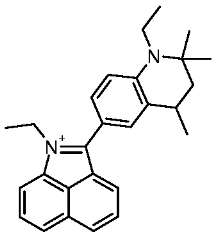 | 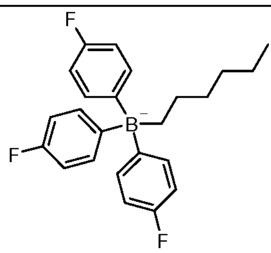 | 532 |
| 80 | 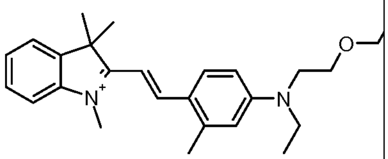 | 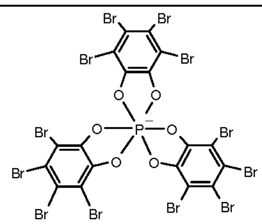 | 532 |
| 81 | 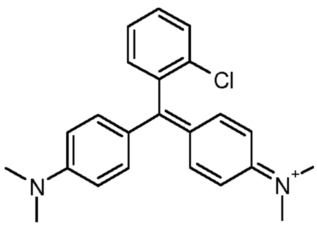 | 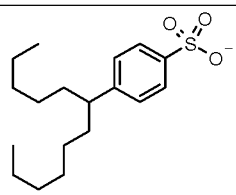<br>Isomerenmischung | 633 |
| 82 | 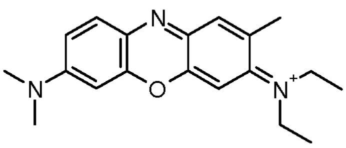 | 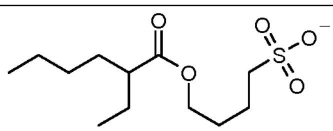 | 633 |

| Beispiel | $F^+$ | $An^-$ | Geeignete Laserwellenlänge (nm) |
|---|---|---|---|
| 83 | 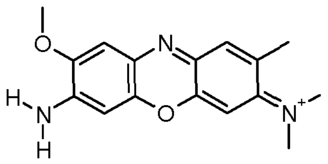 | 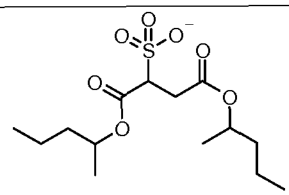 | 633 |
| 84 | 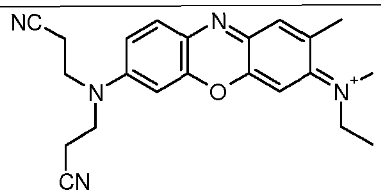 | 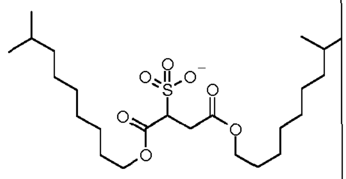 | 633 |
| 85 | 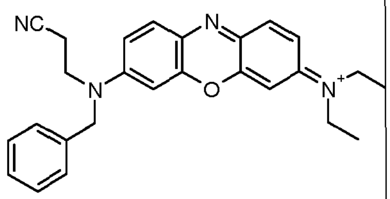 | 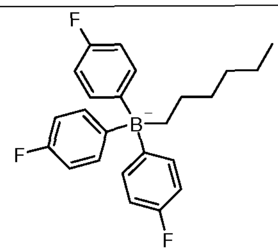 | 633 |
| 86 | 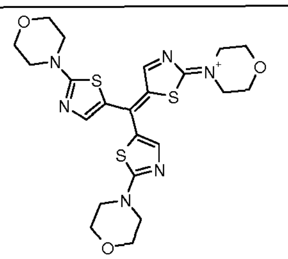 | 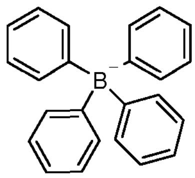 | 633 |
| 87 | 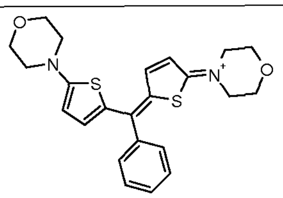 | 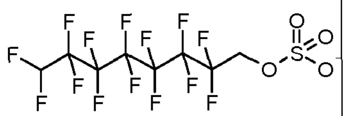 | 633 |
| 88 | 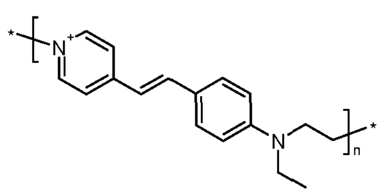 | 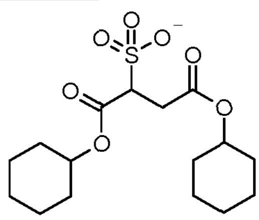 | 473 |

| Beispiel | $F^+$ | $An^-$ | Geeignete Laserwellen-länge (nm) |
|---|---|---|---|
| 89 | 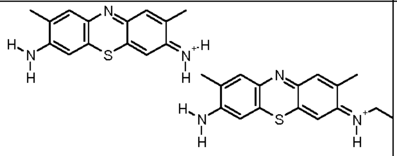 5 : 1 | 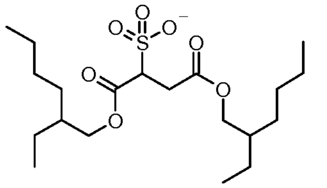 | 633 |
| 90 | 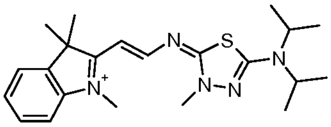 | 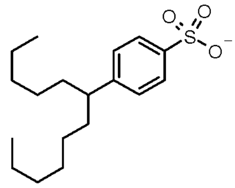 Isomerenmischung | 532 |
| 91 | 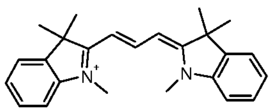 | 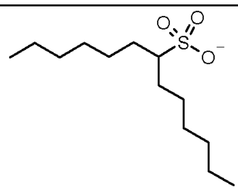 Isomerenmischung | 532 |
| 92 | 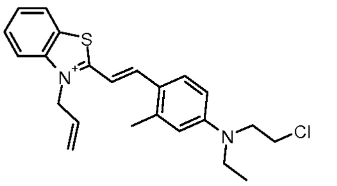 | 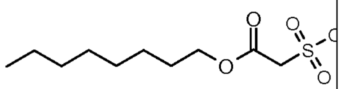 | 532 |
| 93 | 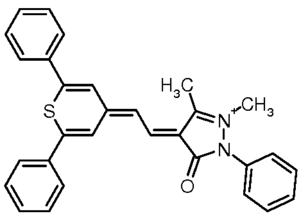 | 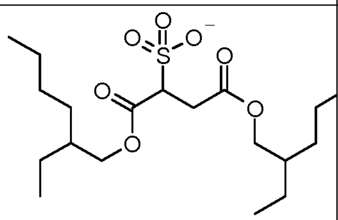 | 532 |
| 94 | 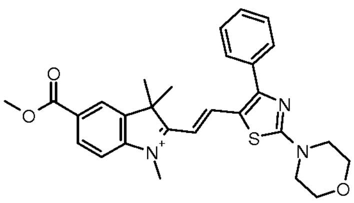 | 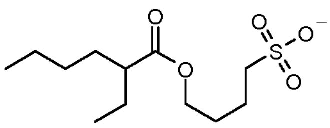 | 532 |

| Beispiel | F⁺ | An⁻ | Geeignete Laserwellen-länge (nm) |
|---|---|---|---|
| 95 | 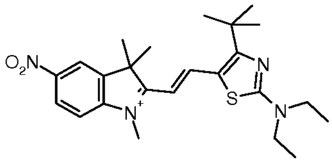 | 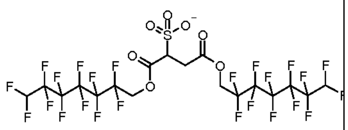 | 532 |
| 96 | 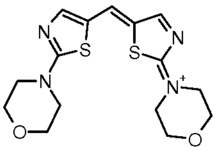 | 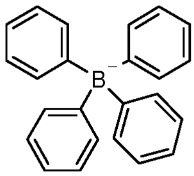 | 532 |
| 97 | 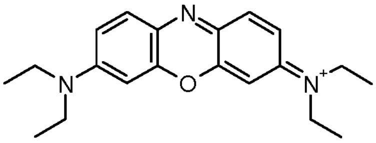 | 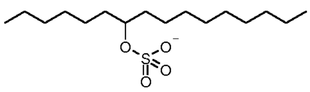 | 633 |
| 98 | 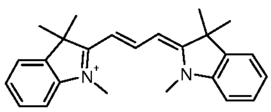 | 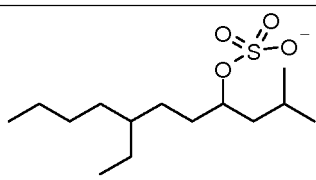 | 532 |
| 99 | 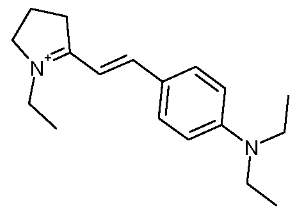 | 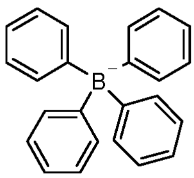 | 473 |
| 100 | 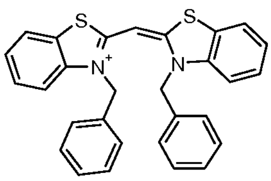 | 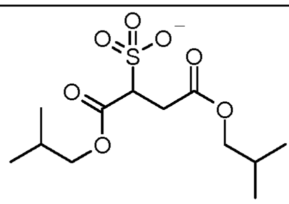 | 473 |
| 101 | 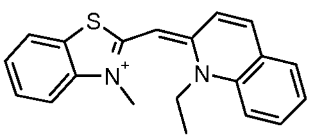 | 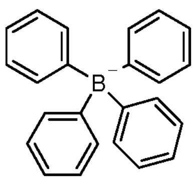 | 473 |

| Beispiel | $F^+$ | $An^-$ | Geeignete Laserwellenlänge (nm) |
|---|---|---|---|
| 102 | 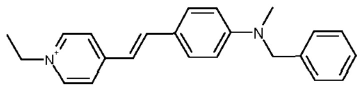 | 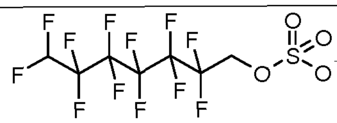 | 473 |
| 103 | 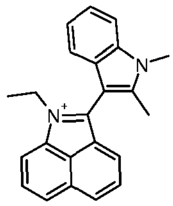 | 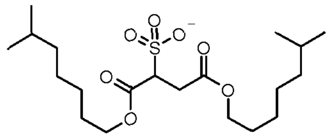 | 532 |
| 104 | 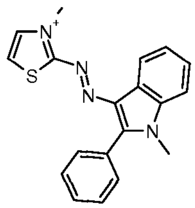 | 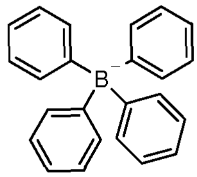 | 523 |
| 105 | 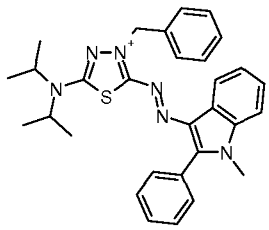 | 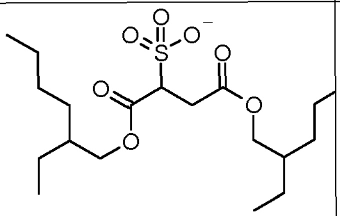 | 532 |
| 106 | 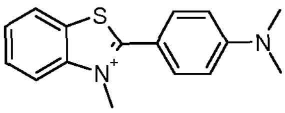 | 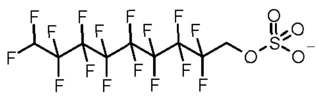 | 473 |
| 107 | 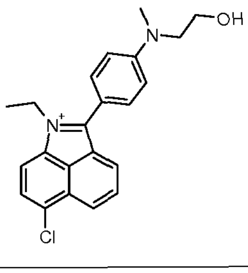 | 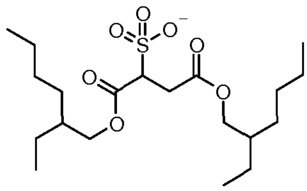 | 532 |
| 108 | 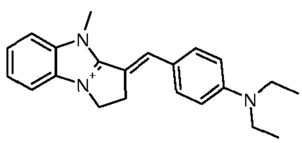 | 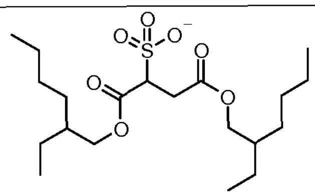 | 473 |

| Beispiel | $F^+$ | $An^-$ | Geeignete Laserwellen-länge (nm) |
|---|---|---|---|
| 109 | 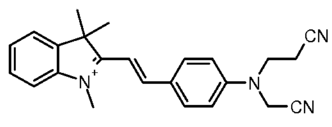 | 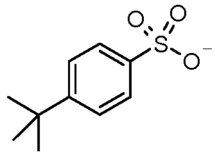 | 473 |
| 110 | 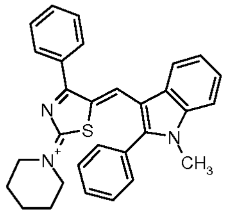 | 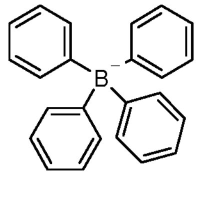 | 473 |
| 111 | 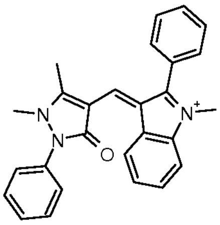 | 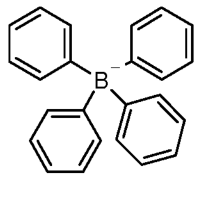 | 473 |
| 112 | 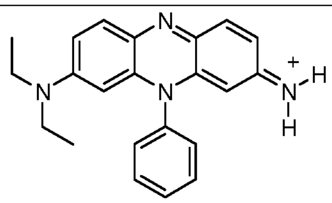 | 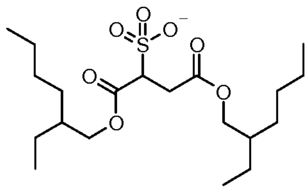 | 532 |
| 113 | 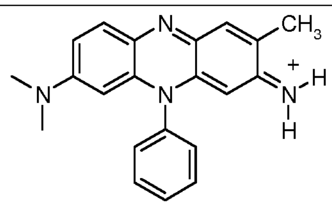 | 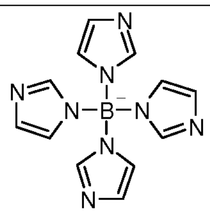 | 532 |

Tabelle 2: Erfindungsgemäße Farbstoffe

In Tabelle 3 sind die beobachteten Wasseraufnahmen W der ausgewählten Beispiele zusammengefasst.

Tabelle 3: Wasseraufnahme ausgewählter Beispiele

| Beispiel | $F^+$ | $An^-$ | W [%] |
|---|---|---|---|
| 1 | 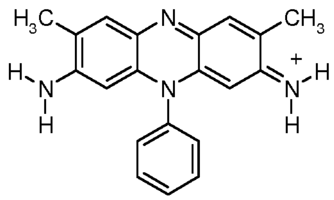 | 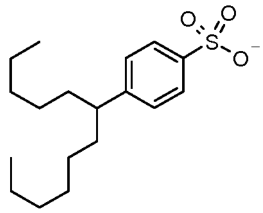 Isomerenmischung | 2,7 |
| 14 | 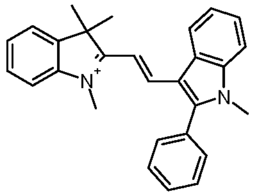 | 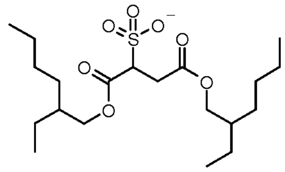 | 0,03 |
| 25 | 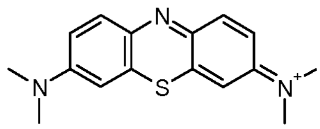 | 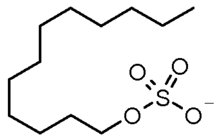 | 0,1 |
| 30 | 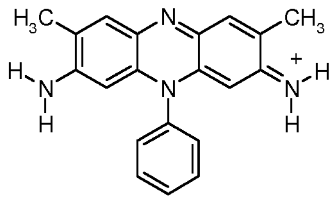 | 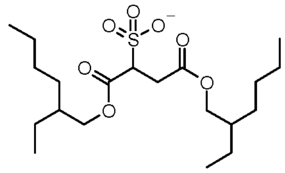 | 1,9 |
| 39 | 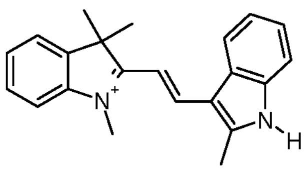 | 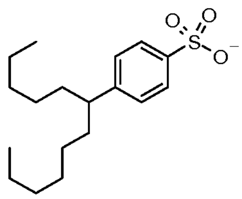 Isomerenmischung | 1,6 |
| 41 | 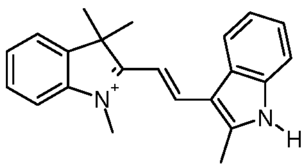 | 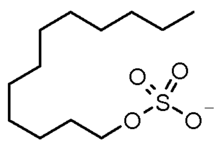 | 0,49 |
| 46 | 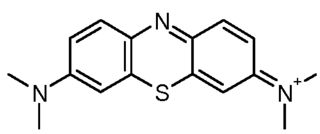 | 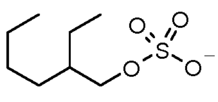 | 2,3 |

Bei den Vergleichsbeispielen V 1-2 handelt es sich um die käuflichen Farbstoffe Safranin O/T und Methylenblau. Bei dem Vergleichsbeispiel V 3 handelt es sich um Basic Orange 21, das nach einer Vorschrift aus H. Berneth in Ullmann's Encyclopedia of Industrial Chemistry, Methine Dyes and Pigments, Wiley-VCH Verlag, 2008 hergestellt wurde. V-4 wurde aus Methylenblau und Lithiumperchlorat erhalten wie unten beschrieben. In Tabelle 4 sind die beobachteten Wasseraufnahmen W der Vergleichsbeispiele V 1-4 zusammengefasst.

Tabelle 4: Wasseraufnahme ausgewählter Vergleichsbeispiele

| Vergleichsbeispiel | $F^+$ | $An^-$ | W [%] |
|---|---|---|---|
| V-1 | 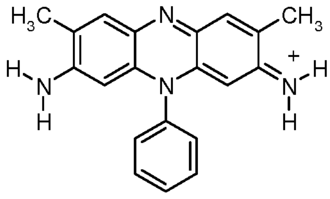 | $Cl^-$ | 14,8 |
| V-2 | 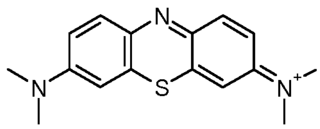 | $Cl^-$ | 20,9 |
| V-3 | 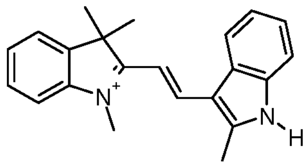 | $Cl^-$ | 9,5 |
| V-4 | 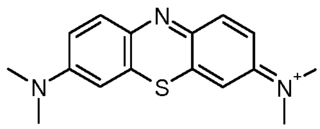 | $ClO_4^-$ | 6,2 |

**Herstellung des Vergleichsbeispiel V4**

5,55 g Methylenblau-Hydrat (90-proz., 2010 bezogen von Fluka) wurden in 90 ml Wasser teilweise gelöst. Hierzu wurde bei Raumtemperatur und unter gutem Rühren während 1 h eine Lösung von 1,66 g Lithiumperchlorat (2009 bezogen von Acros) in 15 ml Wasser getropft. Es wurde 3 h gerührt, abgesaugt und mit 2x 25 ml Wasser gewaschen. Nach dem Trocknen bei 50 °C im Vakuum erhielt man 5,97 g (99,5 %) eines blauen Pulvers der Formel

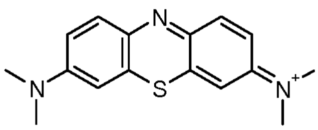

$ClO_4^-$ .

**Herstellung der Komponenten**

**Herstellung von Polyol 1:**

In einem 1 L Kolben wurden 0.18 g Zinnoctoat, 374.8 g ε-Caprolacton und 374.8 g eines difunktionellen Polytetrahydrofuranpolyetherpolyols (Equivalentgewicht 500 g/Mol OH) vorgelegt und auf 120 °C aufgeheizt und so lange auf dieser Temperatur gehalten, bis der Festgehalt (Anteil der nicht-flüchtigen Bestandteile) bei 99.5 Gew.-% oder darüber lag. Anschließend wurde abgekühlt und das Produkt als wachsiger Feststoff erhalten.

**Herstellung des Acrylates 1 (Phosphorthioyltris(oxy-4,1-phenyleniminocarbonyl-oxyethan-2,1-diyl)-triacrylat):**

In einem 500 mL Rundkolben wurden 0.1 g 2,6-Di-tert.-butyl-4-methylphenol, 0.05 g Dibutylzinn-dilaurat (Desmorapid® Z, Bayer MaterialScience AG, Leverkusen, Deutschland) sowie und 213.07 g einer 27 %-igen Lösung von Tris(p-isocyanatophenyl)thiophosphat in Ethylacetat (Desmodur® RFE, Produkt der Bayer MaterialScience AG, Leverkusen, Deutschland) vorgelegt und auf 60 °C erwärmt. Anschließend wurden 42.37 g 2-Hydroxyethylacrylat zugetropft und die Mischung weiter auf 60 °C gehalten, bis der Isocyanatgehalt unter 0.1 % gesunken war. Danach wurde abgekühlt und im Vakuum das Ethylacetat vollständig entfernt. Das Produkt wurde als teilkristalliner Feststoff erhalten.

**Herstellung des Acrylates 2 2-({[3-(Methylsulfanyl)phenyl]carbamoyl}oxy)ethylprop-2-enoat):**

In einem 100 mL Rundkolben wurden 0.02 g 2,6-Di-tert.-butyl-4-methylphenol, 0.01 g Desmorapid® Z, 11.7 g 3-(Methylthio)phenylisocyanat vorgelegt und auf 60 °C erwärmt. Anschließend wurden 8.2 g 2-Hydroxyethylacrylat zugetropft und die Mischung weiter auf 60 °C gehalten, bis der Isocyanatgehalt unter 0.1 % gesunken war. Danach wurde abgekühlt. Das Produkt wurde als hellgelbe Flüssigkeit erhalten.

**Herstellung des Additives 1: (Bis(2,2,3,3,4,4,5,5,6,6,7,7-dodecafluorheptyl)-(2,2,4-trimethylhexan-1,6-diyl)biscarbamat):**

In einem Rundkolben wurden 0,02 g Desmorapid Z und 3,6 g 2,4,4-Trimethylhexane-1,6-diisocyanat vorgelegt und auf 70 °C erwärmt. Anschließend wurden 11,39 g 2,2,3,3,4,4,5,5,6,6,7,7-Dodecafluorheptan-1-ol zugetropft und die Mischung weiter auf 70 °C gehalten, bis der Isocyanatgehalt unter 0.1 % gesunken war. Danach wurde abgekühlt. Das Produkt wurde als farbloses Öl erhalten.

**Herstellung der Formulierungen zur Bestimmung des Modulaufbaus und des Plateaumoduls $G_0$.**

**Beispiel-Formulierung 1**

2,00 g Acrylat 1, 2,00 g Acrylat 2, 1,50 g Additiv 1 wurden mit 3,465 g Polyol 1, und einer Lösung aus 0,026 g des Farbstoffes aus Beispiel 25 in 0,512 g N-Ethylpyrrolidon für 5 Minuten im Speedmixer gemischt, so dass eine homogene Lösung erhalten wurde. Der oben beschriebenen Polyollösung wurde anschließend 0,667 g Desmodur® N 3900 (Produkt der Bayer MaterialScience AG, Leverkusen, DE) zugegeben und für eine weitere Minute im Speedmixer gemischt. Danach werden 0,01 Gramm einer 10 Gew.-%-igen Lösung des Fomrez UL 28 (Urethanisierungskatalysator, Handelsprodukt der Momentive Performance Chemicals, Wilton, CT, USA) in N-Ethylpyrrolidon zugegeben und erneut für eine Minute im Speedmixer gemischt. Die erhaltene, flüssige Masse wurde in das Platte - Platte Messsystem des Oszillationsrheometers eingebracht.

**Vergleichs-Formulierung 1:**

2,00 g Acrylat 1, 2,00 g Acrylat 2, 1,50 g Additiv 1 wurden mit 3,471 g Polyol 1, und einer Lösung aus 0,015 g des Farbstoffes aus Vergleichsbeispiel V-2 in 0,512 g N-Ethylpyrrolidon für 5 Minuten im Speedmixer gemischt, so dass eine homogene Lösung erhalten wurde. Der oben beschriebenen Polyollösung wurde anschließend 0,668 g Desmodur® N 3900 (Produkt der Bayer MaterialScience AG, Leverkusen, DE) zugegeben und für eine weitere Minute im Speedmixer gemischt. Danach werden 0,01 Gramm einer 10 Gew.-%-igen Lösung Fomrez UL 28 (Urethanisierungskatalysator, Handelsprodukt der Momentive Performance Chemicals, Wilton, CT, USA) in N-Ethylpyrrolidon zugegeben und erneut für eine Minute im Speedmixer gemischt. Die erhaltene, flüssige Masse wurde in das Platte - Platte Messsystem des Oszillationsrheometers eingebracht.

**Beispiel-Formulierung 2**

2,00 g Acrylat 1, 2,00 g Acrylat 2, 1,50 g Additiv 1 wurden mit 3,465 g Polyol 1, und einer Lösung aus 0,026 g des Farbstoffes aus Beispiel 41 in 0,512 g N-Ethylpyrrolidon für 5 Minuten im Speedmixer gemischt, so dass eine homogene Lösung erhalten wurde. Der oben beschriebenen Polyollösung wurde anschließend 0,667 g Desmodur® N 3900 (Produkt der Bayer MaterialScience AG, Leverkusen, DE) zugegeben und für eine weitere Minute im Speedmixer gemischt. Danach werden 0,01 Gramm einer 10 Gew.-%-igen Lösung des Fomrez UL 28 (Urethanisierungskatalysator, Handelsprodukt der Momentive Performance Chemicals, Wilton, CT, USA) in N-Ethylpyrrolidon zugegeben und erneut für eine Minute im Speedmixer gemischt. Die erhaltene, flüssige Masse wurde in das Platte - Platte Messsystem des Oszillationsrheometers eingebracht.

**Vergleichs-Formulierung 2:**

2,00 g Acrylat 1, 2,00 g Acrylat 2, 1,50 g Additiv 1 wurden mit 3,471 g Polyol 1, und einer Lösung aus 0,015 g des Farbstoffes aus Vergleichsbeispiel V-3 in 0,512 g N-Ethylpyrrolidon für 5 Minuten im Speedmixer gemischt, so dass eine homogene Lösung erhalten wurde. Der oben beschriebenen Polyollösung wurde anschließend 0,668 g Desmodur® N 3900 (Produkt der Bayer MaterialScience AG, Leverkusen, DE) zugegeben und für eine weitere Minute im Speedmixer gemischt. Danach werden 0,01 Gramm einer 10 Gew.-%-igen Lösung Fomrez UL 28 (Urethanisierungskatalysator, Handelsprodukt der Momentive Performance Chemicals, Wilton, CT, USA) in N-Ethylpyrrolidon zugegeben und erneut

für eine Minute im Speedmixer gemischt. Die erhaltene, flüssige Masse wurde in das Platte - Platte Messsystem des Oszillationsrheometers eingebracht.

**Beispiel-Formulierung 3**

2,00 g Acrylat 1, 2,00 g Acrylat 2, 1,50 g Additiv 1 wurden mit 3,465 g Polyol 1, 0,512 g N-Ethylpyrrolidon und 0,125 g einer 20.7 (gew. %) Lösung des Farbstoffes aus Beispiel 30 in Butylacetat und 2-Butanon (80 Gew-% Butylacetat, 20 Gew-% 2-Butanon) für 5 Minuten im Speedmixer gemischt, so dass eine homogene Lösung erhalten wurde. Der oben beschriebenen Polyollösung wurde anschließend 0,667 g Desmodur® N 3900 (Produkt der Bayer MaterialScience AG, Leverkusen, DE) zugegeben und für eine weitere Minute im Speedmixer gemischt. Danach werden 0,01 Gramm einer 10 Gew.-%-igen Lösung des Fomrez UL 28 (Urethanisierungskatalysator, Handelsprodukt der Momentive Performance Chemicals, Wilton, CT, USA) in N-Ethylpyrrolidon zugegeben und erneut für eine Minute im Speedmixer gemischt. Die erhaltene, flüssige Masse wurde in das Platte - Platte Messsystem des Oszillationsrheometers eingebracht.

**Vergleichs-Formulierung 3:**

2,00 g Acrylat 1, 2,00 g Acrylat 2, 1,50 g Additiv 1 wurden mit 3,471 g Polyol 1, und einer Lösung aus 0,015 g des Farbstoffes aus Vergleichsbeispiel V-1 in 0,512 g N-Ethylpyrrolidon für 5 Minuten im Speedmixer gemischt, so dass eine homogene Lösung erhalten wurde. Der oben beschriebenen Polyollösung wurde anschließend 0,668 g Desmodur® N 3900 (Produkt der Bayer MaterialScience AG, Leverkusen, DE) zugegeben und für eine weitere Minute im Speedmixer gemischt. Danach werden 0,01 Gramm einer 10 Gew.-%-igen Lösung Fomrez UL 28 (Urethanisierungskatalysator, Handelsprodukt der Momentive Performance Chemicals, Wilton, CT, USA) in N-Ethylpyrrolidon zugegeben und erneut für eine Minute im Speedmixer gemischt. Die erhaltene, flüssige Masse wurde in das Platte - Platte Messsystem des Oszillationsrheometers eingebracht.

**Beispiel-Formulierung 4**

2,00 g Acrylat 1, 2,00 g Acrylat 2, 1,50 g Additiv 1 wurden mit 3,465 g Polyol 1 und 0,125 g einer 20.7 (gew. %) Lösung des Farbstoffes aus Beispiel 30 in Butylacetat und 2-Butanon (80 Gew-% Butylacetat, 20 Gew-% 2-Butanon) für 5 Minuten im Speedmixer gemischt, so dass eine homogene Lösung erhalten wurde. Der oben beschriebenen Polyollösung wurde anschließend 0,667 g Desmodur® N 3900 (Produkt der Bayer MaterialScience AG, Leverkusen, DE) zugegeben und für eine weitere Minute im Speedmixer gemischt. Danach werden 0,01 Gramm einer 10 Gew.-%-igen Lösung des Fomrez UL 28 (Urethanisierungskatalysator, Handelsprodukt der Momentive Performance Chemicals, Wilton, CT, USA) in N-Ethylpyrrolidon zugegeben und erneut für eine Minute im Speedmixer gemischt. Die erhaltene, flüssige Masse wurde in das Platte - Platte Messsystem des Oszillationsrheometers eingebracht.

**Plateaumodul $G_0$ und Modulaufbau:**

Die wie beschrieben hergestellten Formulierungen wurden anschließend in der oben beschriebenen Weise auf ihre rheologischen Eigenschaften geprüft. Dabei ergaben sich folgende Messwerte für den Plateaumoduls Go:

Tabelle 5: Plateaumodul $G_0$ ausgewählter Beispiele

| Formulierung | Plateaumodul $G_0$ (Pa) | Temperatur (°C) |
|---|---|---|
| Beispiel-Formulierung 1 | 430000 | 80 |
| Vergleichs-Formulierung 1 | 400000 | 80 |
| Beispiel-Formulierung 2 | 357000 | 80 |
| Vergleichs-Formulierung 2 | 336000 | 80 |
| Beispiel-Formulierung 3 | 372000 | 80 |
| Vergleichs-Formulierung 3 | 303000 | 80 |
| Beispiel-Formulierung 4 | 480000 | 80 |

Die in Tabelle 5 aufgeführten Beispiel-Formulierungen belegen, dass ihr Plateaumodul immer größer ist als der der entsprechenden Vergleichs-Formulierung. Daher ist die Vernetzung der Polymermatrix durch die erfindungsgemäße Auswahl der Farbstoffe besser als bei den Farbstoffen mit hoher Wasseraufnahme. Eine unvollständige Vernetzung des Matrixpolymeren beeinflusst die Stabilität der eingeschriebenen Hologramme nachteilig.

Figur 4 zeigt den Vergleich des Modulaufbaues über der Härtezeit zwischen Beispiel-Formulierung 1 und Vergleichs-Formulierung 1. Figur 5 zeigt den Vergleich des Modulaufbaues über der Härtezeit zwischen Beispiel-Formulierung 2 und Vergleichs-Formulierung 2. Figur 6 zeigt den Vergleich des Modulaufbaues über der Härtezeit zwischen Beispiel-Formulierung 3 und Vergleichs-Formulierung 3 und Beispiel-Formulierung 4. Es ist offensichtlich, dass die Beispiel-Formulierungen in der Regel den schnelleren Modulaufbau zeigen als die entsprechenden Vergleichs-Formulierungen, d.h. nach einer festen Härtezeit einen höheren Speichermodul G' erreichen. Dies ist zum Beispiel für eine effizientere Beschichtung von Substratfolien mit den Photopolymer-Formulierungen zur Herstellung holographischer Filme von Vorteil, da mit den erfindungsgemäßen Photopolymer-Formulierungen kürzere Aushärtezeiten zur Erreichung der Blockfestigkeit (d.h. die Photopolymerformulierung ist beim Erreichen der Blockfestigkeit mechanisch so stabil, dass die beschichteten Medien weiter verarbeitet, i.d.R. in einem kontinuierlichen Rolle-zu-Rolle-Verfahren aufgewickelt werden können) realisiert werden können. Des Weiteren erlauben die erfindungsgemäßen Photopolymer-Formulierungen auch den Verzicht auf N-Ethylpyrrolidon, was zu einer weiteren Steigerung des Plateaumoduls und dessen Anstieg über die Aushärtezeit führt, wie Beispiel-Formulierung 4 belegt.

## Herstellung der Medien zur Bestimmung der holographischen Eigenschaften

### Beispiel Medium 1

3,38 g der Polyol-Komponente 1 wurden mit 2,00 g Acrylat 1, 2,00 g Acrylat 1, 1,50 g Additiv 1, 0,10 g CGI 909 (Produkt der Fa. BASF SE, Basel, Schweiz), 0.017 g des Farbstoffs aus Beispiel 25 und 0,35 g N-Ethylpyrrolidon bei 60 °C gemischt, so dass eine klare Lösung erhalten wurde. Anschließend wurde auf 30 °C abgekühlt, 0,65 g Desmodur® N3900 (Handelsprodukt der Bayer MaterialScience AG, Leverkusen, DE, Hexandiisocyanat-basiertes Polyisocyanat, Anteil an Iminooxadiazindion mindestens 30 %, NCO-Gehalt: 23,5 %) zugegeben und erneut gemischt. Schließlich wurden 0,01 g Fomrez UL 28 (Urethanisierungskatalysator, Handelsprodukt der Fa. Momentive Performance Chemicals, Wilton, CT, USA) zugegeben und erneut kurz gemischt. Die erhaltene, flüssige Masse wurde dann auf eine Glasplatte gegeben und dort mit einer zweiten Glasplatte abgedeckt. Dieser Probenkörper wurde 12 Stunden bei Raumtemperatur liegen gelassen und gehärtet.

### Beispiel Medium 2

3,38 g der Polyol-Komponente 1 wurden mit 2,00 g Acrylat 1, 2,00 g Acrylat 1, 1.50 g Additiv 1, eine Mischung aus einer 30 Gew.-%-igen Lösung von 0,10 g CGI 909 (Produkt der Fa. BASF SE, Basel, Schweiz) in Ethylacetat und 0,103 g der 9,68 gew.-5igen FarbstoffLösung aus Beispiel 9 bei 60 °C gemischt, so dass eine klare Lösung erhalten wurde. Anschließend wurde auf 30 °C abgekühlt, 0,65 g Desmodur® N3900 (Handelsprodukt der Bayer MaterialScience AG, Leverkusen, DE, Hexandiisocyanat-basiertes Polyisocyanat, Anteil an Iminooxadiazindion mindestens 30 %, NCO-Gehalt: 23,5 %) zugegeben und erneut gemischt. Schließlich wurden 0,01 g Fomrez UL 28 (Urethanisierungskatalysator, Handelsprodukt der Fa. Momentive Performance Chemicals, Wilton, CT, USA) zugegeben und erneut kurz gemischt. Die erhaltene, flüssige Masse wurde dann auf eine Glasplatte gegeben und dort mit einer zweiten Glasplatte abgedeckt. Dieser Probenkörper wurde 12 Stunden bei Raumtemperatur liegen gelassen und gehärtet.

### Beispiel Medium 3

Es wurde gearbeitet wie in Beispiel Medium 1, aber unter Verwendung von 0,01 g des Farbstoffs aus Beispiels 13 anstatt 0.017 g des Farbstoffs aus Beispiel 25.

### Beispiel Medium 4

Es wurde gearbeitet wie in Beispiel Medium 1, aber unter Verwendung von 0,01 g des Farbstoffs aus Beispiels 31 anstatt 0.017 g des Farbstoffs aus Beispiel 25.

### Vergleichs Medium 1

3,38 g der Polyol-Komponente 1 wurden mit 2,00 g Acrylat 1, 2,00 g Acrylat 1, 1,50 g Additiv 1, 0,10 g CGI 909 (Produkt der Fa. BASF SE, Basel, Schweiz), 0.010 g des Farbstoffs aus Vergleichsbeispiel V-2 und 0,35 g N-Ethylpyrrolidon bei 60 °C gemischt, so dass eine klare Lösung erhalten wurde. Anschließend wurde auf 30 °C abgekühlt, 0,65 g Desmodur® N3900 (Handelsprodukt der Bayer MaterialScience AG, Leverkusen, DE, Hexandiisocyanat-basiertes Polyisocyanat, Anteil an Iminooxadiazindion mindestens 30 %, NCO-Gehalt: 23,5 %) zugegeben und erneut gemischt.

Schließlich wurden 0,01 g Fomrez UL 28 (Urethanisierungskatalysator, Handelsprodukt der Fa. Momentive Performance Chemicals, Wilton, CT, USA) zugegeben und erneut kurz gemischt. Die erhaltene, flüssige Masse wurde dann auf eine Glasplatte gegeben und dort mit einer zweiten Glasplatte abgedeckt. Dieser Probenkörper wurde 12 Stunden bei Raumtemperatur liegen gelassen und gehärtet.

**Holographische Prüfung:**

Die wie beschrieben hergestellten Medien wurden anschließend mittels einer Messanordnung gemäß Figur 1 in der oben beschriebenen Weise auf ihre holographischen Eigenschaften geprüft. Dabei ergaben sich folgende Messwerte für $\Delta n_{sat}$ bei der Dosis E [mJ/cm$^2$]:

Tabelle 6: Holographische Bewertung ausgewählter Beispiele

| Farbstoff-Beispiel | Medium | Wellenlänge [nm] | DE | $\Delta n_{sat}$ | Dosis E [mJ/cm$^2$] |
|---|---|---|---|---|---|
| 25 | 1 | 633 | 0,98 | 0,033 | 9 |
| 9 | 2 | 633 | 0,98 | 0,035 | 36 |
| 13 | 3 | 473 | 0,99 | 0,036 | 48 |
| 31 | 4 | 532 | 0,98 | 0,033 | 8 |

Die gefundenen Werte zeigen, dass die in den Photopolymer-Formulierungen eingesetzten erfindungsgemäßen Farbstoffe für die Verwendung in holographischen Medien aufgrund des hohen Wertes von $\Delta n_{sat}$ sehr gut geeignet sind, einen rascheren Modulaufbau beim Aushärten des Matrixnetzwerkes ermöglichen und mit ihnen ein höherer Plateaumodul $G_0$ und damit eine vollständigere Vernetzung des Matrixpolymeren erreicht wird.

Des Weiteren zeigen die erfindungsgemäßen Photopolymer-Formulierungen auch eine höhere Photoempfindlichkeit im holographischen Medium. Wie Figur 7 zeigt, die das erreichte $\Delta n$ gegen die Belichtungsdosis E darstellt, setzt im Beispiel Medium 1 das holographische Schreiben bei kleineren Dosen E als im Vergleichs Medium 1 ein.

Analog zu den Beispiel Medien 1-4 lassen sich mit den erfindungsgemäßen Farbstoffen der Beispiele 1-8, 10-12, 14-24, 26-30 und 32-106 holographische Medien herstellen, die vergleichbare holographische Daten aufweisen.

**Patentansprüche**

1. Photopolymer-Formulierung umfassend eine Polyol-Komponente, eine Polyisocyanat-Komponente, ein Schreibmonomer und einen Photoinitiator enthaltend einen Coinitiator und einen Farbstoff der Formel

$$F^+An^-,$$

in der

$F^+$ für einen kationischen Farbstoff steht ausgewählt aus der Gruppe der Acridin-, Xanthen-, Thioxanthen-, Phenazin-, Phenoxazin-, Phenothiazin-, Tri(het)arylmethan-, Diamino- und Triamino(het)arylmethan-, Mono-, Di- und Trimethincyanin-, Hemicyanin-, extern kationische Merocyanin-, extern kationische Neutrocyanin-, Nullmethin-, Naphtholactam- und Streptocyanin-Farbstoffe, und
$An^-$ für ein Anion steht, dass wenigstens ein Phosphor-, Bor- oder Schwefel-Atom umfasst,
**dadurch gekennzeichnet, dass** der Farbstoff der Formel $F^+An^-$ eine Wasseraufnahme von $\leq$ 5 % aufweist und wobei das Anion $An^-$ einen AClogP im Bereich von 1-6,5 aufweist.

2. Photopolymer-Formulierung nach Anspruch 1, **dadurch gekennzeichnet, dass** der Farbstoff eine Wasseraufnahme von $\leq$ 3 %, und besonders bevorzugt von $\leq$ 2 % aufweist.

3. Photopolymer-Formulierung nach einem der Ansprüche 1 oder 2, **dadurch gekennzeichnet, dass** das Anion $An^-$ einen AClogP im Bereich von 1-4 aufweist.

4. Photopolymer-Formulierung nach einem der Ansprüche 1 bis 3, **dadurch gekennzeichnet, dass** das Anion $An^-$ eine Molmasse >150 g/mol, besonderes bevorzugt > 250 g/mol aufweist.

5. Photopolymer-Formulierung nach einem der Ansprüche 1 bis 4, **dadurch gekennzeichnet, dass** das Anion $An^-$ wenigstens ein Bor oder ein Schwefel-Atom und bevorzugt wenigstens ein Schwefel-Atom insbesondere ein Schwefel-Atom in einer $SO_3$-Gruppierung umfasst.

6. Photopolymer-Formulierung nach einem der Ansprüche 1 bis 5, **dadurch gekennzeichnet, dass** das Anion $An^-$ mindestens einen linearen oder verzweigten aliphatischen Rest, bevorzugt einen linearen oder verzweigten aliphatischen $C_8$- bis $C_{16}$-Rest aufweist oder wenn es mehr als einen linearen oder verzweigten aliphatischen Rest aufweist, dann haben diese zusammen 8 bis 36 C-Atome.

7. Photopolymer-Formulierung nach einem der Ansprüche 1 bis 6, **dadurch gekennzeichnet, dass** das Anion $An^-$ ausgewählt aus der Gruppe $C_8$- bis $C_{25}$-Alkansulfonat, vorzugsweise $C_{13}$- bis $C_{25}$-Alkansulfonat, $C_3$- bis $C_{18}$-Perfluoralkansulfonat, vorzugsweise $C_4$- bis $C_{18}$-Perfluoralkansulfonat, $C_9$- bis $C_{25}$-Alkanoat, $C_9$- bis $C_{25}$-Alkenoat, $C_8$- bis $C_{25}$-Alkylsulfat, vorzugsweise $C_{13}$- bis $C_{25}$-Alkylsulfat, $C_8$- bis $C_{25}$-Alkenylsulfat, vorzugsweise $C_{13}$- bis $C_{25}$-Alkenylsulfat, $C_3$-bis $C_{18}$-Perfluoralkylsulfat, vorzugsweise $C_4$- bis $C_{18}$-Perfluoralkylsulfat, Polyethersulfate basierend auf mindestens 4 Äquivalenten Ethylenoxid und/oder Propylenoxid, Bis-$C_4$- bis $C_{25}$-Alkyl-, $C_5$- bis $C_7$-Cycloalkyl-, $C_3$- bis $C_8$-Alkenyl- oder $C_7$- bis $C_{11}$-Aralkyl-sulfosuccinat, durch mindestens 8 Fluoratome substituiertes Bis-$C_2$- bis $C_{10}$-Alkyl-sulfosuccinat, $C_8$- bis $C_{25}$-Alkyl-sulfoacetate, durch mindestens einen Rest der Gruppe Halogen, $C_4$- bis $C_{25}$-Alkyl, Perfluor-$C_1$-bis $C_8$-Alkyl und/oder $C_1$- bis $C_{12}$-Alkoxycarbonyl substituiertes Benzolsulfonat, gegebenenfalls durch Nitro, Cyano, Hydroxy, $C_1$- bis $C_{25}$-Alkyl, $C_1$- bis $C_{12}$-Alkoxy, Amino, $C_1$- bis $C_{12}$-Alkoxycarbonyl oder Chlor substituiertes Naphthalin- oder Biphenylsulfonat, gegebenenfalls durch Nitro, Cyano, Hydroxy, $C_1$- bis $C_{25}$-Alkyl, $C_1$- bis $C_{12}$-Alkoxy, $C_1$- bis $C_{12}$-Alkoxycarbonyl oder Chlor substituiertes Benzol-, Naphthalin- oder Biphenyldisulfonat, durch Dinitro, $C_6$- bis $C_{25}$-Alkyl, $C_4$- bis $C_{12}$-Alkoxycarbonyl, Benzoyl, Chlorbenzoyl oder Toluoyl substituiertes Benzoat, das Anion der Naphthalindicarbonsäure, Diphenyletherdisulfonat, sulfonierte oder sulfatierte, gegebenenfalls. mindestens einfach ungesättigte $C_8$- bis $C_{25}$-Fettsäureester von aliphatischen $C_1$- bis Cs-Alkoholen oder Glycerin, Bis-(sulfo-$C_2$-bis $C_6$-alkyl)-$C_3$- bis $C_{12}$-alkandicarbonsäureester, Bis-(sulfo-$C_2$- bis $C_6$-alkyl)-itaconsäureester, (Sulfo-$C_2$- bis $C_6$-alkyl)-$C_6$- bis $C_{18}$-alkancarbonsäureester und (Sulfo-$C_2$- bis $C_6$-alkyl)-acryl- oder methacrylsäureester ist, wobei bei mehrwertigen Anionen wie Naphthalindisulfonat $An^-$ für ein Äquivalent dieses Anions steht, und wobei die Alkan- und Alkylgruppen verzweigt sein können und/oder durch Halogen, Cyano, Methoxy, Ethoxy, Methoxycarbonyl oder Ethoxycarbonyl sustituiert sein können.

8. Photopolymer-Formulierung nach einem der Ansprüche 1 bis 7, **dadurch gekennzeichnet, dass** das Anion $An^-$ ausgewählt aus der Gruppe sec-$C_{11}$- bis $C_{18}$-Alkansulfonat, $C_{13}$- bis $C_{25}$-Alkylsulfat, verzweigtes $C_8$- bis $C_{25}$-Alkylsulfat, ggf. verzweigtes Bis-$C_6$- bis $C_{25}$-Alkylsulfosuccinat, sec- oder tert.-$C_4$- bis $C_{25}$-Alkylbenzolsulfonat, sulfonierte oder sulfatierte, gegebenenfalls mindestens einfach ungesättigte $C_8$- bis $C_{25}$-Fettsäureester von aliphatischen $C_1$- bis $C_8$-Alkoholen oder Glycerin, Bis-(sulfo-$C_2$- bis $C_6$-alkyl)-$C_3$- bis $C_{12}$-alkandicarbonsäureester und (Sulfo-$C_2$- bis $C_6$-alkyl)-$C_6$- bis $C_{18}$-alkancarbonsäureester ist.

9. Photopolymer-Formulierung nach einem der Ansprüche 1 bis 8, **dadurch gekennzeichnet, dass** die Polyisocyanat-Komponente ein aliphatisches Polyisocyanat oder ein Präpolymer mit primären NCO-Gruppen ist.

10. Photopolymer-Formulierung nach einem der Ansprüche 1 bis 9, **dadurch gekennzeichnet, dass** die Polyolkomponente ein difunktioneller Polyether-, Polyester oder ein Polyether-polyester-block-copolyester mit primären OH-Funktionen ist.

11. Photopolymer-Formulierung nach einem der Ansprüche 1 bis 10, **dadurch gekennzeichnet, dass** das Schreibmonomer wenigstens ein monofunktionelles und ein multifunktionelles Urethan(meth)acrylat umfasst.

12. Photopolymer-Formulierung nach einem der Ansprüche 1 bis 11, **dadurch gekennzeichnet, dass** sie zusätzlich einen Weichmacher, bevorzugt einen Weichmacher gemäß der allgemeinen Formel (CI)

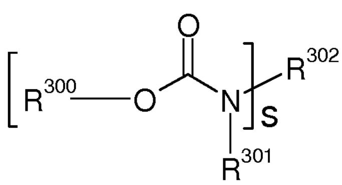

(CI)

umfasst, in der s≥1 und s≤8 ist und $R^{300}$, $R^{301}$, $R^{302}$ unabhängig voneinander Wasserstoff, lineare, verzweigte, cyclische oder heterocyclische unsubstituierte oder gegebenenfalls auch mit Heteroatomen substituierte organische Reste sind, wobei bevorzugt mindestens einer der Reste $R^{300}$, $R^{301}$, $R^{302}$ mit wenigstens einem Fluoratom substituiert ist und besonders bevorzugt $R^{300}$ ein organischer Rest mit mindestens einem Fluoratom ist.

**13.** Holographisches Medium, enthaltend eine Photopolymer-Formulierung gemäß einem der Ansprüche 1 bis 12.

**14.** Verwendung eines holographischer Mediums gemäß Anspruch 13 zur Aufzeichnung von In-Line, Off-Axis, Full-Aperture Transfer, Weißlicht-Transmissions, Denisyuk, Off-Axis Reflektions oder Edge-Lit Hologrammen sowie holographischen Stereogrammen.

## Claims

**1.** Photopolymer formulation comprising a polyol component, a polyisocyanate component, a writing monomer and a photoinitiator containing a coinitiator and a dye of formula

$F^+An^-$,

where

$F^+$ represents a cationic dye selected from the group of acridine, xanthene, thioxanthene, phenazine, phenoxazine, phenothiazine, tri(het)arylmethane, diamino- and triamino(het)arylmethane, mono-, di- and trimethinecyanine, hemicyanine, externally cationic merocyanine, externally cationic neutrocyanine, nullmethine, naphtholactam and streptocyanine dyes, and $An^-$ represents an anion that comprises at least a phosphorus, boron or sulphur atom,
**characterized in that** the dye of formula $F^+An^-$ has a water imbibition of ≤ 5% and wherein the anion An- has an AClogP in the range of 1-6.5.

**2.** Photopolymer formulation according to Claim 1, **characterized in that** the dye has a water imbibition of ≤ 3% and more preferably of ≤ 2%.

**3.** Photopolymer formulation according to either of Claims 1 and 2, **characterized in that** the anion An- has an AClogP in the range of 1-4.

**4.** Photopolymer formulation according to any one of Claims 1 to 3, **characterized in that** the anion An- has a molar mass >150 g/mol and more preferably > 250 g/mol.

**5.** Photopolymer formulation according to any one of Claims 1 to 4, **characterized in that** the anion $An^-$ comprises at least a boron or sulphur atom and preferably at least a sulphur atom particularly a sulphur atom in an $SO_3$ moiety.

**6.** Photopolymer formulation according to any one of Claims 1 to 5, **characterized in that** the anion An- has one or more than one linear or branched aliphatic moiety and preferably one linear or branched aliphatic $C_8$ to $C_{16}$ moiety or when it has more than one linear or branched aliphatic moiety, these together have 8 to 36 carbon atoms.

**7.** Photopolymer formulation according to any one of Claims 1 to 6, **characterized in that** the anion An- is selected from the group $C_8$- to $C_{25}$-alkanesulphonate, preferably $C_{13}$- to $C_{25}$-alkanesulphonate, $C_3$- to $C_{18}$-perfluoroalkanesulphonate, preferably $C_4$- to $C_{18}$-perfluoroalkanesulphonate, $C_9$- to $C_{25}$-alkanoate, $C_9$- to $C_{25}$-alkenoate, $C_8$- to $C_{25}$-alkyl sulphate, preferably $C_{13}$-to $C_{25}$-alkyl sulphate, $C_8$- to $C_{25}$-alkenyl sulphate, preferably $C_{13}$- to $C_{25}$-alkenyl sulphate, $C_3$- to $C_{18}$-perfluoroalkyl sulphate, preferably $C_4$- to $C_{18}$-perfluoroalkyl sulphate, polyether sulphates based on 4 or more equivalents of ethylene oxide and/or propylene oxide, bis-$C_4$- to $C_{25}$-alkyl, $C_5$- to $C_7$-cycloalkyl, $C_3$- to $C_8$-alkenyl or $C_7$- to $C_{11}$-aralkyl sulphosuccinate, bis-$C_2$-to $C_{10}$-alkyl sulphosuccinate substituted by 8 or more fluorine atoms, $C_8$- to $C_{25}$-alkyl sulphoacetates, benzenesulphonate substituted by at least one moiety from the group halogen, $C_4$- to $C_{25}$-alkyl, perfluoro-$C_1$-to $C_8$-alkyl and/or $C_1$- to $C_{12}$-alkoxycarbonyl, optionally nitro-, cyano-, hydroxyl-, $C_1$- to $C_{25}$-alkyl-, $C_1$- to $C_{12}$-alkoxy-, amino-, $C_1$- to $C_{12}$-alkoxycarbonyl- or chlorine-substituted naphthalene- or biphenylsulphonate, optionally nitro-, cyano-, hydroxyl-, $C_1$- to $C_{25}$-alkyl-, $C_1$- to $C_{12}$-alkoxy-, $C_1$- to $C_{12}$-alkoxycarbonyl- or chlorine-substituted benzene-, naphthalene- or biphenyldisulphonate, dinitro-, $C_6$- to $C_{25}$-alkyl-, $C_4$- to $C_{12}$-alkoxycarbonyl-, benzoyl-, chlorobenzoyl- or toluoyl-substituted benzoate, the anion of naphthalenedicarboxylic

acid, diphenyl ether disulphonate, sulphonated or sulphated, optionally mono- or polyunsaturated $C_8$- to $C_{25}$-fatty acid esters of aliphatic $C_1$- to $C_8$-alcohols or glycerol, bis(sulpho-$C_2$-to $C_6$-alkyl) $C_3$- to $C_{12}$-alkanedicarboxylic esters, bis (sulpho-$C_2$- to $C_6$-alkyl) itaconic acid esters, (sulpho-$C_2$- to $C_6$-alkyl) $C_6$- to $C_{18}$-alkanecarboxylic esters and (sulpho-$C_2$- to $C_6$-alkyl) acrylic or methacrylic acid esters, where An- in multivalent anions such as naphthalenedisulphonate represents one equivalent of this anion, and where the alkane and alkyl groups may be branched and/or may be halogen, cyano, methoxy, ethoxy, methoxycarbonyl or ethoxycarbonyl substituted.

**8.** Photopolymer formulation according to any one of Claims 1 to 7, **characterized in that** the anion An- is selected from the group sec-$C_{11}$- to $C_{18}$-alkanesulphonate, $C_{13}$- to $C_{25}$-alkyl sulphate, branched $C_8$- to $C_{25}$-alkyl sulphate, optionally branched bis-$C_6$- to $C_{25}$-alkyl sulphosuccinate, sec- or tert-$C_4$- to $C_{25}$-alkylbenzenesulphonate, sulphonated or sulphated, optionally mono- or polyunsaturated $C_8$- to $C_{25}$-fatty acid esters of aliphatic $C_1$- to $C_8$-alcohols or glycerol, bis(sulpho-$C_2$- to $C_6$-alkyl) $C_3$- to $C_{12}$-alkanedicarboxylic esters and (sulpho-$C_2$- to $C_6$-alkyl) $C_6$- to $C_{18}$-alkanecarboxylic esters.

**9.** Photopolymer formulation according to any one of Claims 1 to 8, **characterized in that** the polyisocyanate component is an aliphatic polyisocyanate or a prepolymer with primary NCO groups.

**10.** Photopolymer formulation according to any one of Claims 1 to 9, **characterized in that** the polyol component is a difunctional polyether, polyester or a polyether-polyester block copolyester with primary OH functions.

**11.** Photopolymer formulation according to any one of Claims 1 to 10, **characterized in that** the writing monomer comprises at least a monofunctional and a multifunctional urethane (meth)acrylate.

**12.** Photopolymer formulation according to any one of Claims 1 to 11, **characterized in that** it additionally comprises a plasticizer, preferably a plasticizer conforming to general formula (CI)

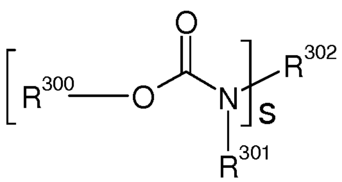

(CI)

where s is ≥1 and ≤8 and $R^{300}$, $R^{301}$, $R^{302}$ are independently of each other hydrogen, linear, branched, cyclic or heterocyclic unsubstituted or else optionally heteroatom-substituted organic moieties, wherein preferably at least one of $R^{300}$, $R^{301}$, $R^{302}$ is substituted with at least a fluorine atom and more preferably $R^{300}$ is an organic moiety with at least one fluorine atom.

**13.** Holographic medium, containing a photopolymer formulation according to any one of Claims 1 to 12.

**14.** Use of a holographic medium according to Claim 13 for recording of in-line, off-axis, full-aperture transfer, white light transmission, Denisyuk, off-axis reflection or edge-lit holograms and also holographic stereograms.

## Revendications

**1.** Formulation de photopolymère comprenant un composant polyol, un composant polyisocyanate, un monomère d'écriture et un photoinitiateur contenant un co-initiateur et un colorant de formule

$F^+ An^-$

dans laquelle

$F^+$ représente un colorant cationique choisi dans le groupe constitué par les colorants acridine, xanthène, thioxanthène, phénazine, phénoxazine, phénothiazine, tri(hét)arylméthane, diamino- et triamino(hét)arylméthane, mono-, di- et triméthinecyanine, hémicyanine, mérocyanine cationique externe, neutrocyanine cationique externe, zérométhine, naphtolactame et streptocyanine, et

$An^-$ représente un anion, qui comprend au moins un atome de phosphore, de bore ou de soufre, **caractérisée en ce que** le colorant de formule $F^+ An^-$ présente une absorption de l'eau ≤ 5 % et l'anion $An^-$ présente un AClogP dans la plage allant de 1 à 6,5.

2. Formulation de photopolymère selon la revendication 1, **caractérisée en ce que** le colorant présente une absorption de l'eau ≤ 3 % et de manière particulièrement préférée ≤ 2 %.

3. Formulation de photopolymère selon l'une quelconque des revendications 1 ou 2, **caractérisée en ce que** l'anion $An^-$ présente un AClogP dans la plage allant de 1 à 4.

4. Formulation de photopolymère selon l'une quelconque des revendications 1 à 3, **caractérisée en ce que** l'anion An- présente une masse molaire > 150 g/mol, de manière particulièrement préférée > 250 g/mol.

5. Formulation de photopolymère selon l'une quelconque des revendications 1 à 4, **caractérisée en ce que** l'anion An- comprend au moins un atome de bore ou de soufre, et de préférence au moins un atome de soufre, notamment un atome de soufre dans un groupe $SO_3$.

6. Formulation de photopolymère selon l'une quelconque des revendications 1 à 5, **caractérisée en ce que** l'anion $An^-$ comprend au moins un radical aliphatique linéaire ou ramifié, de préférence un radical aliphatique en $C_8$ à $C_{16}$ linéaire ou ramifié, ou, lorsqu'il comprend plus d'un radical aliphatique linéaire ou ramifié, ceux-ci contiennent ensemble 8 à 36 atomes C.

7. Formulation de photopolymère selon l'une quelconque des revendications 1 à 6, **caractérisée en ce que** l'anion $An^-$ est choisi dans le groupe constitué par un sulfonate d'alcane en $C_8$ à $C_{25}$, de préférence un sulfonate d'alcane en $C_{13}$ à $C_{25}$, un sulfonate de perfluoroalcane en $C_3$ à $C_{18}$, de préférence un sulfonate de perfluoroalcane en $C_4$ à $C_{18}$, un alcanoate en $C_9$ à $C_{25}$, un alcénoate en $C_9$ à $C_{25}$, un sulfate d'alkyle en $C_8$ à $C_{25}$, de préférence un sulfate d'alkyle en $C_{13}$ à $C_{25}$, un sulfate d'alcényle en $C_8$ à $C_{25}$, de préférence un sulfate d'alcényle en $C_{13}$ à $C_{25}$, un sulfate de perfluoroalkyle en $C_3$ à $C_{18}$, de préférence un sulfate de perfluoroalkyle en $C_4$ à $C_{18}$, les polyéther-sulfates à base d'au moins 4 équivalents d'oxyde d'éthylène et/ou d'oxyde de propylène, un sulfosuccinate de bis-alkyle en $C_4$ à $C_{25}$, de cycloalkyle en $C_5$ à $C_7$, d'alcényle en $C_3$ à $C_8$ ou d'aralkyle en $C_7$ à $C_{11}$, un sulfosuccinate de bis-alkyle en $C_2$ à $C_{10}$ substitué par au moins 8 atomes de fluor, un sulfoacétate d'alkyle en $C_8$ à $C_{25}$, un sulfonate de benzène substitué par au moins un radical du groupe constitué par halogène, alkyle en $C_4$ à $C_{25}$, perfluoroalkyle en $C_1$ à $C_8$ et/ou alcoxycarbonyle en $C_1$ à $C_{12}$, un sulfonate de naphtaline ou de biphényle éventuellement substitué par nitro, cyano, hydroxy, alkyle en $C_1$ à $C_{25}$, alcoxy en $C_1$ à $C_{12}$, amino, alcoxycarbonyle en $C_1$ à $C_{12}$ ou chlore, un disulfonate de benzène, de naphtaline ou de biphényle éventuellement substitué par nitro, cyano, hydroxy, alkyle en $C_1$ à $C_{25}$, alcoxy en $C_1$ à $C_{12}$, alcoxycarbonyle en $C_1$ à $C_{12}$ ou chlore, un benzoate substitué par dinitro, alkyle en $C_6$ à $C_{25}$, alcoxycarbonyle en $C_4$ à $C_{12}$, benzoyle, chlorobenzoyle ou toluoyle, l'anion de l'acide naphtaline-dicarboxylique, le disulfonate de diphényléther, les esters d'acides gras en $C_8$ à $C_{25}$ sulfonés ou sulfatés, éventuellement au moins mono-insaturés d'alcools en $C_1$ à $C_8$ aliphatiques ou de glycérine, les esters d'acides bis-(sulfo-alkyle en $C_2$ à $C_6$)-alcane en $C_3$ à $C_{12}$-dicarboxyliques, les esters d'acides bis-(sulfo-alkyle en $C_2$ à $C_6$)-itaconique, les esters d'acides (sulfo-alkyle en $C_2$ à $C_6$)-alcane en $C_6$ à $C_{18}$-carboxyliques et les esters d'acides (sulfo-alkyle en $C_2$ à $C_6$)-acryliques ou - méthacryliques ; en cas d'anions polyvalents tels que le disulfonate de naphtaline, $An^-$ représentant un équivalent de cet anion, et les groupes alcane et alkyle pouvant être ramifiés et/ou substitués par halogène, cyano, méthoxy, éthoxy, méthoxycarbonyle ou éthoxycarbonyle.

8. Formulation de photopolymère selon l'une quelconque des revendications 1 à 7, **caractérisée en ce que** l'anion $An^-$ est choisi dans le groupe constitué par un sulfonate de sec-alcane en $C_{11}$ à $C_{18}$, un sulfate d'alkyle en $C_{13}$ à $C_{25}$, un sulfate d'alkyle en $C_8$ à $C_{25}$ ramifié, un sulfosuccinate de bis-alkyle en $C_6$ à $C_{25}$ éventuellement ramifié, un sulfonate de sec- ou tert.-alkylbenzène en $C_4$ à $C_{25}$, les esters d'acides gras en $C_8$ à $C_{25}$ sulfonés ou sulfatés, éventuellement au moins mono-insaturés d'alcools en $C_1$ à $C_8$ aliphatiques ou de glycérine, les esters d'acides bis-(sulfo-alkyle en $C_2$ à $C_6$)-alcane en $C_3$ à $C_{12}$-dicarboxyliques et les esters d'acides (sulfo-alkyle en $C_2$ à $C_6$) -alcane en $C_6$ à $C_{18}$-carboxyliques.

9. Formulation de photopolymère selon l'une quelconque des revendications 1 à 8, **caractérisée en ce que** le composant polyisocyanate est un polyisocyanate aliphatique ou un prépolymère contenant des groupes NCO primaires.

10. Formulation de photopolymère selon l'une quelconque des revendications 1 à 9, **caractérisée en ce que** le composant polyol est un polyéther-, polyester- ou polyéther-polyester-bloc-copolyester bifonctionnel contenant des

fonctions OH primaires.

11. Formulation de photopolymère selon l'une quelconque des revendications 1 à 10, **caractérisée en ce que** le monomère d'écriture comprend au moins un (méth)acrylate d'uréthane monofonctionnel et un multifonctionnel.

12. Formulation de photopolymère selon l'une quelconque des revendications 1 à 11, **caractérisée en ce qu'**elle comprend en outre un plastifiant, de préférence un plastifiant selon la formule générale (CI)

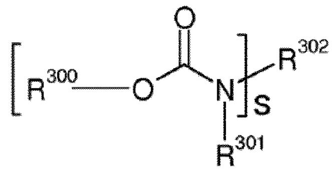

(CI)

dans laquelle $s \geq 1$ et $s \leq 8$, et $R^{300}$, $R^{301}$, $R^{302}$ représentent indépendamment les uns des autres l'hydrogène, des radicaux organiques linéaires, ramifiés, cycliques ou hétérocycliques non substitués ou éventuellement également substitués avec des hétéroatomes, de préférence au moins un des radicaux $R^{300}$, $R^{301}$, $R^{302}$ étant substitué avec au moins un atome de fluor, et de manière particulièrement préférée $R^{300}$ étant un radical organique contenant au moins un atome de fluor.

13. Support holographique, contenant une formulation de photopolymère selon l'une quelconque des revendications 1 à 12.

14. Utilisation d'un support holographique selon la revendication 13 pour l'enregistrement d'hologrammes en ligne, d'hologrammes désaxés, d'hologrammes de transfert à ouverture totale, d'hologrammes en transmission en lumière blanche, d'hologrammes de Denisyuk, d'hologrammes désaxés en réflexion ou d'hologrammes à bords éclairés, ainsi que de stéréogrammes holographiques.

**Figur 1:**

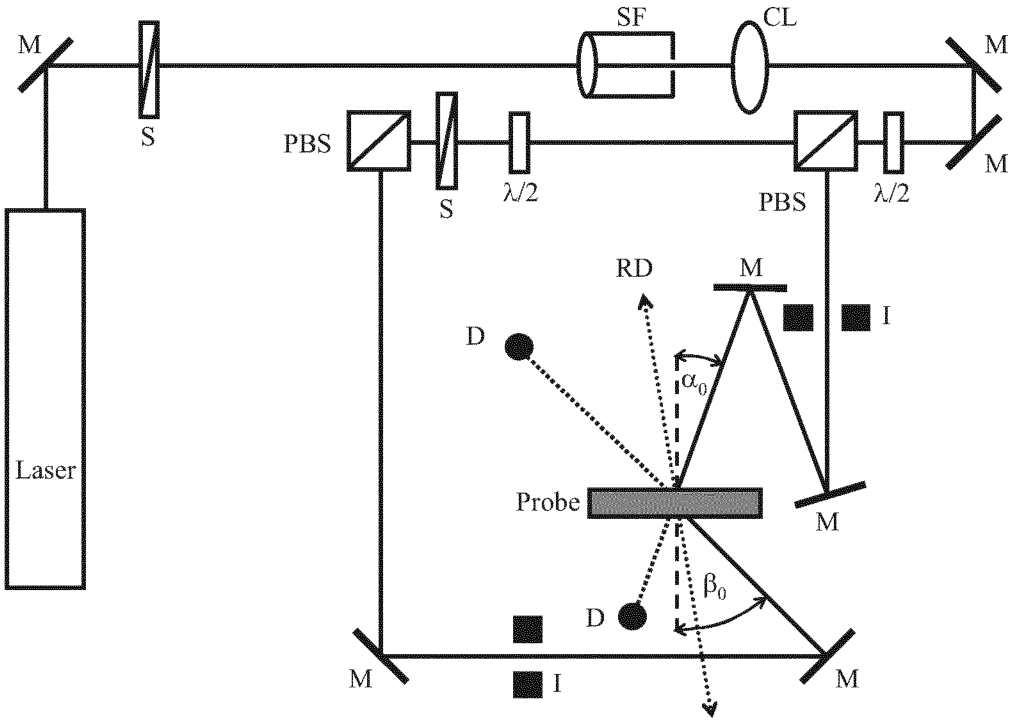

Figur 2:

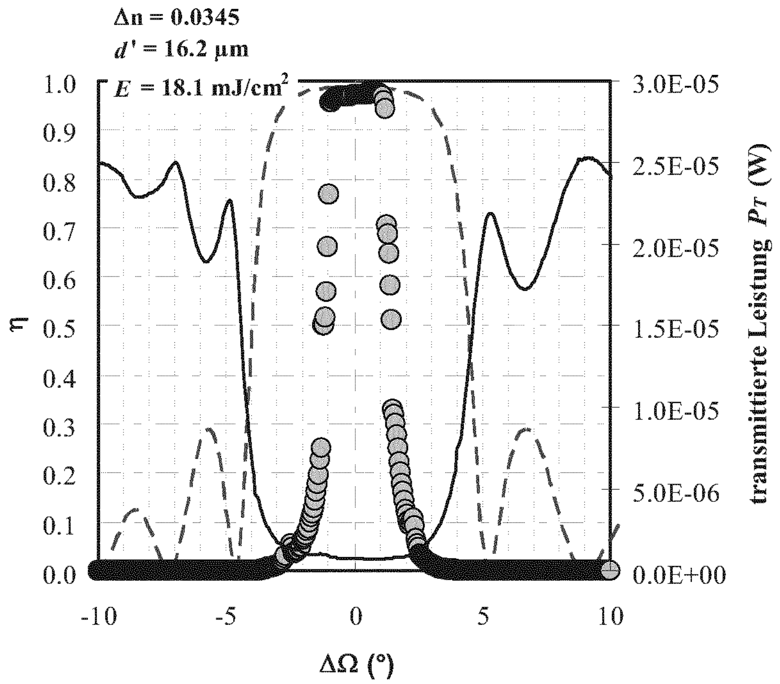


Figur 3:

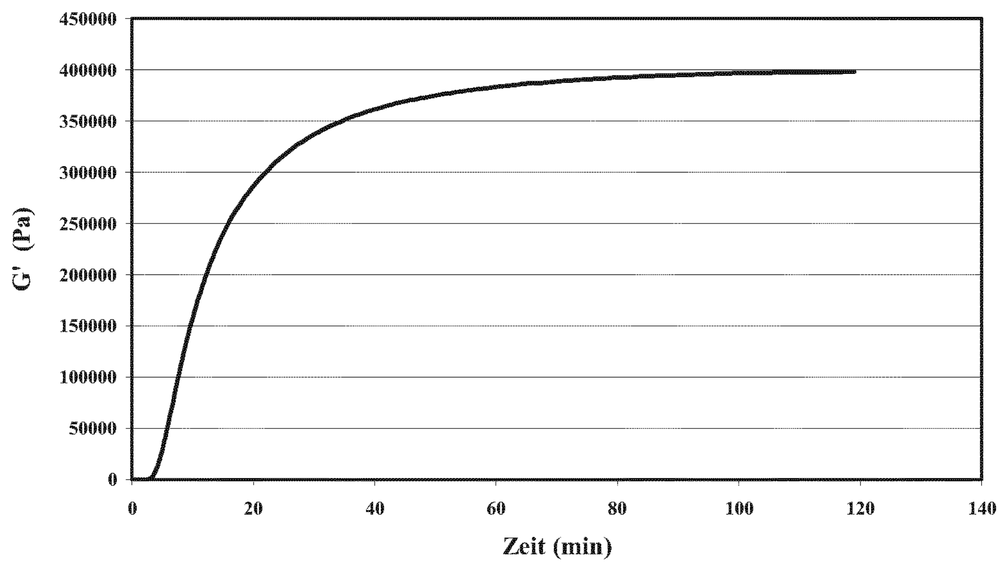

Figur 4:

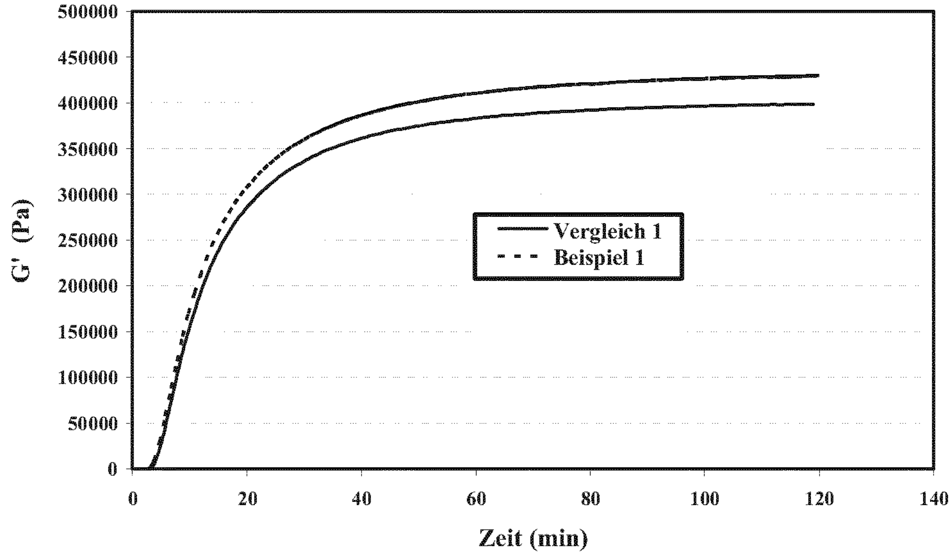


Figur 5:

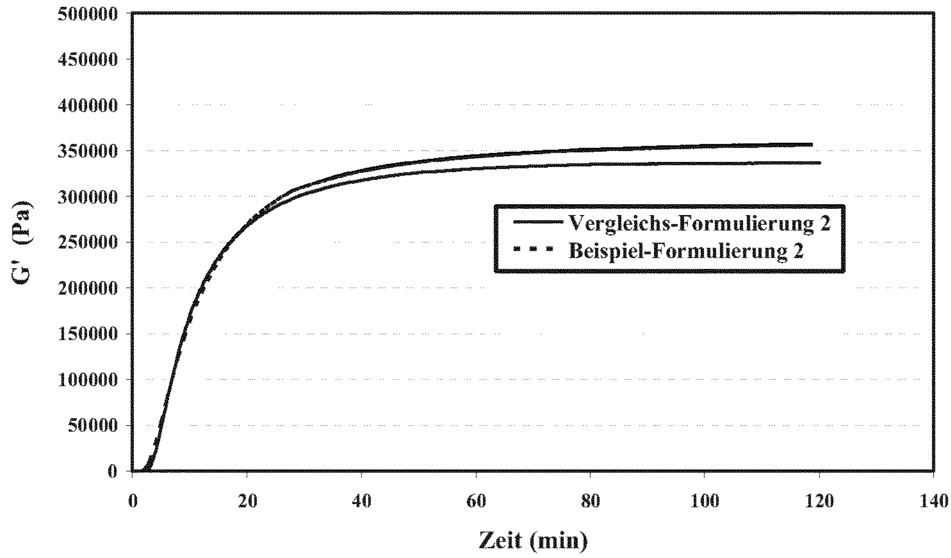

Figur 6:

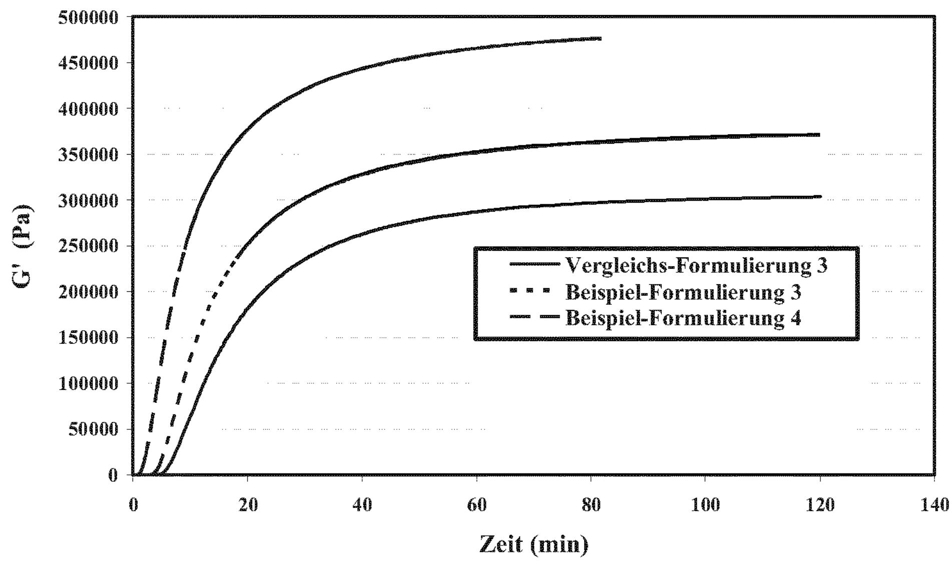


Figur 7:

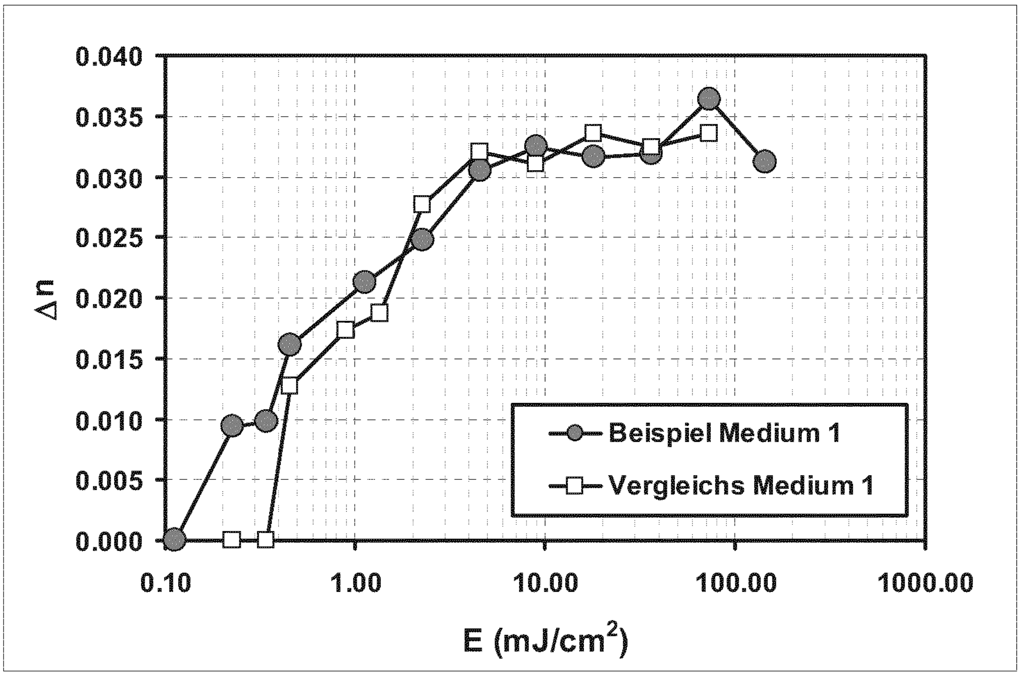

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- WO 2008125229 A1
- CH 691684 A5
- EP 1666988 A1
- EP 2028654 A1
- EP 0223587 A
- DE PS1158646 C


### In der Beschreibung aufgeführte Nicht-Patentliteratur


- **P. HARIHARAN.** Optical Holography. Cambridge University Press, 1996
- **H. BERNETH.** Ullmann's Encyclopedia of Industrial Chemistry, Cationic Dyes. Wiley-VCH Verlag, 2008
- **H. BERNETH.** Ullmann's Encyclopedia of Industrial Chemistry, Azine Dyes. Wiley-VCH Verlag, 2008
- **H. BERNETH.** Ullmann's Encyclopedia of Industrial Chemistry, Methine Dyes and Pigments. Wiley-VCH Verlag, 2008
- **T. GESSNER ; U. MAYER.** Ullmann's Encyclopedia of Industrial Chemistry, Triarylmethane and Diarylmethane Dyes. Wiley-VCH Verlag, 2000
- *J. Comput. Aid. Mol. Des.,* 2005, vol. 19, 453
- *Virtual Computational Chemistry Laboratory, http://www.vcclab.org berechnet*
- **CUNNINGHAM et al.** *RadTech'98 North America UV/EB Conference Proceedings,* 19. April 1998
- Chemistry & Technology of UV & EB Formulations For Coatings. Inks & Paints. SITA Technology, 1991, vol. 3, 61-328
- Holographic interference lithography for integrated optics. *IEEE Transactions on Electron Devices,* 1978, vol. ED-25 (10), ISSN 0018-9383, 1193-1200
- **M. DOI ; S.F. EDWARDS.** The Theory of Polymer Dynamics. Oxford Science Publications, 1986
- **H. KOGELNIK.** *The Bell System Technical Journal,* November 1969, vol. 48 (9), 2909-2947
- *J. Org. Chem.,* 2004, vol. 69, 8521-8524
- *Phys. Chem. Chem. Phys.,* 1999, vol. 1, 4395